# EUROPEAN PATENT SPECIFICATION

(11) **EP 4 231 801 B1**
(45) Date of publication and mention of the grant of the patent: **26.11.2025**
(21) Application number: 23150263.4
(22) Date of filing: 04.01.2023
(51) Int. Cl.: H10B 41/27, H10B 41/41, H10B 41/50, H10B 43/27, H10B 43/40, H10B 43/50

(54) **NON-VOLATILE MEMORY DEVICE**
NICHTFLÜCHTIGE SPEICHERANORDNUNG
DISPOSITIF DE MÉMOIRE NON VOLATILE

(30) Priority: 10.02.2022 KR 20220017738; 01.07.2022 KR 20220081506
(43) Date of publication of application: 23.08.2023
(73) Proprietor: SAMSUNG ELECTRONICS CO., LTD., Yeongtong-gu Suwon-si, Gyeonggi-do 16677 (KR)
(72) Inventor: CHO, Beakhyung, Suwon-si, Gyeonggi-do 16677 (KR); BYEON, Daeseok, Suwon-si, Gyeonggi-do 16677 (KR)
(74) Representative: Kuhnen & Wacker Patent- und Rechtsanwaltsbüro PartG mbB

(56) References cited:
- US-A1- 2017 330 624
- US-A1- 2021 183 879
- US-A1- 2021 375 901
- US-B1- 11 183 246

## Description

### BACKGROUND

### 1. Field

The present disclosure relates to a memory device, and more particularly, to a three-dimensional non-volatile memory device in which a memory cell array overlaps a partial region of a peripheral circuit.

### 2. Description of Related Art

Related memory devices may be used to store data, and may be classified into volatile memory devices and non-volatile memory devices. In response to the demand for high capacity and miniaturization of non-volatile memory devices, related three-dimensional memory devices have been developed in which memory cell arrays and peripheral circuits are vertically arranged. In order to increase the capacity of a related non-volatile memory device, as the number of word lines stacked on a substrate increases, the area of a cell region in which a memory cell array is arranged may decrease. However, despite the decrease in the area of the cell region, the area of a peripheral circuit region in which a peripheral circuit is arranged under the memory cell array may not decrease.

US 2021/183879 A1 discloses a semiconductor memory device includes a logic circuit disposed on a substrate having a cell region and a peripheral region outside the cell region; a source plate defined over the logic circuit; a slit separating the source plate into a cell source plate in the cell region and a dummy source plate in the peripheral region; and a memory cell array defined on the cell source plate. The dummy source plate is maintained at a constant voltage independent of operations of the memory cell array and the logic circuit.

US 11 183 246 B1 discloses a memory device that includes a first plane defined in a second wafer stacked on a first wafer; a second plane defined in a third wafer stacked on the second wafer, and overlapping with the first plane in a vertical direction; a first page buffer circuit including a first column driver coupled to bit lines of the first plane and a first column operator; and a second page buffer circuit including a second column driver coupled to bit lines of the second plane and a second column operator. The first column driver is disposed in the second wafer, the second column driver is disposed in the third wafer and overlaps with the first column driver in the vertical direction, and the first and second column operators are disposed in a cell region of the first wafer and overlap with the first and second planes in the vertical direction.

US 2017/0330624 A1 discloses a memory device that has a vertical structure in which a row decoder, a page buffer, and a peripheral circuit are disposed under a memory cell array. The row decoder and the page buffer may be asymmetrically disposed. The peripheral circuit is disposed in an area where the row decoder and the page buffer are not disposed. The row decoder and the page buffer may be symmetrically disposed with respect to an interface of planes. The peripheral circuit may be disposed in an area including a part of the interface of the planes.

US 11183246 B1 discloses a memory device that includes a first plane defined in a second wafer stacked on a first wafer; a second plane defined in a third wafer stacked on the second wafer, and overlapping with the first plane in a vertical direction; a first page buffer circuit including a first column driver coupled to bit lines of the first plane and a first column operator; and a second page buffer circuit including a second column driver coupled to bit lines of the second plane and a second column operator. The first column driver is disposed in the second wafer, the second column driver is disposed in the third wafer and overlaps with the first column driver in the vertical direction, and the first and second column operators are disposed in a cell region of the first wafer and overlap with the first and second planes in the vertical direction.

### SUMMARY

The invention is defined in the appended claims.

The present disclosure provides a non-volatile memory device in which some circuits constituting a peripheral circuit are buried by a cell region and the other circuits constituting the peripheral circuit are not buried by the cell region, as the number of stacked word lines increases.

According to a partial aspect of the present disclosure, a non-volatile memory device includes a first semiconductor layer and a second semiconductor layer. The first semiconductor layer includes a first memory cell array, a second memory cell array, and a first metal pad. The first memory cell array is disposed on a first cell region of the first semiconductor layer, and includes a first plurality of word lines stacked in a vertical direction and a first plurality of memory cells respectively coupled to the first plurality of word lines. The second memory cell array is disposed on a second cell region of the first semiconductor layer, and includes a second plurality of word lines stacked in the vertical direction and a second plurality of memory cells respectively coupled to the second plurality of word lines. T second semiconductor layer includes a first peripheral circuit disposed on a first region of the second semiconductor layer and coupled to the first memory cell array, a second peripheral circuit disposed on a second region of the second semiconductor layer and coupled to the second memory cell array, and a second metal pad. The second semiconductor layer is coupled, in the vertical direction, to the first semiconductor layer by the first metal pad and the second metal pad in a bonding manner. The first region includes a first peripheral circuit region that overlaps the first cell region in the vertical direction, and a second peripheral circuit region that does not overlap the first cell region in the vertical direction. The second region overlaps the second cell region in the vertical direction.

According to a partial aspect of the present disclosure, a non-volatile memory device includes a first semiconductor layer and a second semiconductor layer. The first semiconductor layer includes a memory cell array disposed on a cell region of the first semiconductor layer, and a first metal pad. The memory cell array includes a plurality of word lines stacked in a vertical direction and a plurality of memory cells respectively coupled to the plurality of word lines. The second semiconductor layer includes a peripheral circuit disposed on a peripheral circuit region of the second semiconductor layer, and a second metal pad. The second semiconductor layer is coupled, in the vertical direction, to the first semiconductor layer by the first metal pad and the second metal pad in a bonding manner. The peripheral circuit region includes a first peripheral circuit region that overlaps the cell region in the vertical direction, and a second peripheral circuit region that does not overlap the cell region in the vertical direction. An area of the peripheral circuit region is greater than an area of the cell region. The peripheral circuit includes a page buffer circuit connected to the plurality of memory cells through a plurality of bit lines. A portion of the page buffer circuit is disposed on the first peripheral circuit region. Another portion of the page buffer circuit is disposed on the second peripheral circuit region.

According to a partial aspect of the present disclosure, a non-volatile memory device includes a first semiconductor layer and a second semiconductor layer. The first semiconductor layer includes a cell region on which a memory cell array is disposed, and a first metal pad. The memory cell array includes a plurality of word lines stacked in a vertical direction and a plurality of memory cells respectively coupled to the plurality of word lines. The second semiconductor layer includes a peripheral circuit region on which a peripheral circuit is disposed, and a second metal pad. The second semiconductor layer is coupled, in the vertical direction, to the first semiconductor layer by the first metal pad and the second metal pad in a bonding manner. The peripheral circuit region includes a first peripheral circuit region that overlaps the cell region in the vertical direction, and a second peripheral circuit region that does not overlap the cell region in the vertical direction. An area of the peripheral circuit region is greater than an area of the cell region. The peripheral circuit further includes a row decoder connected to the plurality of word lines. A portion of the row decoder is arranged in the first peripheral circuit region. Another portion of the row decoder is arranged in the second peripheral circuit region.

### BRIEF DESCRIPTION OF DRAWINGS

The above and other aspects, features, and advantages of certain embodiments of the present disclosure will be more apparent from the following description taken in conjunction with the accompanying drawings in which:
FIG. 1 is a block diagram illustrating a memory device according, to an embodiment;
FIG. 2 is a circuit diagram illustrating a memory block, according to an embodiment;
FIGS. 3A and 3B are perspective views respectively illustrating memory blocks, according to some embodiments;
FIG. 4 is a diagram schematically illustrating a memory device having a cell-over-periphery (COP) structure, according to an embodiment;
FIG. 5 is a cross-sectional view of a memory device having a bonding-vertical-NAND (B-VNAND) structure, according to an embodiment;
FIG. 6 is a diagram illustrating a memory device according to a comparative example, and a memory device, according to the disclosure and not to the invention;
FIGS. 7A and 7B are diagrams respectively illustrating memory devices, according to the disclosure and not to the invention;
FIG. 8 is a circuit diagram illustrating a page buffer circuit, according to an embodiment;
FIG. 9 is a circuit diagram illustrating a page buffer decoder, according to an embodiment;
FIG. 10 is a diagram illustrating a row decoder and a pass transistor circuit, according to an embodiment;
FIG. 11A is a diagram illustrating a memory device, according to an embodiment, and FIGS. 11B to 11D are respectively illustrating memory devices, according to the disclosure and not to the invention;
FIGS. 12A and 12C to 12F are diagrams respectively illustrating memory devices, according to the disclosure and not to the invention, and FIG. 12B is illustrating a memory device, according to an embodiment;
FIGS. 13A and 13B are diagrams respectively illustrating memory devices, according to the disclosure and not to the invention;
FIGS. 14A and 14B are diagrams respectively illustrating memory devices, according to the disclosure and not to the invention;
FIGS. 15A to 15D are diagrams respectively illustrating memory devices, according to the disclosure and not to the invention;
FIGS. 16A and 16B are diagrams respectively illustrating memory devices, according to the disclosure and not to the invention;
FIGS. 17A to 17D are diagrams respectively illustrating memory devices, according to the disclosure and not to the invention;
FIGS. 18A and 18B are diagrams respectively illustrating memory devices, according to the disclosure and not to the invention;
FIGS. 19A to 19D are diagrams respectively illustrating memory devices, according to the disclosure and not to the invention;
FIGS. 20A and 20B are diagrams respectively illustrating memory devices, according to the disclosure and not to the invention;
FIGS. 21A to 21D are diagrams respectively illustrating memory devices, according to the disclosure and not to the invention;
FIGS. 22A and 22B are diagrams respectively illustrating memory devices, according to the disclosure and not to the invention;
FIGS. 23A to 23D are diagrams respectively illustrating memory devices, according the disclosure and not to the invention;
FIGS. 24A and 24B are diagrams respectively illustrating memory devices, according to the disclosure and not to the invention;
FIGS. 25A to 25D are diagrams respectively illustrating memory devices, according to the disclosure and not to the invention;
FIGS. 26A and 26B are diagrams respectively illustrating memory devices, according to the disclosure and not to the invention; and
FIG. 27 is a block diagram illustrating a solid-state drive (SSD) system to which a memory device, according to an embodiment.

### DETAILED DESCRIPTION

The following description with reference to the accompanying drawings is provided to assist in a comprehensive understanding of embodiments of the present disclosure defined by the claims. Various specific details are included to assist in understanding, but these details are considered to be exemplary only. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

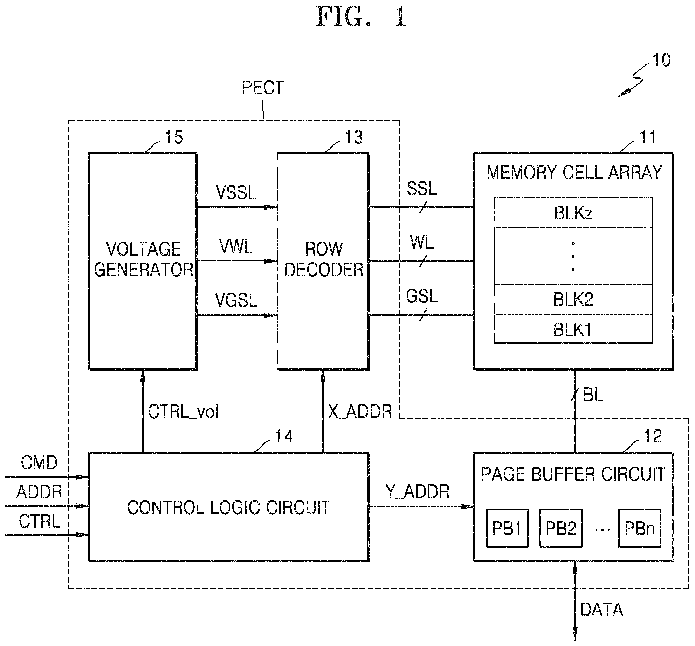

FIG. 1 is a block diagram illustrating a memory device 10, according to an embodiment.

Referring to FIG. 1, the memory device 10 may include a memory cell array 11 and a peripheral circuit PECT, and the peripheral circuit PECT may include a page buffer circuit 12, a row decoder 13, a control logic circuit 14, and a voltage generator 15. In some embodiments, the peripheral circuit PECT may further include a data input/output circuit, an input/output interface, and the like (not shown). Alternatively or additionally, the peripheral circuit PECT may further include a pre-decoder, a temperature sensor, a command decoder, an address decoder, and the like. As used herein, the memory device 10 may refer to a "non-volatile memory device".

The memory cell array 11 may include a plurality of memory blocks BLK1 to BLKz (hereinafter "BLK", generally), where z is a positive integer. Each of the plurality of memory blocks BLK may include a plurality of memory cells. The memory cell array 11 may be connected to the page buffer circuit 12 through bit lines BL, and may be connected to the row decoder 13 through word lines WL, string select lines SSL, and ground select lines GSL. For example, the memory cells may be flash memory cells. Hereinafter, embodiments are described with reference to an example in which the memory cells are NAND flash memory cells. However, the present disclosure is not limited thereto, and in some embodiments, the memory cells may be resistive memory cells, such as resistive random-access memory (RAM) (ReRAM) memory cells, phase-change RAM (PRAM) memory cells, or magnetic RAM (MRAM) memory cells.

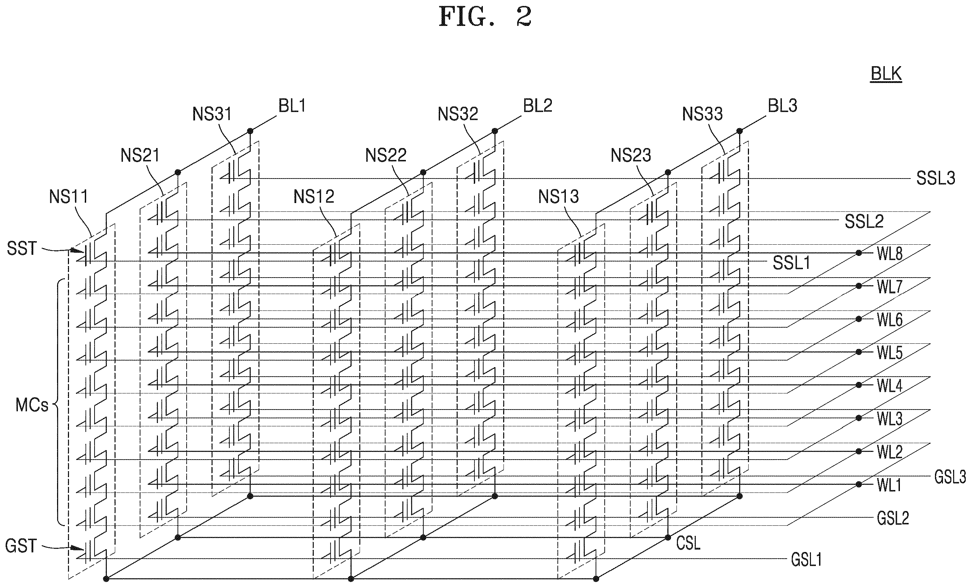

In some embodiments, the memory cell array 11 may include a three-dimensional memory cell array, which may include a plurality of NAND strings, each of which may include memory cells respectively connected (coupled) to word lines vertically stacked on a substrate, as described in detail with reference to FIGS. 2 to 3B. U.S. Patent Nos. 7,679,133, 8,553,466, 8,654,587, 8,559,235, and 9,536,970 disclose appropriate configurations of a three-dimensional memory array in which the three-dimensional memory array is configured in a plurality of levels, and word lines and/or bit lines are shared between the levels, the disclosures of which are incorporated in their entirety by reference herein. However, the present disclosure is not limited thereto, and in some embodiments, the memory cell array 11 may include a two-dimensional memory cell array, which may include a plurality of NAND strings arranged in row and column directions.

The page buffer circuit 12 may include a plurality of page buffers PB1 to PBn (hereinafter "PB", generally), where n is a positive integer. The plurality of page buffers PB may be connected (coupled) to the memory cells of the memory cell array 11 through the corresponding bit lines, respectively. The page buffer circuit 12 may select at least one of the bit lines BL under control by the control logic circuit 14. For example, the page buffer circuit 12 may select some of the bit lines BL in response to a column address Y_ADDR received from the control logic circuit 14.

Each of the plurality of page buffers PB may operate as a write driver or a sense amplifier. For example, in a program operation, each of the plurality of page buffers PB may store, in a memory cell, data DATA to be programmed, by applying a voltage corresponding to the data DATA to a bit line. For example, in a program verify operation or a read operation, each of the plurality of page buffers PB may detect the programmed data DATA by sensing a current or a voltage through a bit line.

Based on a command CMD, an address ADDR, and a control signal CTRL, the control logic circuit 14 may output various control signals for programming data to the memory cell array 11, reading data from the memory cell array 11, or erasing data stored in the memory cell array 11, for example, a voltage control signal CTRL_vol, a row address X_ADDR, and the column address Y_ADDR. Accordingly, the control logic circuit 14 may generally control various operations of the memory device 10. For example, the control logic circuit 14 may receive the command CMD, the address ADDR, and the control signal CTRL from a memory controller (not shown).

The voltage generator 15 may generate various types of voltages to perform program, read, and erase operations on the memory cell array 11, based on the voltage control signal CTRL_vol. For example, the voltage generator 15 may generate a word line voltage VWL, such as, but not limited to, a program voltage, a read voltage, a pass voltage, an erase verify voltage, or a program verify voltage. Alternatively or additionally, the voltage generator 15 may further generate a string select line voltage VSSL and a ground select line voltage VGSL based on the voltage control signal CTRL_vol.

In response to the row address X_ADDR received from the control logic circuit 14, the row decoder 13 may select one of the plurality of memory blocks BLK, select one of the word lines WL of the selected memory block, and select one of the plurality of string select lines SSL. For example, in a program operation, the row decoder 13 may apply a program voltage and a program verify voltage to the selected word line. For another example, in a read operation, the row decoder 13 may apply a read voltage to the selected word line.

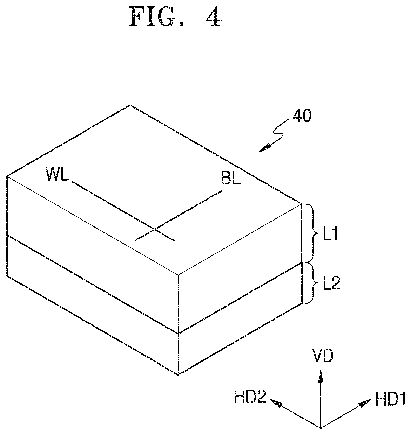

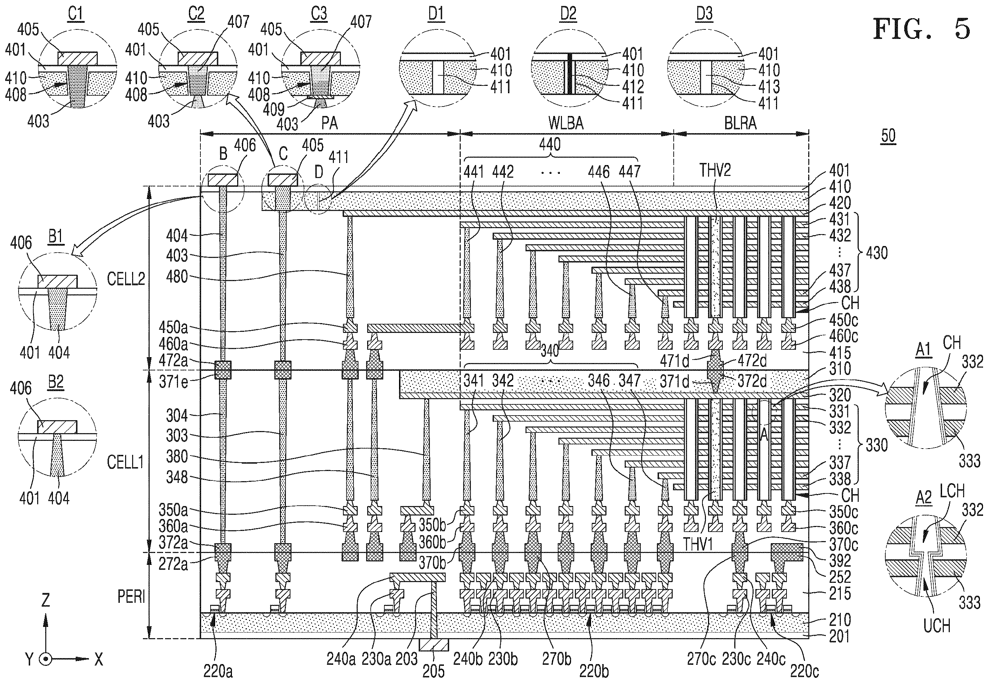

According to some embodiments, the memory cell array 11 may be arranged (disposed) in a first semiconductor layer (e.g., L1 in FIG. 4 or CELL1 and CELL2 in FIG. 5), the peripheral circuit PECT may arranged (disposed) in a second semiconductor layer (e.g., L2 in FIG. 4 or PERI in FIG. 5), and a partial region of the peripheral circuit PECT may be buried by the memory cell array 11, and the remaining region of the peripheral circuit PECT may not be buried by the memory cell array 11. That is, the partial region of the peripheral circuit PECT may overlap the memory cell array 11 in the vertical direction, and the remaining region of the peripheral circuit PECT may not vertically overlap the memory cell array 11.

FIG. 2 is a circuit diagram illustrating a memory block BLK, according to an embodiment.

Referring to FIG. 2, the memory block BLK may correspond to one of the plurality of memory blocks BLK of FIG. 1. The memory block BLK may include NAND strings NS11 to NS33, and each NAND string (e.g., NS11) may include a string select transistor SST, a plurality of memory cells MCs, and a ground select transistor GST, which are connected in series. The string select and ground select transistors SST and GST and the memory cells MCs included in each NAND string may form a stacked structure on a substrate in a vertical direction.

Bit lines BL1 to BL3 (hereinafter, also referred to as the first to third bit lines BL1 to BL3) may extend in a first direction or a first horizontal direction, and word lines WL1 to WL8 may extend in a second direction or a second horizontal direction. As used herein, the first horizontal direction refers to the first direction, and the second horizontal direction refers to the second direction. The NAND strings NS11, NS21, and NS31 may be between the first bit line BL1 and a common source line CSL, the NAND strings NS12, NS22, and NS32 may be between the second bit line BL2 and the common source line CSL, and the NAND strings NS13, NS23, and NS33 may be between the third bit line BL3 and the common source line CSL.

The string select transistors SST may be connected to corresponding string select lines SSL1 to SSL3, respectively. The memory cells MCs may be connected to the corresponding word lines WL1 to WL8, respectively. The ground select transistors GST may be connected to corresponding ground select lines GSL1 to GSL3, respectively. The string select transistors SST may be connected to the corresponding bit lines, and the ground select transistors GST may be connected to the common source line CSL. In some embodiments, the number of NAND strings, the number of word lines, the number of bit lines, the number of ground select lines, and the number of string select lines may vary depending on embodiments.

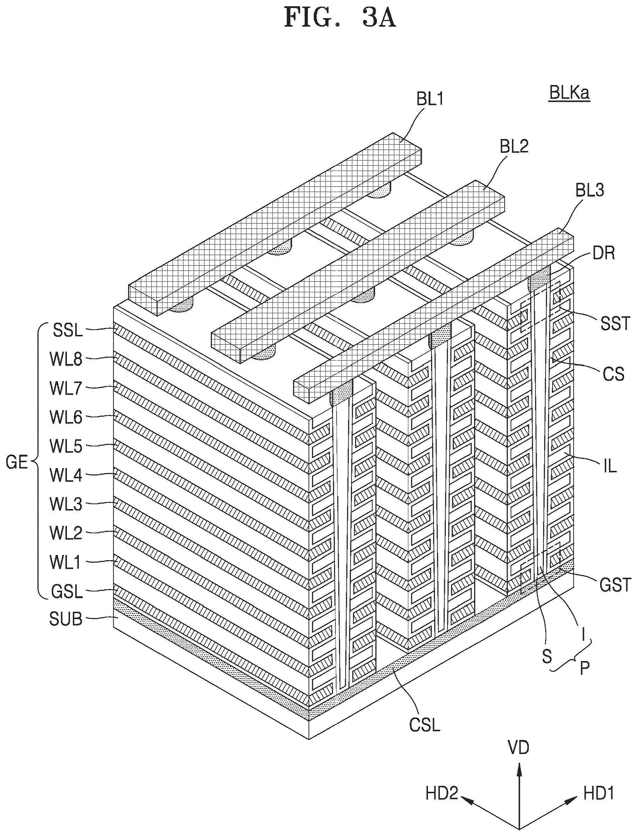

FIG. 3A is a perspective view illustrating a memory block BLKa, according to an embodiment.

Referring to FIG. 3A, the memory block BLKa may correspond to one of the plurality of memory blocks BLK of FIG. 1. The memory block BLKa is formed in a vertical direction VD with respect to a substrate SUB. The substrate SUB may have a first conductivity type (e.g., p-type) and may extend in the second direction or a second horizontal direction HD2 on the substrate SUB. In some embodiments, the common source line CSL doped with impurities of a second conductivity type (e.g., n type) may be provided on the substrate SUB. In other embodiments, the common source line CSL may be implemented as a conductive layer, such as a metal layer. A plurality of insulating films IL extending in the second horizontal direction HD2 are sequentially provided in the vertical direction VD in a region of the substrate SUB, and the plurality of insulating films IL are spaced a certain distance from each other in the vertical direction VD. For example, the plurality of insulating films IL may include an insulating material, such as, but not limited to, silicon oxide.

A plurality of pillars P are provided in a region of the substrate SUB, to be sequentially arranged in the first direction or a first horizontal direction HD1 and penetrate the plurality of insulating films IL in the vertical direction VD. For example, the plurality of pillars P may penetrate the plurality of insulating films IL and be in contact with the substrate SUB. For example, a surface layer S of each of the pillars P may include a first-type silicon material and function as a channel region. Accordingly, in some embodiments, the pillar P may be referred to as a channel structure or a vertical channel structure. An inner layer I of each of the pillars P may include an insulating material, such as silicon oxide, or an air gap, and the like.

In a region between two adjacent common source lines CSL, a charge storage layer CS is provided along exposed surfaces of the insulating films IL, the pillars P, and the substrate SUB. The charge storage layer CS may include a gate insulating layer (also referred to as a 'tunneling insulating layer'), a charge trapping layer, and a blocking insulating layer. For example, the charge storage layer CS may have an oxide-nitride-oxide (ONO) structure. Alternatively or additionally, in a region between two adjacent common source lines CSL, gate electrodes GE including the select lines GSL and SSL and the word lines WL1 to WL8 are provided on the exposed surface of the charge storage layer CS. Drain contacts or drains DR are provided on the plurality of pillars P, respectively. For example, the drains DR may include a silicon material doped with impurities having the second conductivity type. The bit lines BL1 to BL3 extending in the first horizontal direction HD1 and spaced a certain distance from each other in the second horizontal direction HD2 are provided on the drains DR.

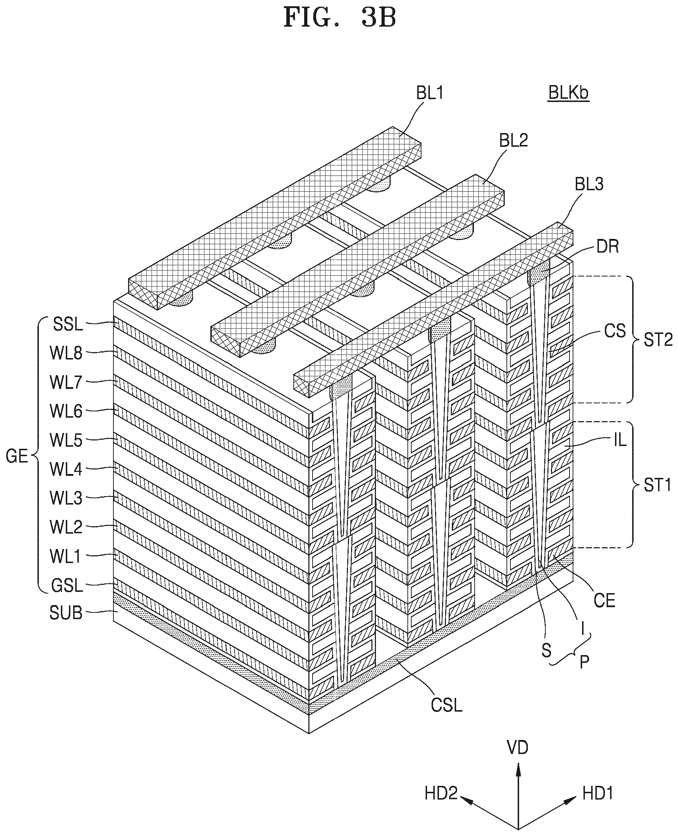

FIG. 3B is a perspective view illustrating a memory block BLKb according to an embodiment.

Referring to FIG. 3B, the memory block BLKb may correspond to one of the plurality of memory blocks BLK of FIG. 1. Alternatively or additionally, the memory block BLKb corresponds to a modification of the memory block BLKa of FIG. 3A, and the descriptions provided above with reference to FIG. 3A may also be applied to memory block BLKb of FIG. 3B. The memory block BLKb may be formed in a direction perpendicular to the substrate SUB. The memory block BLKb may include a first memory stack ST1 and a second memory stack ST2, which are stacked in the vertical direction VD.

FIG. 4 is a diagram schematically illustrating a memory device 40 having a cell-over-periphery (COP) structure, according to an embodiment.

Referring to FIGS. 1 and 4, the memory device 40 may include a first semiconductor layer L1 and a second semiconductor layer L2, and the first semiconductor layer L1 may be stacked in the vertical direction VD with respect to the second semiconductor layer L2. For example, the second semiconductor layer L2 may be arranged below the first semiconductor layer L1 in the vertical direction VD, and accordingly, may be arranged close to the substrate.

In some embodiments, the memory cell array 11 may be formed in the first semiconductor layer L1, and the peripheral circuit PECT may be formed in the second semiconductor layer L2. Accordingly, the memory device 40 may have a structure in which the memory cell array 11 is arranged on top of the peripheral circuit PECT, (e.g., a COP structure). The COP structure may effectively reduce a horizontal area and improve the degree of integration of the memory device 40.

In some embodiments, the second semiconductor layer L2 may include a substrate, and the peripheral circuit PECT may be formed in the second semiconductor layer L2 by forming transistors and metal patterns for the wiring of the transistors on the substrate. After the peripheral circuit PECT is formed in the second semiconductor layer L2, the first semiconductor layer L1 including the memory cell array 11 may be formed, and metal patterns for electrically connecting the word lines WL and the bit lines BL of the memory cell array 11 to the peripheral circuit PECT formed in the second semiconductor layer L2 may be formed. For example, the bit lines BL may extend in the first horizontal direction HD1, and the word lines WL may extend in the second horizontal direction HD2. For example, the memory block BLKa of FIG. 3A or the memory block BLKb of FIG. 3B may be formed in the first semiconductor layer L1.

With the development of semiconductor processes, as the number of memory cells arranged (disposed) in the memory cell array 11 of the first semiconductor layer L1 increases, (e.g., as the number of stacked word lines WL increases), the area of the memory cell array 11, (e.g., the area of a cell region) decreases. For example, the cell region may be defined as a region in which a plurality of NAND strings (e.g., NS11 to NS33 of FIG. 2) or a plurality of pillars (e.g., P of FIGS. 3A and 3B) are arranged. For another example, the cell region may be defined as a region in which a plurality of word lines (e.g., WL1 to WL8 of FIGS. 2, 3A, and 3B) are arranged. For another example, the cell region may be defined as a region in which a plurality of bit lines (e.g., BL1, BL2, BL3 of FIGS. 2, 3A, and 3B) are arranged. However, the cell region is not limited thereto, and may be defined as a region including the memory cell array 11.

Alternatively or additionally, the area of a peripheral circuit region in which the peripheral circuit PECT of the second semiconductor layer L2 is arranged may not decrease as much as does the area of the cell region. Accordingly, in some embodiments, a first peripheral circuit region of the peripheral circuit region of the second semiconductor layer L2 overlaps the memory cell array 11 in the vertical direction VD, and a second peripheral circuit region of the peripheral circuit region of the second semiconductor layer L2 may not overlap the memory cell array 11 in the vertical direction VD.

FIG. 5 is a diagram illustrating a memory device 50, according to some embodiments.

Referring to FIG. 5, the memory device 50 may have a chip-to-chip (C2C) structure. At least one upper chip including a cell region and a lower chip including a peripheral circuit region PERI may be manufactured separately, and then, the at least one upper chip and the lower chip may be connected to each other by a bonding method to realize the C2C structure. For example, the bonding method may refer to a method of electrically and/or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. Alternatively or additionally, the bonding metal patterns may be formed of aluminum (Al) or tungsten (W).

The memory device 50 may include the at least one upper chip including the cell region. For example, as illustrated in FIG. 5, the memory device 50 may include two upper chips. However, the number of the upper chips is not limited thereto. In the case in which the memory device 50 includes the two upper chips, a first upper chip including a first cell region CELL1, a second upper chip including a second cell region CELL2 and the lower chip including the peripheral circuit region PERI may be manufactured separately, and then, the first upper chip, the second upper chip and the lower chip may be connected to each other by the bonding method to manufacture the memory device 50. The first upper chip may be turned over and then may be connected to the lower chip by the bonding method, and the second upper chip may also be turned over and then may be connected to the first upper chip by the bonding method. Hereinafter, upper and lower portions of each of the first and second upper chips will be defined based on before each of the first and second upper chips is turned over. That is, an upper portion of the lower chip may mean an upper portion defined based on a +Z-axis direction, and the upper portion of each of the first and second upper chips may mean an upper portion defined based on a -Z-axis direction in FIG. 5. However, embodiments are not limited thereto. In some embodiments, one of the first upper chip and the second upper chip may be turned over and then may be connected to a corresponding chip by the bonding method.

Each of the peripheral circuit region PERI and the first and second cell regions CELL1 and CELL2 of the memory device 50 may include an external pad bonding region PA, a word line bonding region WLBA, and a bit line bonding region BLBA.

The peripheral circuit region PERI may include a first substrate 210 and a plurality of circuit elements 220a, 220b and 220c formed on the first substrate 210. An interlayer insulating layer 215 including one or more insulating layers may be provided on the plurality of circuit elements 220a, 220b and 220c, and a plurality of metal lines electrically connected (coupled) to the plurality of circuit elements 220a, 220b and 220c may be provided in the interlayer insulating layer 215. For example, the plurality of metal lines may include first metal lines 230a, 230b and 230c connected to the plurality of circuit elements 220a, 220b and 220c, and second metal lines 240a, 240b and 240c formed on the first metal lines 230a, 230b and 230c. The plurality of metal lines may be formed of at least one of various conductive materials. For example, the first metal lines 230a, 230b and 230c may be formed of tungsten having a relatively high electrical resistivity, and the second metal lines 240a, 240b and 240c may be formed of copper having a relatively low electrical resistivity.

The first metal lines 230a, 230b and 230c and the second metal lines 240a, 240b and 240c are illustrated and described in the present embodiments. However, embodiments are not limited thereto. In some embodiments, at least one or more additional metal lines may further be formed on the second metal lines 240a, 240b and 240c. In this case, the second metal lines 240a, 240b and 240c may be formed of aluminum, and at least some of the additional metal lines formed on the second metal lines 240a, 240b and 240c may be formed of copper having an electrical resistivity lower than that of aluminum of the second metal lines 240a, 240b and 240c.

The interlayer insulating layer 215 may be arranged on the first substrate 210 and may include an insulating material such as, but not limited to, silicon oxide and/or silicon nitride.

Each of the first and second cell regions CELL1 and CELL2 may include at least one memory block. The first cell region CELL1 may include a second substrate 310 and a common source line 320. A plurality of word lines 330 (e.g., 331 to 338) may be stacked on the second substrate 310 in a direction (e.g., the Z-axis direction) perpendicular to a top surface of the second substrate 310. String select lines and a ground select line may be arranged on and under the word lines 330, and the plurality of word lines 330 may be arranged between the string select lines and the ground select line. Similarly, the second cell region CELL2 may include a third substrate 410 and a common source line 420, and a plurality of word lines 430 (431 to 438) may be stacked on the third substrate 410 in a direction (e.g., the Z-axis direction) perpendicular to a top surface of the third substrate 410. Each of the second substrate 310 and the third substrate 410 may be formed of at least one of various materials and may be, for example, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell regions CELL1 and CELL2.

In some embodiments, as illustrated in a region A1, the channel structure CH may be provided in the bit line bonding region BLBA and may extend in the direction perpendicular to the top surface of the second substrate 310 to penetrate the word lines 330, the string select lines, and the ground select line. The channel structure CH may include a data storage layer, a channel layer, and a filling insulation layer. The channel layer may be electrically connected to a first metal line 350c and a second metal line 360c in the bit line bonding region BLBA. For example, the second metal line 360c may be a bit line and may be connected to the channel structure CH through the first metal line 350c. The bit line 360c may extend in a first direction (e.g., a Y-axis direction) parallel to the top surface of the second substrate 310.

**In** some embodiments, as illustrated in a region A2, the channel structure CH may include a lower channel LCH and an upper channel UCH, which are connected to each other. For example, the channel structure CH may be formed by a process of forming the lower channel LCH and a process of forming the upper channel UCH. The lower channel LCH may extend in the direction perpendicular to the top surface of the second substrate 310 to penetrate the common source line 320 and lower word lines 331 and 332. The lower channel LCH may include a data storage layer, a channel layer, and a filling insulation layer and may be connected to the upper channel UCH. The upper channel UCH may penetrate upper word lines 333 to 338. The upper channel UCH may include a data storage layer, a channel layer, and a filling insulation layer, and the channel layer of the upper channel UCH may be electrically connected to the first metal line 350c and the second metal line 360c. As a length of a channel increases, due to characteristics of manufacturing processes, it may be difficult to form a channel having a substantially uniform width. The memory device 50 according to the present embodiments may include a channel having improved width uniformity due to the lower channel LCH and the upper channel UCH which are formed by the processes performed sequentially.

In the case in which the channel structure CH includes the lower channel LCH and the upper channel UCH as illustrated in the region A2, a word line located near to a boundary between the lower channel LCH and the upper channel UCH may be a dummy word line. For example, the word lines 332 and 333 adjacent to the boundary between the lower channel LCH and the upper channel UCH may be the dummy word lines. **In** this case, data may not be stored in memory cells connected to the dummy word line. Alternatively or additionally, the number of pages corresponding to the memory cells connected to the dummy word line may be less than the number of pages corresponding to the memory cells connected to a general word line. A level of a voltage applied to the dummy word line may be different from a level of a voltage applied to the general word line, and, as such, may reduce an influence of a non-uniform channel width between the lower and upper channels LCH and UCH on an operation of the memory device.

In some embodiments, the number of the lower word lines 331 and 332 penetrated by the lower channel LCH is less than the number of the upper word lines 333 to 338 penetrated by the upper channel UCH in the region A2. However, embodiments are not limited thereto. In some embodiments, the number of the lower word lines penetrated by the lower channel LCH may be equal to or more than the number of the upper word lines penetrated by the upper channel UCH. Alternatively or additionally, structural features and connection relation of the channel structure CH arranged in the second cell region CELL2 may be substantially the same as those of the channel structure CH arranged in the first cell region CELL1.

In the bit line bonding region BLBA, a first through-electrode THV1 may be provided in the first cell region CELL1, and a second through-electrode THV2 may be provided in the second cell region CELL2. As illustrated in FIG. 5, the first through-electrode THV1 may penetrate the common source line 320 and the plurality of word lines 330. In some embodiments, the first through-electrode THV1 may further penetrate the second substrate 310. The first through-electrode THV1 may include a conductive material. Alternatively or additionally, the first through-electrode THV1 may include a conductive material surrounded by an insulating material. The second through-electrode THV2 may have the same shape and structure as the first through-electrode THV1.

In some embodiments, the first through-electrode THV1 and the second through-electrode THV2 may be electrically connected to each other through a first through-metal pattern 372d and a second through-metal pattern 472d. The first through-metal pattern 372d may be formed at a bottom end of the first upper chip including the first cell region CELL1, and the second through-metal pattern 472d may be formed at a top end of the second upper chip including the second cell region CELL2. The first through-electrode THV1 may be electrically connected to the first metal line 350c and the second metal line 360c. A lower via 371d may be formed between the first through-electrode THV1 and the first through-metal pattern 372d, and an upper via 471d may be formed between the second through-electrode THV2 and the second through-metal pattern 472d. The first through-metal pattern 372d and the second through-metal pattern 472d may be connected to each other by the bonding method.

Alternatively or additionally, in the bit line bonding region BLBA, an upper metal pattern 252 may be formed in an uppermost metal layer of the peripheral circuit region PERI, and an upper metal pattern 392 having the same shape as the upper metal pattern 252 may be formed in an uppermost metal layer of the first cell region CELL1. The upper metal pattern 392 of the first cell region CELL1 and the upper metal pattern 252 of the peripheral circuit region PERI may be electrically connected to each other by the bonding method. In the bit line bonding region BLBA, the bit line 360c may be electrically connected to a page buffer included in the peripheral circuit region PERI. For example, some of the circuit elements 220c of the peripheral circuit region PERI may constitute the page buffer, and the bit line 360c may be electrically connected to the circuit elements 220c constituting the page buffer through an upper bonding metal pattern 370c of the first cell region CELL1 and an upper bonding metal pattern 270c of the peripheral circuit region PERI.

Continuing to refer to FIG. 5, in the word line bonding region WLBA, the word lines 330 of the first cell region CELL1 may extend in a second direction (e.g., an X-axis direction) parallel to the top surface of the second substrate 310 and may be connected to a plurality of cell contact plugs 340 (e.g., 341 to 347). First metal lines 350b and second metal lines 360b may be sequentially connected onto the cell contact plugs 340 connected to the word lines 330. In the word line bonding region WLBA, the cell contact plugs 340 may be connected to the peripheral circuit region PERI through upper bonding metal patterns 370b of the first cell region CELL1 and upper bonding metal patterns 270b of the peripheral circuit region PERI.

The cell contact plugs 340 may be electrically connected to a row decoder included in the peripheral circuit region PERI. For example, some of the circuit elements 220b of the peripheral circuit region PERI may constitute the row decoder, and the cell contact plugs 340 may be electrically connected to the circuit elements 220b constituting the row decoder through the upper bonding metal patterns 370b of the first cell region CELL1 and the upper bonding metal patterns 270b of the peripheral circuit region PERI. In some embodiments, an operating voltage of the circuit elements 220b constituting the row decoder may be different from an operating voltage of the circuit elements 220c constituting the page buffer. For example, the operating voltage of the circuit elements 220c constituting the page buffer may be greater than the operating voltage of the circuit elements 220b constituting the row decoder.

Similarly, in the word line bonding region WLBA, the word lines 430 of the second cell region CELL2 may extend in the second direction (e.g., the X-axis direction) parallel to the top surface of the third substrate 410 and may be connected to a plurality of cell contact plugs 440 (e.g., 441 to 447). The cell contact plugs 440 may be connected to the peripheral circuit region PERI through an upper metal pattern of the second cell region CELL2 and lower and upper metal patterns and a cell contact plug 348 of the first cell region CELL1.

In the word line bonding region WLBA, the upper bonding metal patterns 370b may be formed in the first cell region CELL1, and the upper bonding metal patterns 270b may be formed in the peripheral circuit region PERI. The upper bonding metal patterns 370b of the first cell region CELL1 and the upper bonding metal patterns 270b of the peripheral circuit region PERI may be electrically connected to each other by the bonding method. The upper bonding metal patterns 370b and the upper bonding metal patterns 270b may be formed of aluminum, copper, or tungsten.

In the external pad bonding region PA, a lower metal pattern 371e may be formed in a lower portion of the first cell region CELL1, and an upper metal pattern 472a may be formed in an upper portion of the second cell region CELL2. The lower metal pattern 371e of the first cell region CELL1 and the upper metal pattern 472a of the second cell region CELL2 may be connected to each other by the bonding method in the external pad bonding region PA. Similarly, an upper metal pattern 372a may be formed in an upper portion of the first cell region CELL1, and an upper metal pattern 272a may be formed in an upper portion of the peripheral circuit region PERI. The upper metal pattern 372a of the first cell region CELL1 and the upper metal pattern 272a of the peripheral circuit region PERI may be connected to each other by the bonding method.

Common source line contact plugs 380 and 480 may be disposed in the external pad bonding region PA. The common source line contact plugs 380 and 480 may be formed of a conductive material such as a metal, a metal compound, and/or doped polysilicon. The common source line contact plug 380 of the first cell region CELL1 may be electrically connected to the common source line 320, and the common source line contact plug 480 of the second cell region CELL2 may be electrically connected to the common source line 420. A first metal line 350a and a second metal line 360a may be sequentially stacked on the common source line contact plug 380 of the first cell region CELL1, and a first metal line 450a and a second metal line 460a may be sequentially stacked on the common source line contact plug 480 of the second cell region CELL2.

Input/output pads 205, 405 and 406 may be arranged in the external pad bonding region PA. Referring to FIG. 5, a lower insulating layer 201 may cover a bottom surface of the first substrate 210, and a first input/output pad 205 may be formed on the lower insulating layer 201. The first input/output pad 205 may be connected to at least one of a plurality of the circuit elements 220a disposed in the peripheral circuit region PERI through a first input/output contact plug 203 and may be separated from the first substrate 210 by the lower insulating layer 201. Alternatively or additionally, a side insulating layer may be arranged between the first input/output contact plug 203 and the first substrate 210 to electrically isolate the first input/output contact plug 203 from the first substrate 210.

An upper insulating layer 401 covering a top surface of the third substrate 410 may be formed on the third substrate 410. A second input/output pad 405 and/or a third input/output pad 406 may be arranged on the upper insulating layer 401. The second input/output pad 405 may be connected to at least one of the plurality of circuit elements 220a arranged in the peripheral circuit region PERI through second input/output contact plugs 403 and 303, and the third input/output pad 406 may be connected to at least one of the plurality of circuit elements 220a arranged in the peripheral circuit region PERI through third input/output contact plugs 404 and 304.

In some embodiments, the third substrate 410 may not be arranged in a region in which the input/output contact plug is arranged. For example, as illustrated in a region B, the third input/output contact plug 404 may be separated from the third substrate 410 in a direction parallel to the top surface of the third substrate 410 and may penetrate an interlayer insulating layer 415 of the second cell region CELL2 so as to be connected to the third input/output pad 406. In this case, the third input/output contact plug 404 may be formed by at least one of various processes.

In some embodiments, as illustrated in a region B1, the third input/output contact plug 404 may extend in a third direction (e.g., the Z-axis direction), and a diameter of the third input/output contact plug 404 may become progressively greater toward the upper insulating layer 401. That is, a diameter of the channel structure CH described in the region A1 may become progressively less toward the upper insulating layer 401, but the diameter of the third input/output contact plug 404 may become progressively greater toward the upper insulating layer 401. For example, the third input/output contact plug 404 may be formed after the second cell region CELL2 and the first cell region CELL1 are bonded to each other by the bonding method.

In some embodiments, as illustrated in a region B2, the third input/output contact plug 404 may extend in the third direction (e.g., the Z-axis direction), and a diameter of the third input/output contact plug 404 may become progressively less toward the upper insulating layer 401.That is, like the channel structure CH, the diameter of the third input/output contact plug 404 may become progressively less toward the upper insulating layer 401. For example, the third input/output contact plug 404 may be formed together with the cell contact plugs 440 before the second cell region CELL2 and the first cell region CELL1 are bonded to each other.

In some embodiments, the input/output contact plug may overlap with the third substrate 410. For example, as illustrated in a region C, the second input/output contact plug 403 may penetrate the interlayer insulating layer 415 of the second cell region CELL2 in the third direction (e.g., the Z-axis direction) and may be electrically connected to the second input/output pad 405 through the third substrate 410. In this case, a connection structure of the second input/output contact plug 403 and the second input/output pad 405 may be realized by various methods.

In some embodiments, as illustrated in a region C1, an opening 408 may be formed to penetrate the third substrate 410, and the second input/output contact plug 403 may be connected directly to the second input/output pad 405 through the opening 408 formed in the third substrate 410. In this case, as illustrated in the region C1, a diameter of the second input/output contact plug 403 may become progressively greater toward the second input/output pad 405. However, embodiments are not limited thereto, and in some embodiments, the diameter of the second input/output contact plug 403 may become progressively less toward the second input/output pad 405.

In some embodiments, as illustrated in a region C2, the opening 408 penetrating the third substrate 410 may be formed, and a contact 407 may be formed in the opening 408. An end of the contact 407 may be connected to the second input/output pad 405, and another end of the contact 407 may be connected to the second input/output contact plug 403. Thus, the second input/output contact plug 403 may be electrically connected to the second input/output pad 405 through the contact 407 in the opening 408. In this case, as illustrated in the region C2, a diameter of the contact 407 may become progressively greater toward the second input/output pad 405, and a diameter of the second input/output contact plug 403 may become progressively less toward the second input/output pad 405. For example, the second input/output contact plug 403 may be formed together with the cell contact plugs 440 before the second cell region CELL2 and the first cell region CELL1 are bonded to each other, and the contact 407 may be formed after the second cell region CELL2 and the first cell region CELL1 are bonded to each other.

In some embodiments, as shown in a region C3, a stopper 409 may further be formed on a bottom end of the opening 408 of the third substrate 410, as compared with the embodiments of the region C2. The stopper 409 may be a metal line formed in the same layer as the common source line 420. Alternatively or additionally, the stopper 409 may be a metal line formed in the same layer as at least one of the word lines 430. The second input/output contact plug 403 may be electrically connected to the second input/output pad 405 through the contact 407 and the stopper 409.

Like the second and third input/output contact plugs 403 and 404 of the second cell region CELL2, a diameter of each of the second and third input/output contact plugs 303 and 304 of the first cell region CELL1 may become progressively less toward the lower metal pattern 371e or may become progressively greater toward the lower metal pattern 371e.

In some embodiments, a slit 411 may be formed in the third substrate 410. For example, the slit 411 may be formed at a certain position of the external pad bonding region PA. For example, as illustrated in a region 'D', the slit 411 may be located between the second input/output pad 405 and the cell contact plugs 440 when viewed in a plan view. Alternatively or additionally, the second input/output pad 405 may be located between the slit 411 and the cell contact plugs 440 when viewed in a plan view.

In some embodiments, as illustrated in a region D1, the slit 411 may be formed to penetrate the third substrate 410. For example, the slit 411 may be used to prevent the third substrate 410 from being finely cracked when the opening 408 is formed. However, embodiments are not limited thereto, and in some embodiments, the slit 411 may be formed to have a depth ranging from about 60% to about 70% of a thickness of the third substrate 410.

In some embodiments, as illustrated in a region D2, a conductive material 412 may be formed in the slit 411. For example, the conductive material 412 may be used to discharge a leakage current occurring in driving of the circuit elements in the external pad bonding region PA to the outside. In this case, the conductive material 412 may be connected to an external ground line.

In some embodiments, as illustrated in a region D3, an insulating material 413 may be formed in the slit 411. For example, the insulating material 413 may be used to electrically isolate the second input/output pad 405 and the second input/output contact plug 403 arranged in the external pad bonding region PA from the word line bonding region WLBA. Since the insulating material 413 is formed in the slit 411, a voltage provided through the second input/output pad 405 may be prevented from affecting a metal layer arranged on the third substrate 410 in the word line bonding region WLBA.

In some embodiments, the first to third input/output pads 205, 405 and 406 may be selectively formed. For example, the memory device 50 may be realized to include only the first input/output pad 205 arranged on the first substrate 210, to include only the second input/output pad 405 arranged on the third substrate 410, or to include only the third input/output pad 406 arranged on the upper insulating layer 401.

In some embodiments, at least one of the second substrate 310 of the first cell region CELL1 or the third substrate 410 of the second cell region CELL2 may be used as a sacrificial substrate and may be completely or partially removed before or after a bonding process. An additional layer may be stacked after the removal of the substrate. For example, the second substrate 310 of the first cell region CELL1 may be removed before or after the bonding process of the peripheral circuit region PERI and the first cell region CELL1, and then, an insulating layer covering a top surface of the common source line 320 or a conductive layer for connection may be formed. Similarly, the third substrate 410 of the second cell region CELL2 may be removed before or after the bonding process of the first cell region CELL1 and the second cell region CELL2, and then, the upper insulating layer 401 covering a top surface of the common source line 420 or a conductive layer for connection may be formed.

Referring to FIGS. 1 and 5, with the development of semiconductor process, as the number of stages of memory cells arranged in the memory cell array 11 of the first and second cell regions CELL1 and CELL2 increases (e.g., as the number of stacked word lines WL increases), the area of the memory cell array 11 (e.g., the area of a cell region) decreases. For example, the cell region may be defined as a region in which a plurality of NAND strings (e.g., NS11 to NS33 of FIG. 2) or a plurality of pillars (e.g., P of FIGS. 3A and 3B) are arranged. For another example, the cell region may be defined as a region in which a plurality of word lines (e.g., WL1 to WL8 of FIGS. 2, 3A, and 3B) are arranged. For another example, the cell region may be defined as a region in which a plurality of bit lines (e.g., BL1, BL2, BL3 of FIGS. 2, 3A, and 3B) are arranged. However, the cell region is not limited thereto, and may be defined as a region including the memory cell array 11.

Moreover, the area of a peripheral circuit region PERI in which the peripheral circuit PECT is arranged may not decrease as much as does the area of the cell region. Accordingly, in some embodiments, a first peripheral circuit region of the peripheral circuit region PERI overlaps the memory cell array 11 in the vertical direction VD, and a second peripheral circuit region of the peripheral circuit region PERI may not overlap the memory cell array 11 in the vertical direction VD.

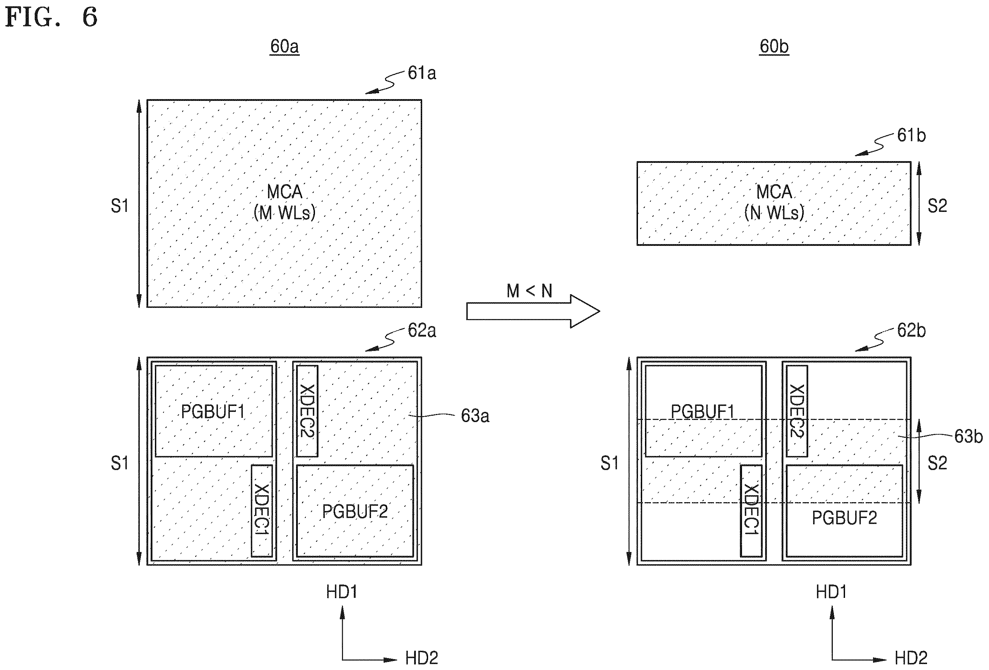

FIG. 6 is a diagram illustrating a memory device 60a according to a comparative example, and a memory device 60b, according to an embodiment.

Referring to FIG. 6, the memory device 60a according to the comparative example may include a first semiconductor layer 61a in which a memory cell array MCA is arranged, and a second semiconductor layer 62a in which page buffer circuits PGBUF1 and PGBUF2 and row decoders XDEC1 and XDEC2 are arranged. When the memory cell array MCA includes M word lines stacked in the vertical direction, that is, when the memory cell array MCA includes a stack structure of M word lines, the memory cell array MCA may have a first size S1 in the first horizontal direction HD1, where M is an integer greater than 1. Alternatively or additionally, the second semiconductor layer 62a may also have the first size S1 in the first horizontal direction HD1, and accordingly, the memory cell array MCA may be on and overlap the second semiconductor layer 62a. In this case, the area of an overlap region 63a on the second semiconductor layer 62a may correspond to the area of the memory cell array MCA. That is, the size of the overlap region 63a on the second semiconductor layer 62a in the first horizontal direction HD1 may correspond to the first size s1, which is equal to the size of the memory cell array MCA in the first horizontal direction HD1.

The memory device 60b, according to some embodiments, may include a first semiconductor layer 61b in which the memory cell array MCA is arranged, and a second semiconductor layer 62b in which the page buffer circuits PGBUF1 and PGBUF2 and the row decoders XDEC1 and XDEC2 are arranged. With the development of semiconductor processing technology, the number of word lines stacked in the vertical direction may increase from M to N, where N is an integer greater than M). Accordingly, when the memory cell array MCA includes N word lines stacked in the vertical direction, that is, when the memory cell array MCA includes a stack structure of N word lines, the area of the memory cell array MCA may decrease. For example, the area of the memory cell array MCA may decrease by 60% compared to the comparative example.

For another example, the memory cell array MCA may have a second size S2 less than the first size S1 in the first horizontal direction HD1. The second semiconductor layer 62b may have the first size S1 in the first horizontal direction HD1, and accordingly, the memory cell array MCA may be on and overlap a partial region of the second semiconductor layer 62b. In this case, the area of an overlap region 63b on the second semiconductor layer 62b may correspond to the area of the memory cell array MCA. That is, the size of the overlap region 63b on the second semiconductor layer 62b in the first horizontal direction HD1 may correspond to the second size s2, which is equal to the size of the memory cell array MCA in the first horizontal direction HD1.

The first semiconductor layer 61b may correspond to the first semiconductor layer L1 of FIG. 4 or the cell region CELL1 or CELL2 of FIG. 5, and the second semiconductor layer 62b may correspond to the second semiconductor layer L2 of FIG. 4 or the peripheral circuit region PERI of FIG. 5. As described above, according to some embodiments, the memory cell array MCA may be on and overlap the partial region of the second semiconductor layer 62b rather than the entire region thereof. For example, the memory cell array MCA may be on and overlap partial regions of the page buffer circuits PGBUF1 and PGBUF2. For example, the memory cell array MCA may be on and overlap partial regions of the row decoders XDEC1 and XDEC2.

In some embodiments, the memory cell array MCA may be on and overlap partial regions of the page buffer circuits PGBUF1 and PGBUF2 and entire regions of the row decoders XDEC1 and XDEC2. That is, the page buffer circuits PGBUF1 and PGBUF2 may be partially buried by the memory cell array MCA, and the row decoders XDEC1 and XDEC2 may be completely buried by the memory cell array MCA. In some embodiments, the memory cell array MCA may be on and overlap partial regions of the page buffer circuits PGBUF1 and PGBUF2 and the entire region of one of the row decoders XDEC1 and XDEC2. That is, the page buffer circuits PGBUF1 and PGBUF2 may be partially buried by the memory cell array MCA, and one of the row decoders XDEC1 and XDEC2 may be completely buried by the memory cell array MCA.

In some embodiments, the memory cell array MCA may be on and overlap the entire regions of the page buffer circuits PGBUF1 and PGBUF2 and partial regions of the row decoders XDEC1 and XDEC2. That is, the page buffer circuits PGBUF1 and PGBUF2 may be completely buried by the memory cell array MCA, and the row decoders XDEC1 and XDEC2 may be partially buried by the memory cell array MCA. Alternatively or additionally, the memory cell array MCA may be on and overlap the entire region of one of the page buffer circuits PGBUF1 and PGBUF2 and partial regions of the row decoders XDEC1 and XDEC2. That is, one of the page buffer circuits PGBUF1 and PGBUF2 may be completely buried by the memory cell array MCA, and the row decoders XDEC 1 and XDEC2 may be partially buried by the memory cell array MCA.

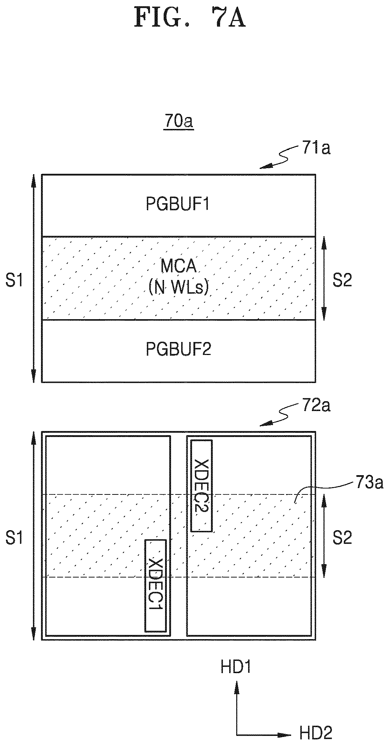

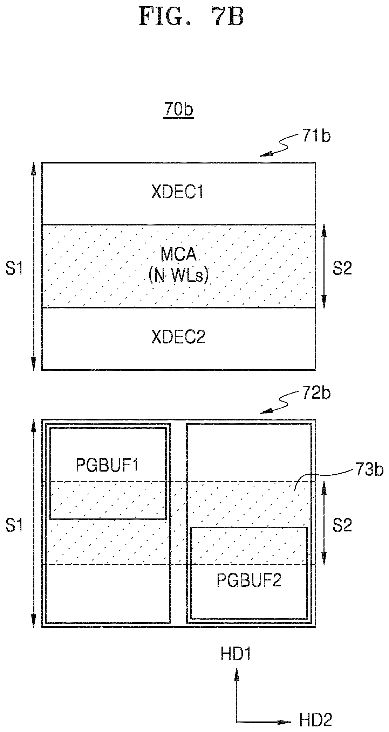

FIGS. 7A and 7B are diagrams illustrating memory devices 70a and 70b, respectively, according to some embodiments. The memory devices 70a and 70b correspond to modifications of the memory device 60b of FIG. 6, and the descriptions provided above with reference to FIG. 6 may also be applied to the present embodiments.

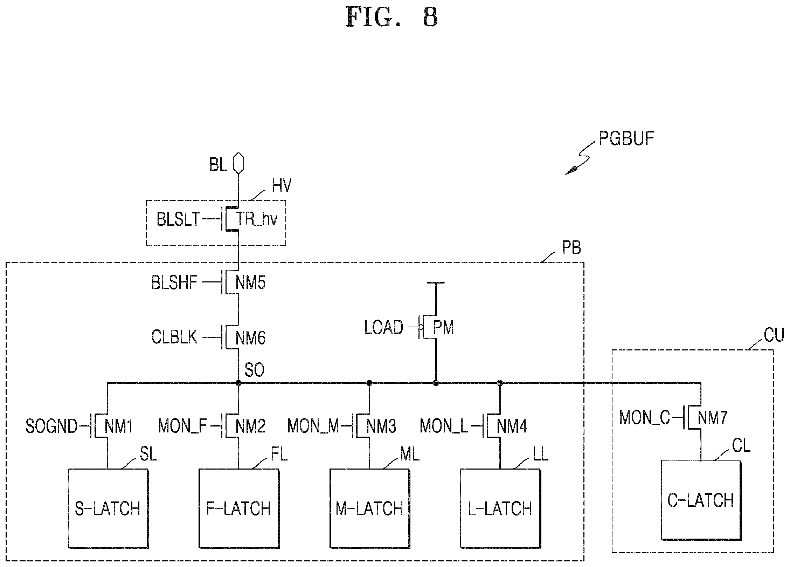

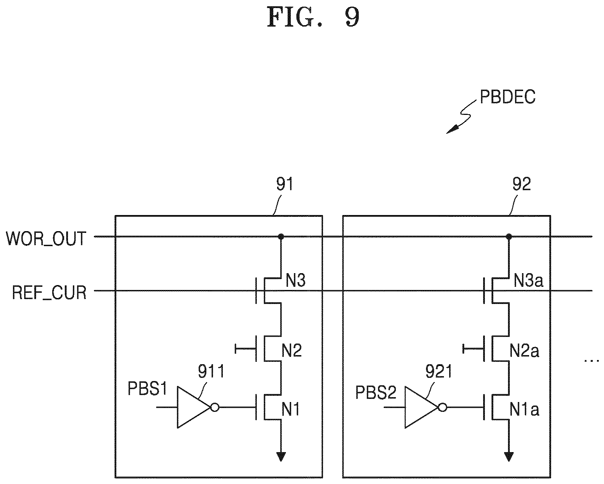

Referring to FIG. 7A, the memory device 70a may include a first semiconductor layer 71a in which the memory cell array MCA and the page buffer circuits PGBUF1 and PGBUF2 are arranged, and a second semiconductor layer 72a in which the row decoders XDEC1 and XDEC2 are arranged. The memory cell array MCA may be on and overlap a partial region of the second semiconductor layer 72a. In this case, the size of an overlap region 73a on the second semiconductor layer 72a may correspond to the second size S2 of the memory cell array MCA. Some components of the page buffer circuits PGBUF1 and PGBUF2 may be arranged in the first semiconductor layer 71a, and the remaining components of the page buffer circuits PGBUF1 and PGBUF2 may be arranged in the second semiconductor layer 72a. For example, a high-voltage unit (e.g., HV of FIG. 8) and/or a page buffer (e.g., PB of FIG. 8) may be arranged in the first semiconductor layer 71a, and a cache unit (e.g., the CU of FIG. 8) and/or a page buffer decoder (e.g., PBDEC of FIG. 9) may be arranged in the second semiconductor layer 72a. The page buffer circuit PGBUF1 may be arranged in the first semiconductor layer 71a, and the page buffer circuit PGBUF2 may be arranged in the second semiconductor layer 72a.

The memory cell array MCA may be on and overlap partial regions of the row decoders XDEC1 and XDEC2, and accordingly, the row decoders XDEC1 and XDEC2 may be partially buried by the memory cell array MCA. In some embodiments, the memory cell array MCA may be on and overlap one of the row decoders XDEC1 and XDEC2, and accordingly, the one of the row decoders XDEC1 and XDEC2 may be completely buried by the memory cell array MCA, and the other one of the row decoders XDEC1 and XDEC2 may not be buried by the memory cell array MCA. The memory cell array MCA may be on and overlap a partial region of one of the row decoders XDEC1 and XDEC2, and accordingly, the one of the row decoders XDEC1 and XDEC2 may be partially buried by the memory cell array MCA, and the other one of the row decoders XDEC1 and XDEC2 may be completely buried by the memory cell array MCA.

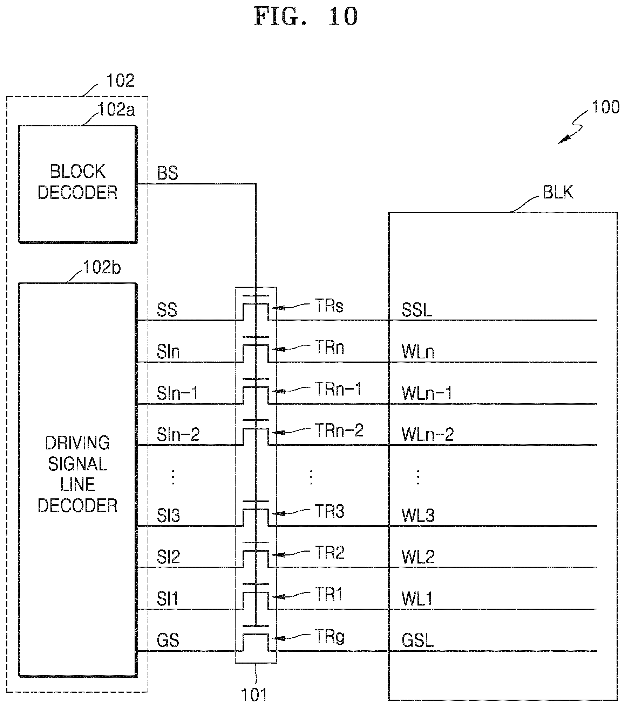

Referring to FIG. 7B, the memory device 70b may include a first semiconductor layer 71b in which the memory cell array MCA and the row decoders XDEC1 and XDEC2 are arranged, and a second semiconductor layer 72b in which the page buffer circuits PGBUF1 and PGBUF2 are arranged. The memory cell array MCA may be on and overlap a partial region of the second semiconductor layer 72b. In this case, the size of an overlap region 73b on the second semiconductor layer 72b may correspond to the second size S2 of the memory cell array MCA. Some components of the row decoders XDEC1 and XDEC2 may be arranged in the first semiconductor layer 71b, and the remaining components of the row decoders XDEC1 and XDEC2 may be arranged in the second semiconductor layer 72b. For example, a pass transistor circuit (e.g., 101 of FIG. 10) may be arranged in the first semiconductor layer 71b, and a row decoder (e.g., 102 of FIG. 10) may be arranged in the second semiconductor layer 72b. The row decoder XDEC1 may be arranged in the first semiconductor layer 71a, and the row decoder XDEC2 may be arranged in the second semiconductor layer 72a.

The memory cell array MCA may be on and overlap partial regions of the page buffer circuits PGBUF1 and PGBUF2, and accordingly, the page buffer circuits PGBUF1 and PGBUF2 may be partially buried by the memory cell array MCA. The memory cell array MCA may be on and overlap one of the page buffer circuits PGBUF1 and PGBUF2, and accordingly, the one of the page buffer circuits PGBUF1 and PGBUF2 may be completely buried by the memory cell array MCA, and the other one of the page buffer circuits PGBUF1 and PGBUF2 may not be buried by the memory cell array MCA. The memory cell array MCA may be on and overlap a partial region of one of the page buffer circuits PGBUF1 and PGBUF2, and accordingly, the one of the page buffer circuits PGBUF1 and PGBUF2 may be partially buried by the memory cell array MCA, and the other one of the page buffer circuits PGBUF1 and PGBUF2 may be completely buried by the memory cell array MCA.

FIG. 8 is a circuit diagram illustrating a page buffer circuit PGBUF according to an embodiment.

Referring to FIG. 8, the page buffer circuit PGBUF may correspond to one of the page buffer circuits PGBUF1 and PGBUF2 of FIG. 6, and may correspond to one of the plurality of page buffers PB of FIG. 1. The page buffer circuit PGBUF may include a high-voltage unit HV, a page buffer PB, and a cache unit CU, and the cache unit CU may include a cache latch (C-LATCH) CL.

The high-voltage unit HV may include a bit line select transistor TR_hv connected to a bit line BL and driven by a bit line select signal BLSLT. The bit line select transistor TR_hv may be implemented as a "high-voltage transistor" and may be arranged in a well region other than that of the page buffer PB. According to some embodiments, the bit line select transistor TR _hv may be referred to as a bit line select switch or a high-voltage switch.

The page buffer PB may include a sensing latch (S-LATCH) SL, a force latch (F-LATCH) FL, an upper-bit latch (M-LATCH) ML and a lower-bit latch (L-LATCH) LL. According to some embodiments, the S-LATCH SL, the F-LATCH FL, the M-LATCH ML, or the L-LATCH LL may be referred to as a "main latch". Alternatively or additionally, the page buffer PB may further include a precharge circuit capable of controlling a precharge operation on the bit line BL or a sensing node SO based on a bit line clamping control signal, and may further include a transistor driven by a bit line setup signal.

The S-LATCH SL may store, in a read operation or a program verify operation, data stored in a memory cell or a result of sensing a threshold voltage of the memory cell. Alternatively or additionally, the S-LATCH SL may be used to apply, in a program operation, a program bit line voltage or a program inhibit voltage to the bit line BL. The F-LATCH FL may be used to store, in a program operation, force data and improve threshold voltage distribution. After the force data is initially set to '1', the force data may be converted to '0' when the threshold voltage of the memory cell enters a forcing region that has a voltage less than that of a target region. The M-LATCH ML, the L-LATCH LL, and the C-LATCH CL may be used to store, in a program operation, data input from an external source. In a read operation, the C-LATCH CL may receive, from the S-LATCH SL, data read from a memory cell and output the data to the outside through a data input/output line.

The page buffer PB may further include first to fourth transistors NM1 to NM4. The first transistor NM1 may be connected between the sensing node SO and the S-LATCH SL, and may be driven by a ground control signal SOGND. The second transistor NM2 may be connected between the sensing node SO and the F-LATCH FL, and may be driven by a forcing monitoring signal MON_F. The third transistor NM3 may be connected between the sensing node SO and the M-LATCH ML, and may be driven by an upper-bit monitoring signal MON_M. The fourth transistor NM4 may be connected between the sensing node SO and the L-LATCH LL and may be driven by a lower-bit monitoring signal MON_L.

The page buffer PB may further include fifth and sixth transistors NM5 and NM6 connected in series between the bit line select transistor TR_hv and the sensing node SO. The fifth transistor NM5 may be driven by a bit line shut-off signal BLSHF, and the sixth transistor NM6 may be driven by a bit line connection control signal CLBLK. Alternatively or additionally, the page buffer PB may further include a precharge transistor PM. The precharge transistor PM is connected to the sensing node SO, is driven by a load signal LOAD, and precharges the sensing node SO to a precharge level in a precharge period.

The cache unit CU may include the C-LATCH CL and a seventh transistor NM7. The seventh transistor NM7 may be connected between the sensing node SO and the C-LATCH CL, and may be driven by a cache monitoring signal MON_C. The C-LATCH CL may be connected to the data input/output line, and accordingly, the cache unit CU may be arranged adjacent to the data input/output line. As such, the page buffer PB and the cache unit CU may be arranged to be spaced apart from each other, and the page buffer circuit PGBUF may have a structure in which the page buffer PB and the cache unit CU are separated from each other.

In some embodiments, the page buffer PB of the page buffer circuit PGBUF may be buried by a cell region in which a memory cell array is arranged, and thus overlap the cell region in a vertical direction, whereas the high-voltage unit HV and the cache unit CU may not be buried by the cell region, and thus not overlap the cell region in the vertical direction. In some embodiments, the high-voltage unit HV of the page buffer circuit PGBUF may be buried by the cell region and thus overlap the cell region in the vertical direction, whereas the page buffer PB and the cache unit CU may not be buried by the cell region, and thus not overlap the cell region in the vertical direction. In some embodiments, the page buffer PB and the high-voltage unit HV of the page buffer circuit PGBUF may be buried by the cell region and thus overlap the cell region in the vertical direction, whereas the cache unit CU may not be buried by the cell region, and thus not overlap the cell region in the vertical direction. In some embodiments, the page buffer PB, the high-voltage unit HV, and the cache unit CU of the page buffer circuit PGBUF may be buried by the cell region and thus overlap the cell region in the vertical direction.

FIG. 9 is a circuit diagram illustrating a page buffer decoder PBDEC according to an embodiment.

Referring to FIG. 9, the page buffer decoder PBDEC may include a plurality of page buffer decoders for addressing and driving a memory cell array, for example, first and second page buffer decoders 91 and 92. The first page buffer decoder 91 may include a first inverter 911 and transistors N1, N2, and N3. The first inverter 911 may receive a first page buffer signal PBS1 from a first page buffer circuit (e.g., PGBUF of FIG. 8 ), and an output of the first inverter 911 may be provided to the gate of the transistor N1. The source of the transistor N1 may be connected to a ground terminal, and the drain of the transistor N1 may be connected to the transistor N2. The transistors N2 and N3 are connected to each other in series, and a reference current signal REF_CUR is applied to the gate of the transistor N3. The second page buffer decoder 92 may include an inverter 921 and transistors N1a, N2a, and N3a, and may receive a second page buffer PBS2 from a second page buffer circuit. The description of the first page buffer decoder 91 may be applied to the second page buffer decoder 92, and thus will be omitted.

Referring to FIGS. 8 and 9, for example, when a memory cell connected to the page buffer circuit PGBUF is program-failed, a logic low level may be stored in the S-LATCH SL of the page buffer PB, and in this case, the first page buffer signal PBS1 may be at a logic low level that is the voltage level of the sensing node SO. In this case, the first inverter 911 may output a logic high signal, accordingly, the transistor N1 may be turned on, and the page buffer decoder 91 may operate as a current sink. The transistor N3 may output a first signal, that is, a reference current, to a wired OR terminal WOR_OUT based on the reference current signal REF_CUR. Here, the reference current may correspond to a current flowing through the transistor N3 when the transistor N3 is turned on according to the reference current signal REF CUR.

For example, each of the page buffer circuit 12 of FIG. 1 and the page buffer circuits PGBUF1 and PGBUF2 of FIGS. 6, 7A, and 7B may include the page buffer circuit PGBUF of FIG. 8. For example, each of the page buffer circuit 12 of FIG. 1 and the page buffer circuits PGBUF1 and PGBUF2 of FIGS. 6, 7A, and 7B may include the page buffer circuit PGBUF of FIG. 8 and the page buffer decoder PBDEC of FIG. 9. Hereinafter, according to some embodiments, the page buffer decoder PBDEC may be described as being included in the page buffer circuit, and the page buffer decoder PBDEC may be described as being arranged outside the page buffer circuit.

Referring to FIGS. 8 and 9, in some embodiments, the page buffer PB may be buried by a cell region in which a memory cell array is arranged, and thus overlap the cell region in a vertical direction, whereas the high-voltage unit HV, the cache unit CU, and the page buffer decoder PBDEC may not be buried by the cell region, and thus not overlap the cell region in the vertical direction. In some embodiments, the high-voltage unit HV may be buried by the cell region and thus overlap the cell region in the vertical direction, whereas the page buffer PB, the cache unit CU, and the page buffer decoder PBDEC may not be buried by the cell region and thus not overlap the cell region in the vertical direction. In some embodiments, the page buffer PB and the high-voltage unit HV may be buried by a cell region in which a memory cell array is arranged, and thus overlap the cell region in the vertical direction, whereas the cache unit CU and the page buffer decoder PBDEC may not be buried by the cell region and thus not overlap the cell region in the vertical direction. In some embodiments, the page buffer PB, the high-voltage unit HV, and the cache unit CU may be buried by a cell region in which a memory cell array is arranged, and thus overlap the cell region in the vertical direction, whereas the page buffer decoder PBDEC may not be buried by the cell region and thus not overlap the cell region in the vertical direction.

FIG. 10 is a diagram illustrating a pass transistor circuit 101 and a row decoder 102 according to an embodiment.

Referring to FIG. 10, a memory device 100 may include the memory block BLK, the pass transistor circuit 101, and the row decoder 102. The row decoder 102 may include a block decoder 102a and a driving signal line decoder 102b. For example, each of the row decoder 13 of FIG. 1 and the row decoders XDEC1 and XDEC2 of FIGS. 6, 7A, and 7B may include the row decoder 102. For example, each of the row decoder 13 of FIG. 1 and the row decoders XDEC1 and XDEC2 of FIGS. 6, 7A, and 7B may include the pass transistor circuit 101 and the row decoder 102.

The pass transistor circuit 101 may include a plurality of pass transistors TRg, TR1 to TRn, and TRs. The block decoder 102a may be connected to the pass transistor circuit 101 through a block select signal line BS. The block select signal line BS may be connected to gates of the plurality of pass transistors TRg, TR1 to TRn, and TRs. For example, when a block select signal provided through the block select signal line BS is activated, the plurality of pass transistors TRg, TR1 to TRn, and TRs may be turned on, and accordingly, the memory block BLK may be selected.

The driving signal line decoder 102b may be connected to the pass transistor circuit 101 through a ground select line driving signal line GS, word line driving signal lines SI1 to SIn, and a string select line driving signal line SS. For example, the ground select line driving signal line GS, the word line driving signal lines SI1 to SIn, and the string select line driving signal line SS may be connected to sources of the plurality of pass transistors TRg, TR1 to TRn, and TRs, respectively.

The pass transistor circuit 101 may be connected to the memory block BLK through a ground select line GSL, word lines WL1 to WLn, and a string select line SSL. The pass transistor TRg may be connected between the ground select line driving signal line GS and the ground select line GSL. The plurality of pass transistors TR1 to TRn may be respectively connected between the word line driving signal lines SI1 to SIn and the plurality of word lines WL1 to WLn. The pass transistor TRs may be connected between the string select line driving signal line SS and the string select line SSL. For example, when a block select signal is activated, the plurality of pass transistors TRg, TR1 to TRn, and TRs may provide the ground select line GSL, the word lines WL1 to WLn, and the string select line SSL with driving signals provided through the ground select line driving signal line GS, the word line driving signal lines SI1 to SIn, and the string select line driving signal line SS, respectively.

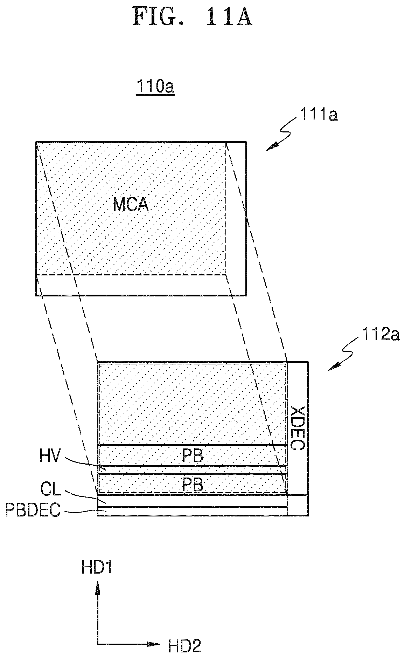

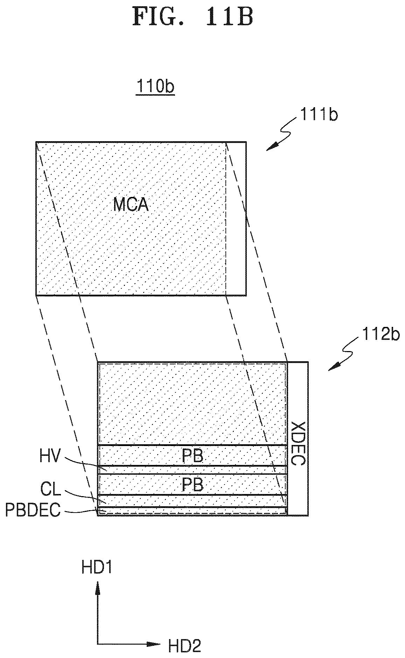

FIG. 11A is a diagram illustrating a memory devices 110a according to an embodiment, and FIGS. 11B to 11D are diagrams illustrating memory devices 110b, 110c, and 110d, respectively, according to the disclosure.

Referring to FIG. 11A, the memory device 110a includes a first semiconductor layer 111a and a second semiconductor layer 112a, the first semiconductor layer 111a includes the memory cell array MCA, and the second semiconductor layer 112a includes the page buffers PB, the high-voltage unit HV, the C-LATCH CL, the page buffer decoder PBDEC, and a row decoder XDEC. The page buffers PB, the high-voltage unit HV, the C-LATCH CL, and the page buffer decoder PBDEC may correspond to, for example, the page buffer circuits PGBUF1 and PGBUF2 of FIGS. 6, 7A, and 7B, the row decoder XDEC may correspond to, for example, the row decoders XDEC1 and XDEC2 of FIGS. 6, 7A, and 7B, and this may be equally applied to the following embodiments.

The area of a cell region in which the memory cell array MCA is arranged may be smaller than the area of the first semiconductor layer 111a, and the area of a peripheral circuit region in which a peripheral circuit including the page buffers PB, the high-voltage unit HV, the C-LATCH CL, the page buffer decoder PBDEC, and the row decoder XDEC is arranged may be similar to the area of the second semiconductor layer 112a. In some embodiments, in the first semiconductor layer 111a, an insulating layer may be arranged in a region in which the memory cell array MCA is not arranged. Alternatively or additionally, in the first semiconductor layer 111a, a wiring structure including a plurality of metal layers may be arranged in a region in which the memory cell array MCA is not arranged. In some embodiments, in the first semiconductor layer 111a, some elements of a peripheral circuit (e.g., PECT of FIG. 1) may be arranged in a region in which the memory cell array MCA is not arranged. This may be equally applied to the following embodiments.

In some embodiments, the memory cell array MCA may be on and overlap the page buffers PB and the high-voltage unit HV. As such, a portion of the page buffer circuit, for example, the page buffers PB and the high-voltage unit HV may be buried by the memory cell array MCA, and the remaining portions of the page buffer circuit, for example, the C-LATCH CL and the page buffer decoder PBDEC may not be buried by the memory cell array MCA. Alternatively or additionally, the row decoder XDEC may not be buried by the memory cell array MCA.

As such, the second semiconductor layer 112a may include a first peripheral circuit region in which the page buffers PB and the high-voltage unit HV are arranged, and a second peripheral circuit region in which the C-LATCH CL, the page buffer decoder PBDEC, and the row decoder XDEC are arranged. The first peripheral circuit region may overlap, in the vertical direction, the cell region in which the memory cell array MCA is arranged, and the second peripheral circuit region may not overlap, in the vertical direction, the cell region in which the memory cell array MCA is arranged.

In some embodiments, the second semiconductor layer 112a may further include a control logic circuit (e.g., 14 of FIG. 1) and/or a voltage generator (e.g., 15 of FIG. 1) arranged adjacent to the page buffer PB, and the control logic circuit and/or the voltage generator may be arranged adjacent to the page buffer PB in the first peripheral circuit region. In some embodiments, the second semiconductor layer 112a may further include a macrocell logic arranged adjacent to the C-LATCH CL, the page buffer decoder PBDEC, and the row decoder XDEC, and the macrocell logic may be arranged in the second peripheral circuit region, that is, may not overlap the memory cell array MCA in the vertical direction. For example, the macrocell logic may include a row decoder driving logic or a page buffer driving logic.

Referring to FIG. 11B, the memory device 110b may include a first semiconductor layer 111b and a second semiconductor layer 112b, and may correspond to a modification of the memory device 110a of FIG. 11A. In the memory device 110a of FIG. 11A, the page buffer circuit may be implemented to be partially buried, whereas in the memory device 110b, the page buffer circuit may be implemented to be completely buried. The memory cell array MCA may be on and overlap the page buffers PB, the high-voltage unit HV, the C-LATCH CL, and the page buffer decoder PBDEC. As such, the entire page buffer circuit of the second semiconductor layer 112b may be buried by the memory cell array MCA. The row decoder XDEC may not be buried by the memory cell array MCA, but the present disclosure is not limited thereto, and the row decoder XDEC may also be buried by the memory cell array MCA.

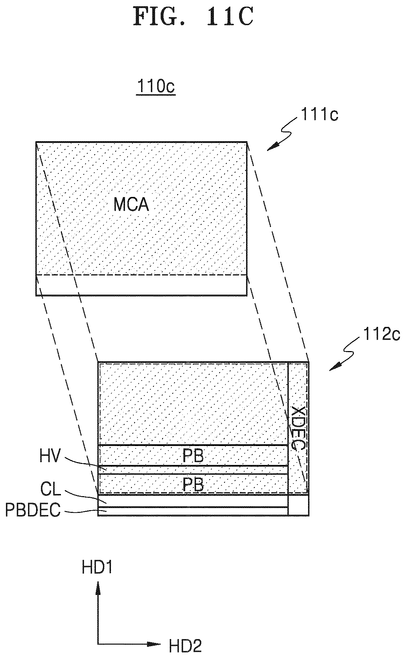

Referring to FIG. 11C, the memory device 110c may include a first semiconductor layer 111c and a second semiconductor layer 112c, and may correspond to a modification of the memory device 110a of FIG. 11A. In the memory device 110c, the row decoder XDEC may be implemented to be completely buried, and the page buffer circuit may be implemented to be partially buried. For example, the memory cell array MCA may be on and overlap the page buffers PB, the high-voltage unit HV, and the row decoder XDEC.

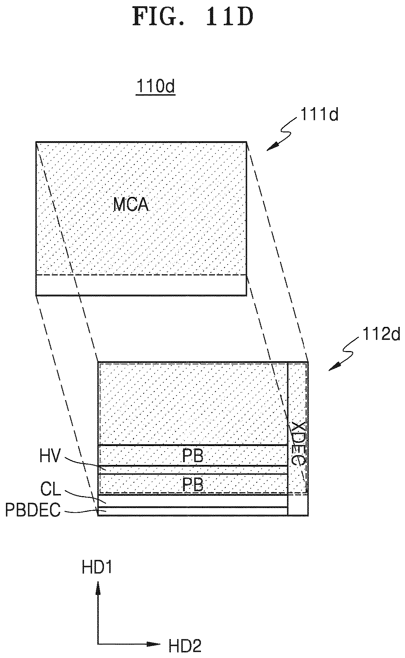

Referring to FIG. 11D, the memory device 110d may include a first semiconductor layer 111d and a second semiconductor layer 112d, and may correspond to a modification of the memory device 110c of FIG. 11C. In the memory device 110d, the row decoder XDEC may be implemented to be partially buried, and the page buffer circuit may also be implemented to be partially buried. For example, the memory cell array MCA may be on and overlap the page buffers PB, the high-voltage unit HV, and a partial region of the row decoder XDEC. For example, the memory cell array MCA may be on and overlap a pass transistor circuit included in the row decoder XDEC. For example, the memory cell array MCA may be on and overlap a ground select line driver and a string select line driver included in the row decoder XDEC. For example, the memory cell array MCA may be on and overlap a word line driver included in the row decoder XDEC.

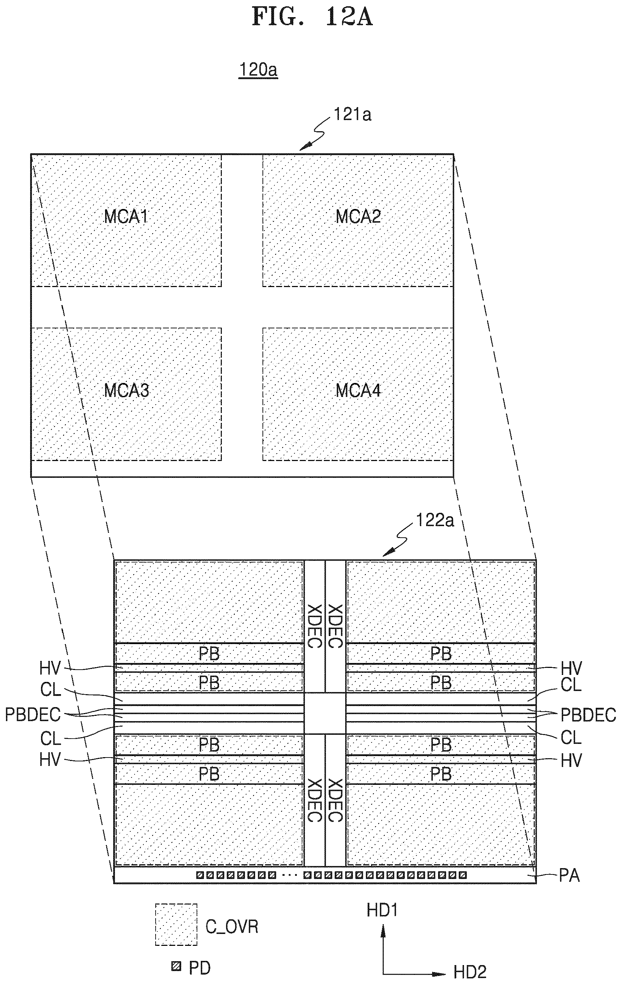

In some embodiments, when a memory device includes a plurality of memory cell arrays, some memory cell arrays and corresponding peripheral circuits may be arranged as illustrated in FIG. 11A, and the remaining memory cell arrays and corresponding peripheral circuits may be arranged as illustrated in at least one of FIGS. 11B, 11C, and 11D. However, the present disclosure is not limited thereto, and in some embodiments, when the memory device includes a plurality of memory cell arrays, the plurality of memory cell arrays and corresponding peripheral circuits may be arranged as illustrated in FIG. 11A, 11B, 11C, or 11D. These various embodiments are described with reference to FIGS. 12A to 12F.

FIG. 12A is a diagram illustrating a memory device 120a according to the disclosure.

Referring to FIG. 12A, the memory device 120a may include a first semiconductor layer 121a and a second semiconductor layer 122a, and first to fourth memory cell arrays MCA1, MCA2, MCA3, and MCA4 may be arranged in the first semiconductor layer 121a. The first to fourth memory cell arrays MCA1, MCA2, MCA3, and MCA4 may be referred to as a memory plane or MAT. The second semiconductor layer 122a may include the page buffers PB, the high-voltage unit HV, the C-LATCH CL, the page buffer decoder PBDEC, and the row decoder XDEC, which correspond to each of the first to fourth memory cell arrays MCA1, MCA2, MCA3, and MCA4. Alternatively or additionally, the second semiconductor layer 122a may further include a pad region PA. The pad region PA may be arranged in an edge region or a bottom region of the second semiconductor layer 122a, and may include a plurality of bonding pads PD arranged in the second horizontal direction HD2. In this case, the pad region PA may not be buried by cell overlap regions C_OVR, that is, may not overlap the cell overlap regions C_OVR in the vertical direction.

The first to fourth memory cell arrays MCA1, MCA2, MCA3, and MCA4 and corresponding peripheral circuits may be implemented as illustrated in FIG. 11A. For example, each of the first to fourth memory cell arrays MCA1, MCA2, MCA3, and MCA4 may be on the corresponding page buffers PB and high-voltage unit HV. That is, the page buffers PB and the high-voltage unit HV of the second semiconductor layer 122a may be partially buried by the cell overlap region C_OVR, and the C-LATCH CL, the page buffer decoder PBDEC, and the row decoder XDEC of the second semiconductor layer 122a may not be buried by the cell overlap region C_OVR.

The peripheral circuits arranged under some of the first to fourth memory cell arrays MCA1, MCA2, MCA3, and MCA4 may be partially buried, and the peripheral circuits arranged under the remaining memory cell arrays may be completely buried. A relatively large number of elements may be buried in the peripheral circuits arranged under some of the first to fourth memory cell arrays MCA1, MCA2, MCA3, and MCA4, and a relatively small number of elements may be buried in the peripheral circuits arranged under the remaining memory cell arrays. For example, the cell overlap regions C_OVR respectively corresponding to the first to fourth memory cell arrays MCA1, MCA2, MCA3, and MCA4 may have different sizes.

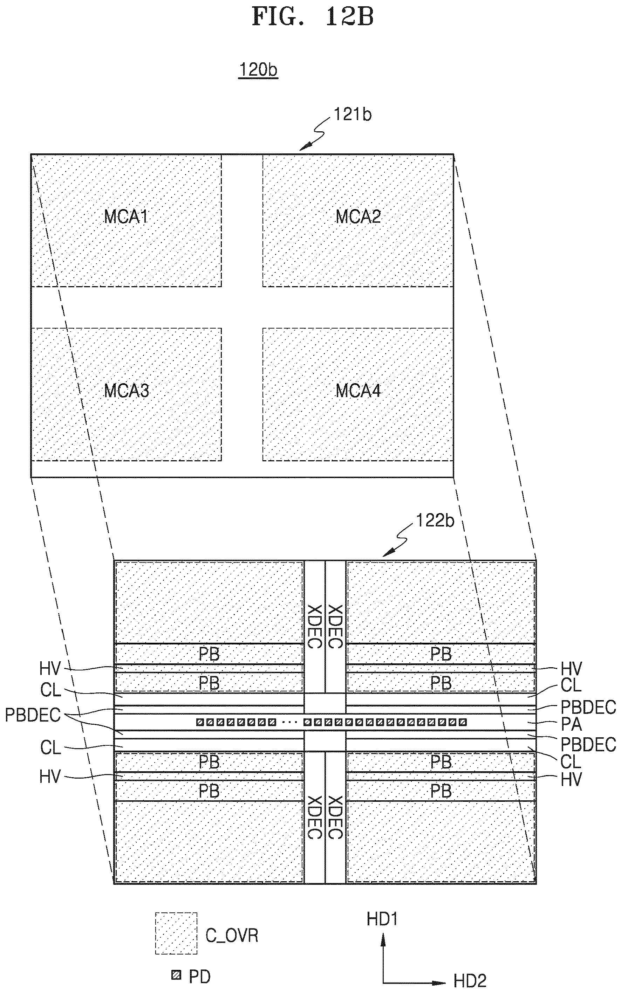

FIG. 12B is a diagram illustrating a memory device 120b according to an embodiment of the invention.

Referring to FIG. 12B, the memory device 120b includes a first semiconductor layer 121b and a second semiconductor layer 122b. The memory device 120b corresponds to a modification of the memory device 120a of FIG. 12A, and hereinafter, differences between the memory device 120b and the memory device 120a of FIG. 12A will be mainly described. In some embodiments, the pad region PA is arranged in a center region of the second semiconductor layer 122b, and includes the plurality of bonding pads PD arranged in the second horizontal direction HD2. The pad region PA extends between the first memory cell array MCA1 and the third memory cell array MCA3, and between the second memory cell array MCA2 and the fourth memory cell array MCA4, in the second horizontal direction HD2. In this case, the pad region PA is not buried by the cell overlap regions C_OVR, that is, do not overlap the cell overlap regions C_OVR in the vertical direction.

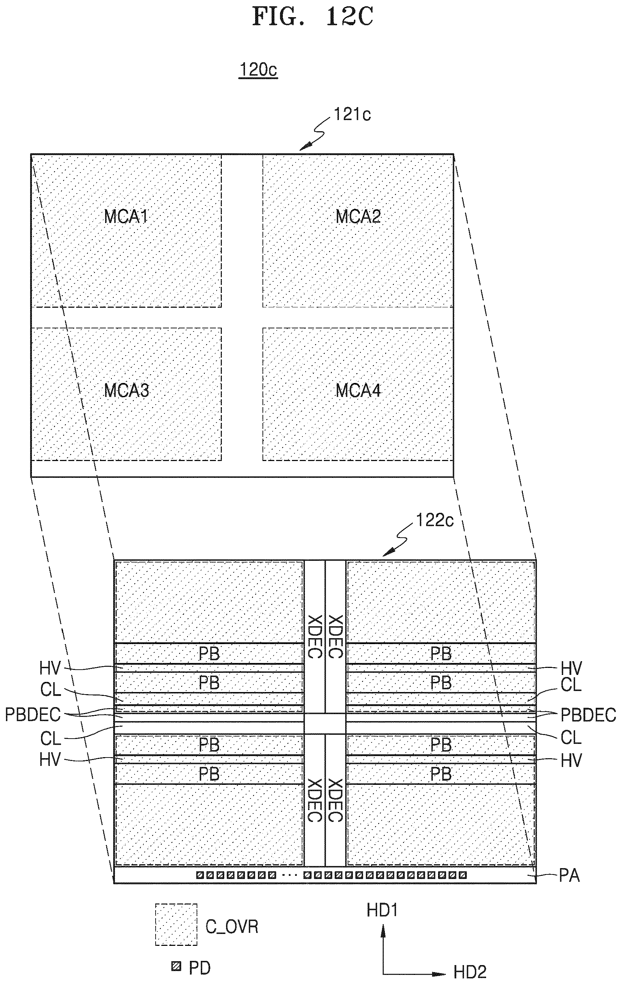

FIG. 12C is a diagram illustrating a memory device 120c according to the disclosure.

Referring to FIG. 12C, the memory device 120c may include a first semiconductor layer 121c and a second semiconductor layer 122c. The memory device 120c corresponds to a modification of the memory device 120a of FIG. 12A, and hereinafter, differences between the memory device 120c and the memory device 120a of FIG. 12A will be mainly described. The first and second memory cell arrays MCA1 and MCA2 and the corresponding peripheral circuits may be implemented as illustrated in FIG. 11B, and the third and fourth memory cell arrays MCA3 and MCA4 and the corresponding peripheral circuits may be implemented as illustrated in FIG. 11A. For example, the peripheral circuits corresponding to each of the first and second memory cell arrays MCA1 and MCA2, for example, the page buffers PB, the high-voltage unit HV, the C-LATCH CL, and the page buffer decoder PBDEC may be completely buried by the cell overlap region C_OVR, and the peripheral circuits corresponding to each of the third and fourth memory cell arrays MCA3 and MCA4, for example, the page buffers PB and the high-voltage unit HV may be partially buried by the cell overlap region C_OVR. In this case, a cell region of each of the first and second memory cell arrays MCA1 and MCA2 may be larger than a cell region of each of the third and fourth memory cell arrays MCA3 and MCA4.

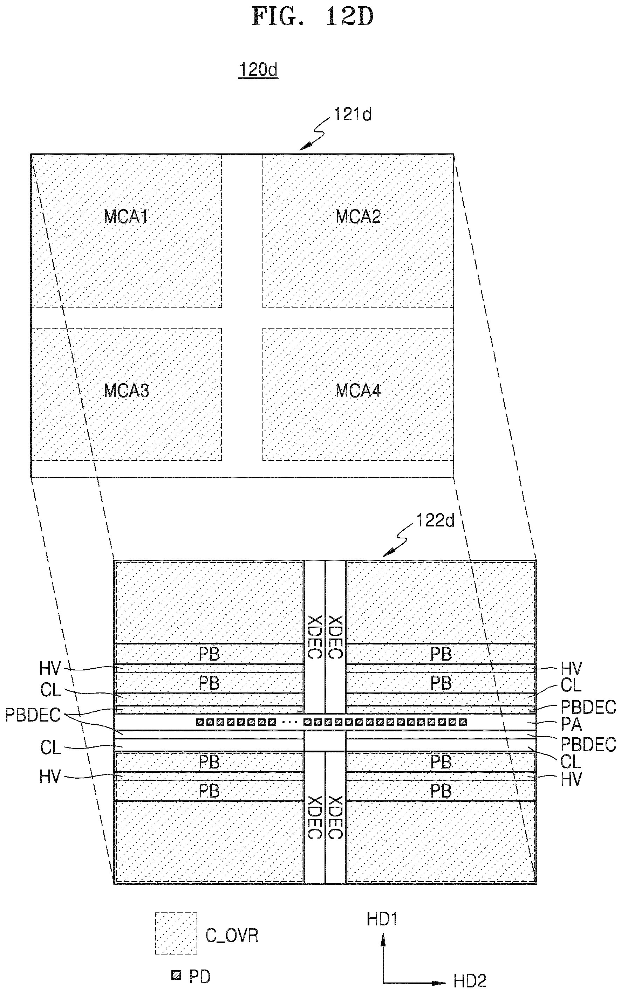

FIG. 12D is a diagram illustrating a memory device 120d according to the disclosure.

Referring to FIG. 12D, the memory device 120d may include a first semiconductor layer 121d and a second semiconductor layer 122d. The memory device 120d corresponds to a modification of the memory device 120b of FIG. 12B, and hereinafter, differences between the memory device 120d and the memory device 120b of FIG. 12B will be mainly described. The first and second memory cell arrays MCA1 and MCA2 and the corresponding peripheral circuits may be implemented as illustrated in FIG. 11B, and the third and fourth memory cell arrays MCA3 and MCA4 and the corresponding peripheral circuits may be implemented as illustrated in FIG. 11A. For example, the peripheral circuits corresponding to each of the first and second memory cell arrays MCA1 and MCA2, for example, the page buffers PB, the high-voltage unit HV, the C-LATCH CL, and the page buffer decoder PBDEC may be completely buried by the cell overlap region C_OVR, and the peripheral circuits corresponding to each of the third and fourth memory cell arrays MCA3 and MCA4, for example, the page buffers PB and the high-voltage unit HV may be partially buried by the cell overlap region C_OVR. In this case, a cell region of each of the first and second memory cell arrays MCA1 and MCA2 may be larger than a cell region of each of the third and fourth memory cell arrays MCA3 and MCA4.

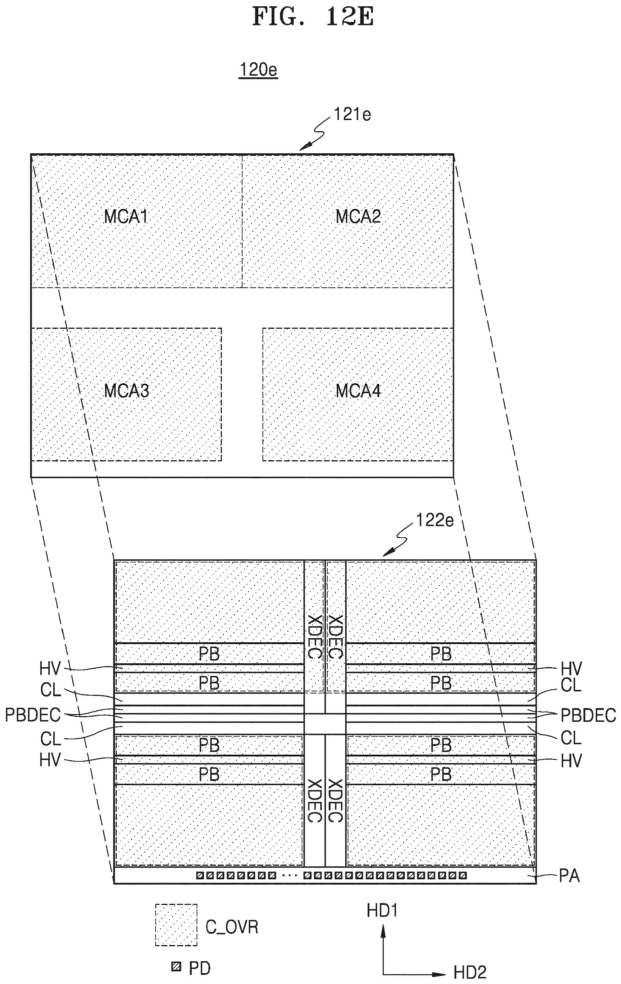

FIG. 12E is a diagram illustrating a memory device 120e according to the disclosure.

Referring to FIG. 12E, the memory device 120e may include a first semiconductor layer 121e and a second semiconductor layer 122e. The memory device 120e corresponds to a modification of the memory device 120c of FIG. 12C, and hereinafter, differences between the memory device 120e and the memory device 120c of FIG. 12C will be mainly described. The first and second memory cell arrays MCA1 and MCA2 and the corresponding peripheral circuits may be implemented as illustrated in FIG. 11D, and the third and fourth memory cell arrays MCA3 and MCA4 and the corresponding peripheral circuits may be implemented as illustrated in FIG. 11A. For example, a partial region of the page buffer circuit corresponding to each of the first and second memory cell arrays MCA1 and MCA2, for example, partial regions of the page buffers PB, the high-voltage unit HV, and the row decoder XDEC may be partially buried by the cell overlap region C_OVR, and the peripheral circuits corresponding to each of the third and fourth memory cell arrays MCA3 and MCA4, for example, the page buffers PB and the high-voltage unit HV may be partially buried by the cell overlap region C_OVR. In this case, a cell region of each of the first and second memory cell arrays MCA1 and MCA2 may be larger than a cell region of each of the third and fourth memory cell arrays MCA3 and MCA4 in the second direction HD2.

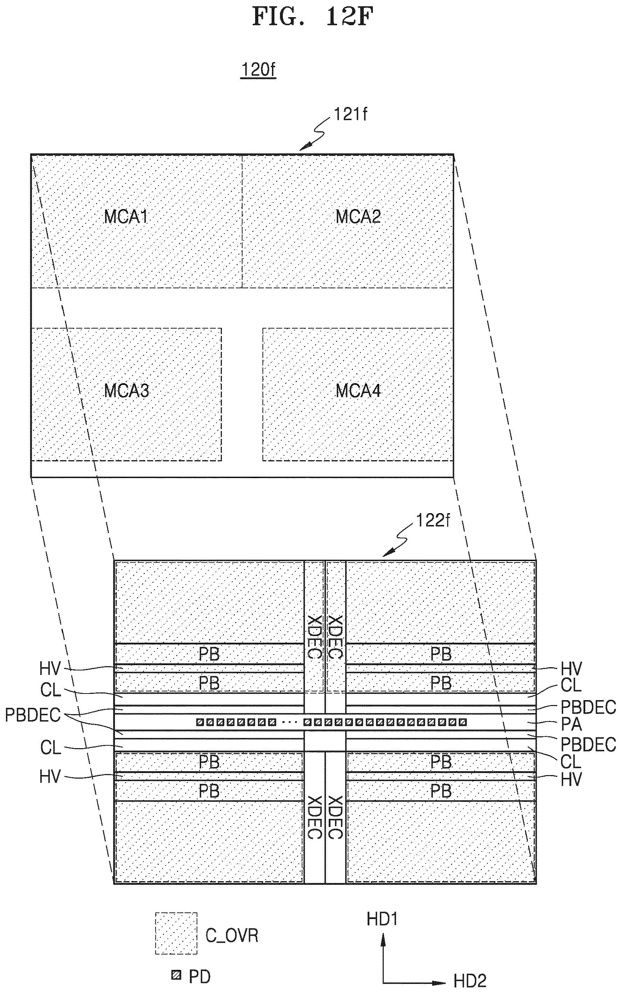

FIG. 12F is a diagram illustrating a memory device 120f according to the disclosure.

Referring to FIG. 12F, the memory device 120f may include a first semiconductor layer 121f and a second semiconductor layer 122f. The memory device 120f corresponds to a modification of the memory device 120d of FIG. 12D, and hereinafter, differences between the memory device 120f and the memory device 120d of FIG. 12D will be mainly described. The first and second memory cell arrays MCA1 and MCA2 and the corresponding peripheral circuits may be implemented as illustrated in FIG. 11D, and the third and fourth memory cell arrays MCA3 and MCA4 and the corresponding peripheral circuits may be implemented as illustrated in FIG. 11A. For example, a partial region of the page buffer circuit corresponding to each of the first and second memory cell arrays MCA1 and MCA2, for example, partial regions of the page buffers PB, the high-voltage unit HV, and the row decoder XDEC may be partially buried by the cell overlap region C_OVR, and the peripheral circuits corresponding to each of the third and fourth memory cell arrays MCA3 and MCA4, for example, the page buffers PB and the high-voltage unit HV may be partially buried by the cell overlap region C_OVR. In this case, a cell region of each of the first and second memory cell arrays MCA1 and MCA2 may be larger than a cell region of each of the third and fourth memory cell arrays MCA3 and MCA4 in the second direction HD2.

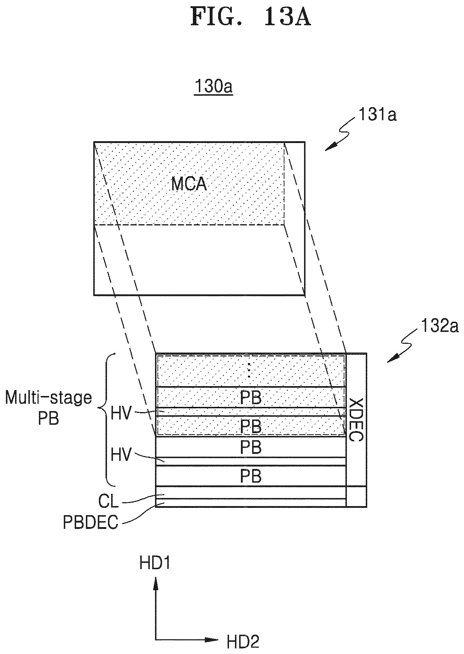

FIG. 13A is a diagram illustrating a memory device 130a according to the disclosure.

Referring to FIG. 13A, the memory device 130a may include a first semiconductor layer 131a and a second semiconductor layer 132a, the first semiconductor layer 131a may include the memory cell array MCA, and the second semiconductor layer 132a may include the page buffers PB, the high-voltage units HV, the C-LATCH CL, the page buffer decoder PBDEC, and the row decoder XDEC. According to the disclosure, the page buffers PB may be arranged in a multi-stage page buffer structure, and may be arranged in the first horizontal direction HD1. In this case, the memory cell array MCA may be on and overlap some of the page buffers PB and the high-voltage units HV, in the multi-stage page buffer structure. As such, some of the page buffers PB of the multi-stage page buffer structure and some of the high-voltage units HV may be buried by the memory cell array MCA, and the other page buffers PB of the multi-stage page buffer structure, the other high-voltage units HV, the C-LATCH CL, and the page buffer decoder PBDEC may not be buried by the memory cell array MCA. Alternatively or additionally, the row decoder XDEC may not be buried by the memory cell array MCA.

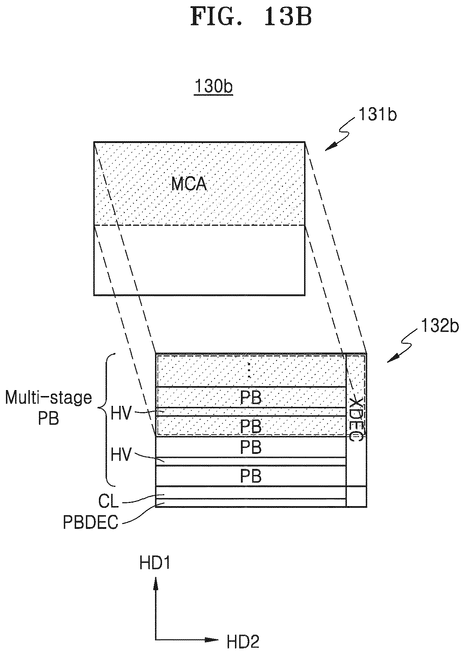

FIG. 13B is a diagram illustrating a memory device 130b according to the disclosure.

Referring to FIG. 13B, the memory device 130b may include a first semiconductor layer 131b and a second semiconductor layer 132b, and may correspond to a modification of the memory device 130a of FIG. 13A. The memory cell array MCA may be on and overlap some of the page buffers PB and the high-voltage units HV in the multi-stage page buffer structure, and may be on and overlap a partial region of the row decoder XDEC. As such, some of the page buffers PB of the multi-stage page buffer structure, some of the high-voltage units HV, and the partial region of the row decoder XDEC may be buried by the memory cell array MCA, and the other page buffers PB of the multi-stage page buffer structure, the other high-voltage units HV, the C-LATCH CL, the page buffer decoder PBDEC, and the remaining region of the row decoder XDEC may not be buried by the memory cell array MCA.

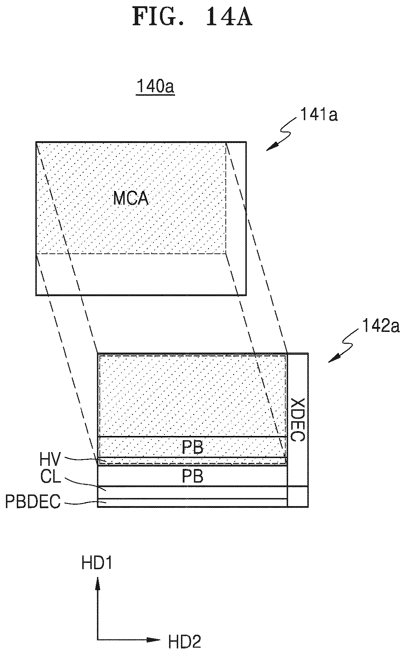

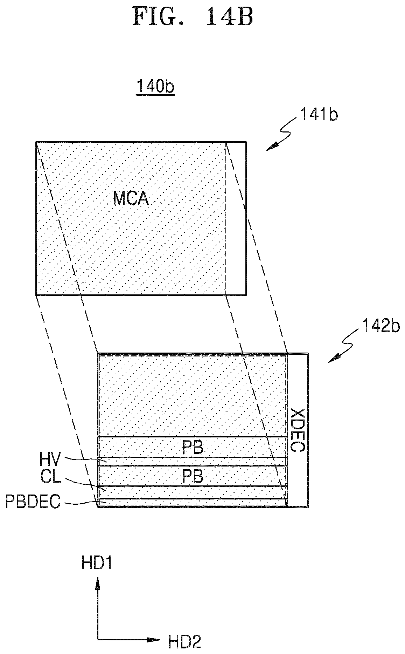

FIG. 14A and 14B are diagrams illustrating memory devices 140a and 140b, respectively, according to the disclosure.

Referring to FIG. 14A, the memory device 140a may include a first semiconductor layer 141a and a second semiconductor layer 142a, the first semiconductor layer 141a may include the memory cell array MCA, and the second semiconductor layer 142a may include the page buffers PB, the high-voltage unit HV, the C-LATCH CL, the page buffer decoder PBDEC, and the row decoder XDEC. For example, the size of a cell region in which the memory cell array MCA is arranged in the first semiconductor layer 141a may be smaller than the size of the cell region of FIG. 11A, but the present disclosure is not limited thereto. According to the disclosure, the memory cell array MCA may be on and overlap one page buffer PB and the high-voltage unit HV. As such, a portion of the page buffer circuit, for example, and one page buffer PB and the high-voltage unit HV may be buried by the memory cell array MCA, and the remaining portions of the page buffer circuit, for example, the other page buffer PB, the C-LATCH CL, and the page buffer decoder PBDEC may not be buried by the memory cell array MCA. Alternatively or additionally, the row decoder XDEC may not be buried by the memory cell array MCA.

Referring to FIG. 14B, the memory device 140b may include a first semiconductor layer 141b and a second semiconductor layer 142b, and may correspond to a modification of the memory device 140a of FIG. 14A. The memory device 140a of FIG. 14A may be implemented to be partially buried, whereas the memory device 140b according to the disclosure may be implemented to be completely buried. The memory cell array MCA may be on and overlap the page buffers PB, the high-voltage unit HV, the C-LATCH CL, and the page buffer decoder PBDEC. As such, the entire page buffer circuit may be buried by the memory cell array MCA. The row decoder XDEC may not be buried by the memory cell array MCA, but the present disclosure is not limited thereto, and according to the disclosure, the row decoder XDEC may also be buried by the memory cell array MCA.

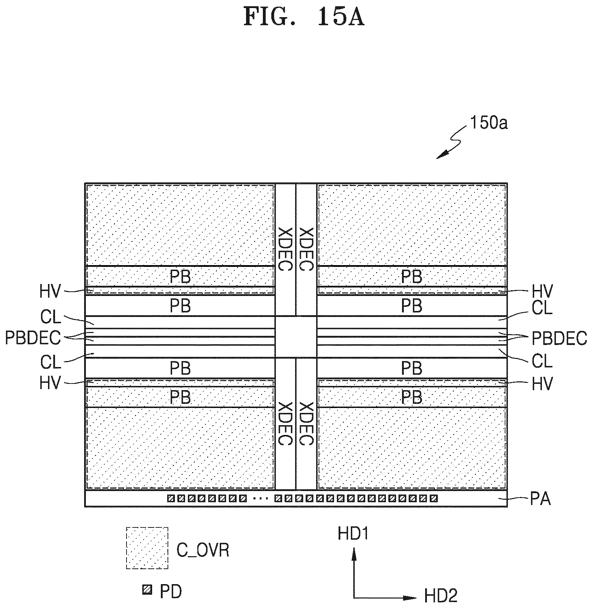

According to the disclosure, when a memory device includes a plurality of memory cell arrays, some memory cell arrays and corresponding peripheral circuits may be arranged as illustrated in FIG. 14A, and the remaining memory cell arrays and corresponding peripheral circuits may be arranged as illustrated in FIG. 14B. However, the present disclosure is not limited thereto, and according to the disclosure, when the memory device includes a plurality of memory cell arrays, the plurality of memory cell arrays and corresponding peripheral circuits may be arranged as illustrated in FIG. 14A or 14B. These various embodiments are described with reference to FIGS. 15A to 15D.

FIG. 15A is a diagram illustrating a memory device 150a according to the disclosure.

Referring to FIG. 15A, the memory device 150a may have a structure corresponding to the second semiconductor layer 142a of FIG. 14A. For example, the memory device 150a may include the page buffers PB, the high-voltage unit HV, the C-LATCH CL, the page buffer decoder PBDEC, and the row decoder XDEC, which correspond to each of a plurality of memory cell arrays, and a portion of a page buffer circuit, for example, one page buffer PB and the high-voltage unit HV may be buried by the cell overlap region C_OVR, that is, may overlap the cell overlap region C_OVR in the vertical direction. According to the disclosure, the remaining portion of the page buffer circuit, for example, the other page buffer PB, the C-LATCH CL, and the page buffer decoder PBDEC, and the row decoder XDEC may not be buried by the cell overlap region C_OVR, that is, may not overlap the cell overlap region C_OVR in the vertical direction. Furthermore, the memory device 150a may further include the pad region PA arranged in an edge region, and the pad region PA may include the plurality of bonding pads PD arranged in the second horizontal direction HD2. In this case, the pad region PA may not be buried by the cell overlap regions C_OVR, that is, may not overlap the cell overlap regions C_OVR in the vertical direction.

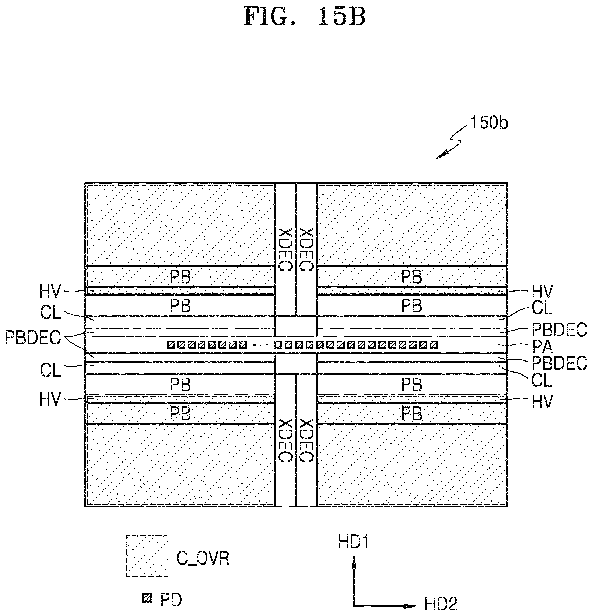

FIG. 15B is a diagram illustrating a memory device 150b according to the disclosure.

Referring to FIG. 15B, the memory device 150b may have a structure corresponding to the second semiconductor layer 142a of FIG. 14A. the memory device 150b may correspond to a modification of the memory device 150a of FIG. 15A, and the descriptions thereof provided above will be omitted. The memory device 150b may further include the pad region PA arranged in a center region, and the pad region PA may include the plurality of bonding pads PD arranged in the second horizontal direction HD2. In this case, the pad region PA may not be buried by the cell overlap regions C_OVR, that is, may not overlap the cell overlap regions C_OVR in the vertical direction.

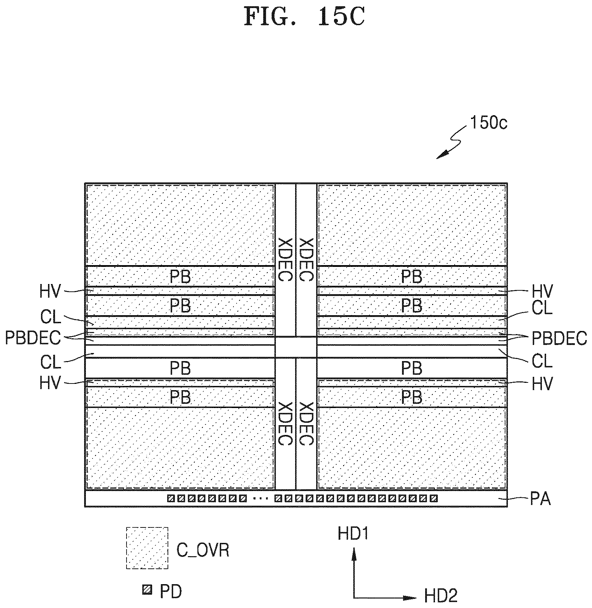

FIG. 15C is a diagram illustrating a memory device 150c according to the disclosure.

Referring to FIG. 15C, the memory device 150c corresponds to a modification of the memory device 150a of FIG. 15A, and may include both a structure corresponding to the second semiconductor layer 142a of FIG. 14A and a structure corresponding to the second semiconductor layer 142b of FIG. 14B. According to the disclosure, the peripheral circuits corresponding to each of first and second memory cell arrays (e.g., MCA1 and MCA2 of FIG. 12A), for example, the page buffers PB, the high-voltage unit HV, the C-LATCH CL, and the page buffer decoder PBDEC may be completely buried by the cell overlap region C_OVR, and the peripheral circuits corresponding to each of third and fourth memory cell arrays (e.g., MCA3 and MCA4 of FIG. 12A), for example, the page buffers PB and the high-voltage unit HV may be partially buried by the cell overlap region C_OVR.

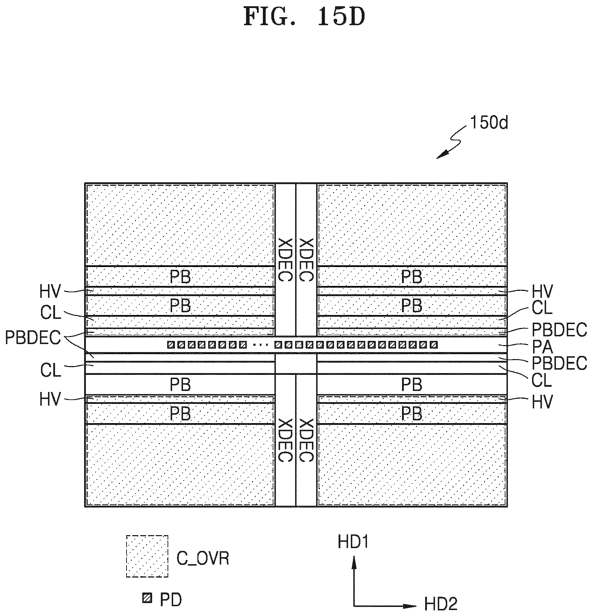

FIG. 15D is a diagram illustrating a memory device 150d according to the disclosure.

Referring to FIG. 15D, the memory device 150d corresponds to a modification of the memory device 150b of FIG. 15B, and may include both a structure corresponding to the second semiconductor layer 142a of FIG. 14A and a structure corresponding to the second semiconductor layer 142b of FIG. 14B. According to the disclosure, the peripheral circuits corresponding to each of the first and second memory cell arrays MCA1 and MCA2, for example, the page buffers PB, the high-voltage unit HV, the C-LATCH CL, and the page buffer decoder PBDEC may be completely buried by the cell overlap region C_OVR, and the peripheral circuits corresponding to each of the third and fourth memory cell arrays MCA3 and MCA4, for example, the page buffers PB and the high-voltage unit HV may be partially buried by the cell overlap region C_OVR.

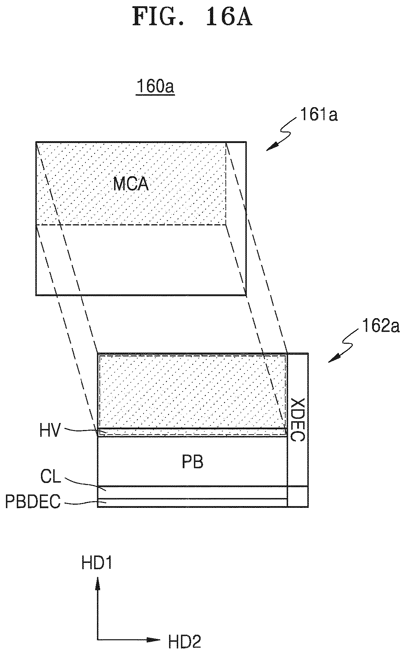

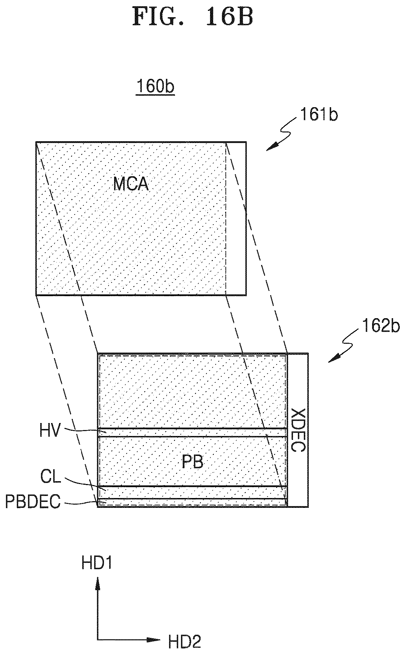

FIGS. 16A and 16B are diagrams illustrating memory devices 160a and 160b, respectively, according to the disclosure.

Referring to FIG. 16A, the memory device 160a may include a first semiconductor layer 161a and a second semiconductor layer 162a, the first semiconductor layer 161a may include the memory cell array MCA, and the second semiconductor layer 162a may include the page buffers PB, the high-voltage unit HV, the C-LATCH CL, the page buffer decoder PBDEC, and the row decoder XDEC. For example, the size of a cell region in which the memory cell array MCA is arranged in the first semiconductor layer 161a may be smaller than the size of the cell region of FIG. 14A, but the present disclosure is not limited thereto. According to the disclosure, the memory cell array MCA may be on and overlap the high-voltage unit HV. As such, a portion of the page buffer circuit, for example, and the high-voltage unit HV may be buried by the memory cell array MCA, and the remaining portions of the page buffer circuit, for example, the page buffer PB, the C-LATCH CL, the page buffer decoder PBDEC, and the row decoder XDEC may not be buried by the memory cell array MCA.

Referring to FIG. 16B, the memory device 160b may include a first semiconductor layer 161b and a second semiconductor layer 162b, and may correspond to a modification of the memory device 160a of FIG. 16A. The memory device 160a of FIG. 16A may be implemented to be partially buried, whereas the memory device 160b according to the disclosure may be implemented to be completely buried. The memory cell array MCA may be on and overlap the page buffers PB, the high-voltage unit HV, the C-LATCH CL, and the page buffer decoder PBDEC. As such, the entire page buffer circuit may be buried by the memory cell array MCA. The row decoder XDEC may not be buried by the memory cell array MCA, but the present disclosure is not limited thereto, and according to the disclosure, the row decoder XDEC may also be buried by the memory cell array MCA.

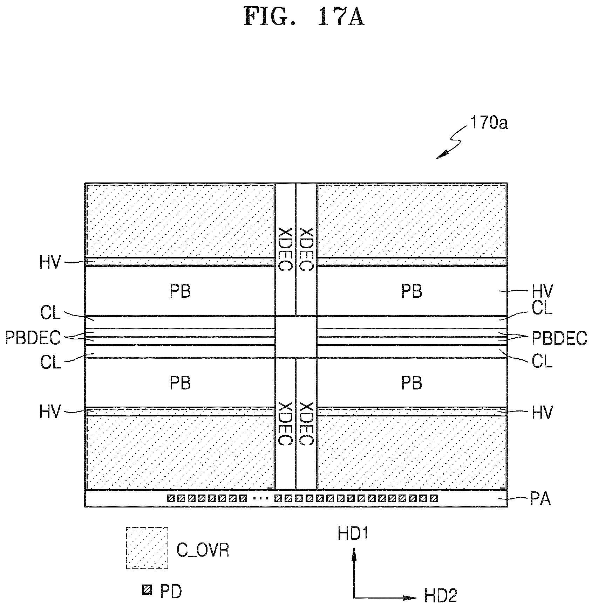

According to the disclosure, when a memory device includes a plurality of memory cell arrays, some memory cell arrays and corresponding peripheral circuits may be arranged as illustrated in FIG. 16A, and the remaining memory cell arrays and corresponding peripheral circuits may be arranged as illustrated in FIG. 16B. However, the present disclosure is not limited thereto, and according to the disclosure, when the memory device includes a plurality of memory cell arrays, the plurality of memory cell arrays and corresponding peripheral circuits may be arranged as illustrated in FIG. 16A or 16B. These various embodiments are described with reference to FIGS. 17A to 17D.

FIG. 17A is a diagram illustrating a memory device 170a according to the disclosure.

Referring to FIG. 17A, the memory device 170a may have a structure corresponding to the second semiconductor layer 162a of FIG. 16A. For example, the memory device 170a may include the page buffers PB, the high-voltage unit HV, the C-LATCH CL, the page buffer decoder PBDEC, and the row decoder XDEC, which correspond to each of a plurality of memory cell arrays, and a portion of a page buffer circuit, for example, the high-voltage unit HV may be buried by the cell overlap region C_OVR, that is, may overlap the cell overlap region C_OVR in the vertical direction. According to the disclosure, the remaining portion of the page buffer circuit, for example, the page buffer PB, the C-LATCH CL, and the page buffer decoder PBDEC, and the row decoder XDEC may not be buried by the cell overlap region C_OVR, that is, may not overlap the cell overlap region C_OVR in the vertical direction. In this case, the memory device 170a may further include the pad region PA arranged in an edge region, and the pad region PA may include the plurality of bonding pads PD arranged in the second horizontal direction HD2. In this case, the pad region PA may not be buried by cell overlap regions C_OVR, that is, may not overlap the cell overlap regions C_OVR in the vertical direction.

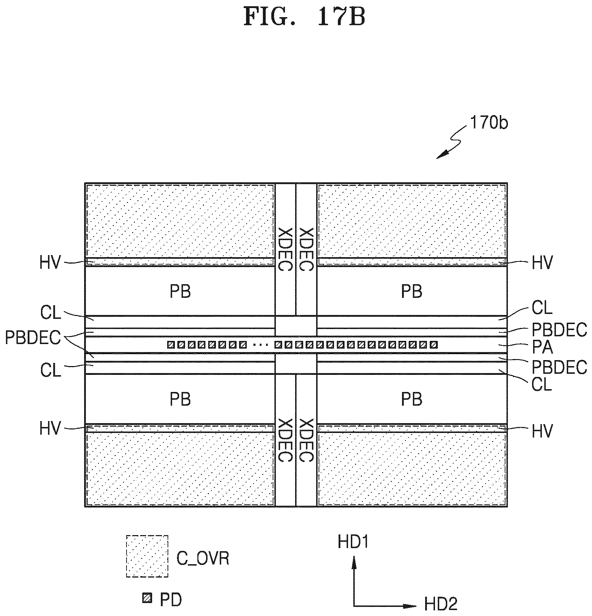

FIG. 17B is a diagram illustrating a memory device 170b according to the disclosure.

Referring to FIG. 17B, the memory device 170b may have a structure corresponding to the second semiconductor layer 162a of FIG. 16A. Alternatively or additionally, the memory device 170b may correspond to a modification of the memory device 170a of FIG. 17A, and the descriptions thereof provided above will be omitted. The memory device 170b may further include the pad region PA arranged in a center region, and the pad region PA may include the plurality of bonding pads PD arranged in the second horizontal direction HD2. In this case, the pad region PA may not be buried by cell overlap regions C_OVR, that is, may not overlap the cell overlap regions C_OVR in the vertical direction.

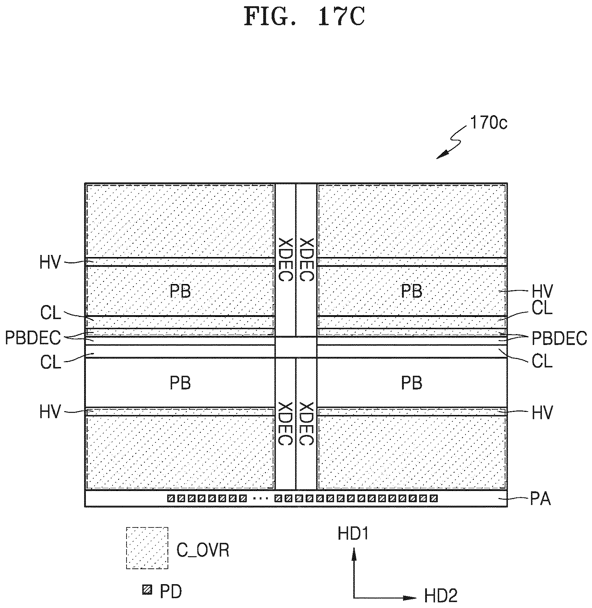

FIG. 17C is a diagram illustrating a memory device 170c according to the disclosure.

Referring to FIG. 17C, the memory device 170c corresponds to a modification of the memory device 170a of FIG. 17A, and may include both a structure corresponding to the second semiconductor layer 162a of FIG. 16A and a structure corresponding to the second semiconductor layer 162b of FIG. 16B. According to the disclosure, the peripheral circuits corresponding to each of first and second memory cell arrays (e.g., MCA1 and MCA2 of FIG. 12A), for example, the page buffers PB, the high-voltage unit HV, the C-LATCH CL, and the page buffer decoder PBDEC may be completely buried by the cell overlap region C_OVR, and the peripheral circuits corresponding to each of third and fourth memory cell arrays (e.g., MCA3 and MCA4 of FIG. 12A), for example, the high-voltage unit HV may be partially buried by the cell overlap region C_OVR.

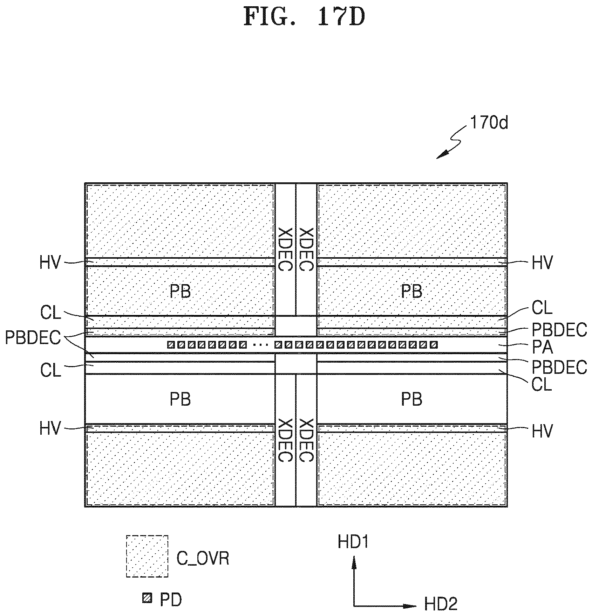

FIG. 17D is a diagram illustrating a memory device 170d according to the disclosure.

Referring to FIG. 17D, the memory device 170d corresponds to a modification of the memory device 170b of FIG. 17B, and may include both a structure corresponding to the second semiconductor layer 162a of FIG. 16A and a structure corresponding to the second semiconductor layer 162b of FIG. 16B. According to the disclosure, the peripheral circuits corresponding to each of the first and second memory cell arrays MCA1 and MCA2, for example, the page buffers PB, the high-voltage unit HV, the C-LATCH CL, and the page buffer decoder PBDEC may be completely buried by the cell overlap region C_OVR, and the peripheral circuits corresponding to each of the third and fourth memory cell arrays MCA3 and MCA4, for example, the high-voltage unit HV may be partially buried by the cell overlap region C_OVR.

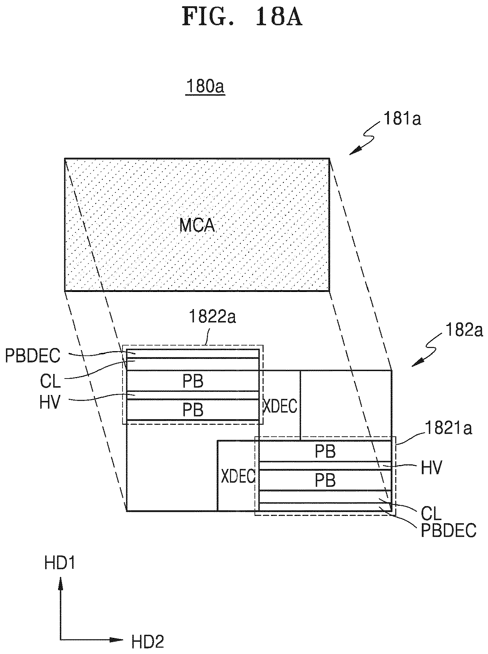

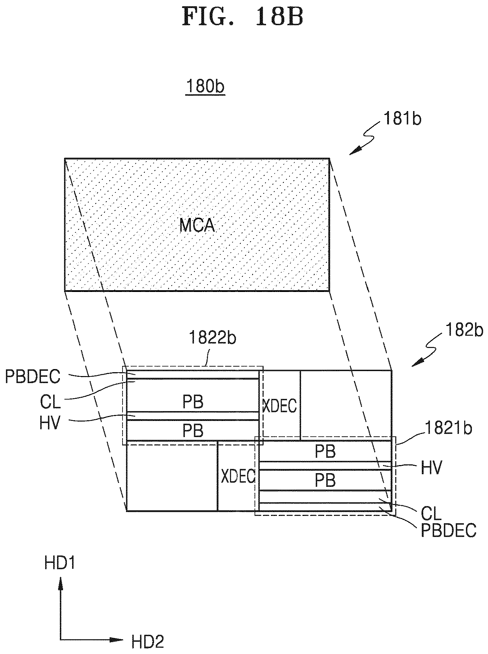

FIGS. 18A and 18B are diagrams illustrating memory devices 180a and 180b, respectively, according to the disclosure.

Referring to FIG. 18A, the memory device 180a may include a first semiconductor layer 181a and a second semiconductor layer 182a, the first semiconductor layer 181a may include the memory cell array MCA, and the second semiconductor layer 182a may include first and second page buffer circuits 1821a and 1822a and the row decoders XDEC. Each of the first and second page buffer circuits 1821a and 1822a may include the page buffers PB, the high-voltage unit HV, the C-LATCH CL, and the page buffer decoder PBDEC. In this case, the page buffers PB, the high-voltage unit HV, the C-LATCH CL, and the page buffer decoder PBDEC included in the first page buffer circuit 1821a may be buried by the memory cell array MCA, some of elements included in the second page buffer circuit 1822a may be buried by the memory cell array MCA, and the other elements may not be buried by the memory cell array MCA. For example, the page buffers PB and the high-voltage unit HV included in the second page buffer circuit 1822a may be buried by the memory cell array MCA, and the C-LATCH CL and the page buffer decoder PBDEC included in the second page buffer circuit 1822a may not be buried by the memory cell array MCA. In this case, the row decoders XDEC may be buried by the memory cell array MCA. For example, the row decoders XDEC may differ in size in the first horizontal direction HD1 from each other, but the present disclosure is not limited thereto.

Referring to FIG. 18B, the memory device 180b may include a first semiconductor layer 181b and a second semiconductor layer 182b, and the second semiconductor layer 182b may include first and second page buffer circuits 1821b and 1822b and the row decoders XDEC, and may correspond to a modification of the memory device 180a of FIG. 18A. The memory device 180a of FIG. 18A may be implemented to be partially buried, whereas the memory device 180b according to the disclosure may be implemented to be completely buried. The memory cell array MCA may be on and overlap the page buffers PB, the high-voltage unit HV, the C-LATCH CL, the page buffer decoder PBDEC, and the row decoders XDEC. As such, both the page buffer circuit and the row decoders XDEC may be buried by the memory cell array MCA.

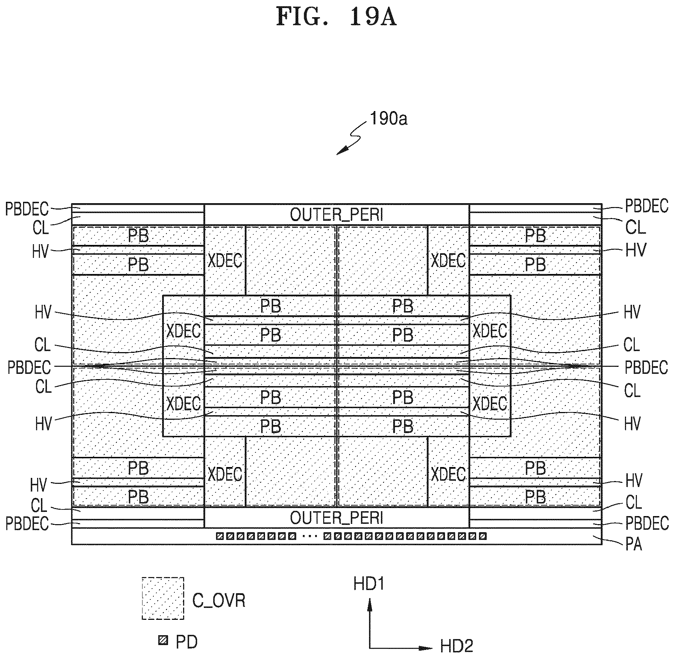

According to the disclosure, when a memory device includes a plurality of memory cell arrays, some memory cell arrays and corresponding peripheral circuits may be arranged as illustrated in FIG. 18A, and the remaining memory cell arrays and corresponding peripheral circuits may be arranged as illustrated in FIG. 18B. However, the present disclosure is not limited thereto, and according to the disclosure, when the memory device includes a plurality of memory cell arrays, the plurality of memory cell arrays and corresponding peripheral circuits may be arranged as illustrated in FIG. 18A or 18B. These various embodiments are described with reference to FIGS. 19A to 19D.

FIG. 19A is a diagram illustrating a memory device 190a according to the disclosure.

Referring to FIG. 19A, the memory device 190a may have a structure corresponding to the second semiconductor layer 182a of FIG. 18A. For example, the memory device 190a may include the page buffers PB, the high-voltage unit HV, the C-LATCH CL, the page buffer decoder PBDEC, and the row decoders XDEC, which correspond to each of a plurality of memory cell arrays, and a first page buffer circuit (e.g., 1821a of FIG. 18A), a portion of a second page buffer circuit (e.g., 1822a of FIG. 18A), for example, the page buffers PB and the high-voltage unit HV, and the row decoders XDEC may be buried by the cell overlap region C_OVR, that is, may overlap the cell overlap region C_OVR in the vertical direction.

According to the disclosure, the remaining portion of the second page buffer circuit (e.g., 1822a of FIG. 18A), for example, the C-LATCH CL and the page buffer decoder PBDEC, may be arranged in an edge region and thus may not be buried by the cell overlap region C_OVR, that is, may not overlap the cell overlap region C_OVR in the vertical direction. Alternatively or additionally, the memory device 190a may further include an external peripheral circuit OUTER_PERI arranged in an edge region, for example, an input/output circuit (e.g., a data input/output buffer, etc.), and the external peripheral circuit OUTER_PERI may not be buried by the cell overlap region C_OVR, that is, may not overlap the cell overlap region C_OVR in the vertical direction. Furthermore, the memory device 190a may further include the pad region PA arranged in an edge region, and the pad region PA may include the plurality of bonding pads PD arranged in the second horizontal direction HD2. In this case, the pad region PA may not be buried by cell overlap regions C_OVR, that is, may not overlap the cell overlap regions C_OVR in the vertical direction.

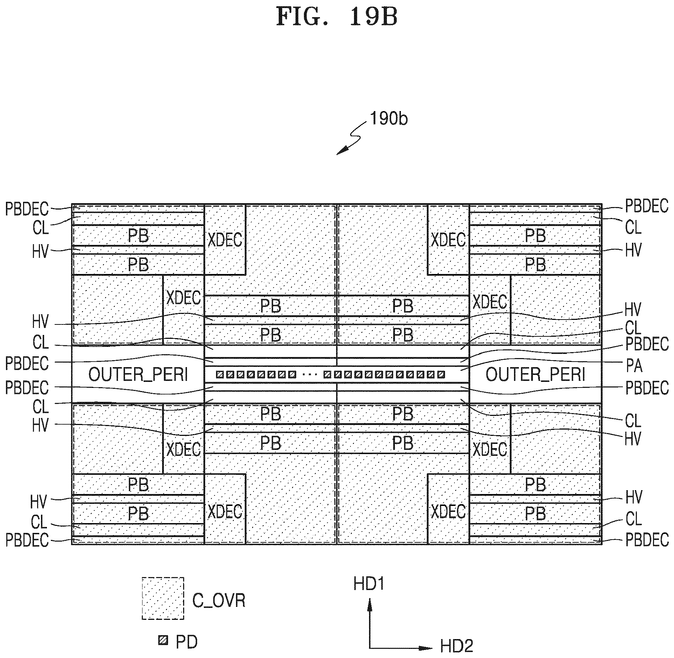

FIG. 19B is a diagram illustrating a memory device 190b according to the disclosure.

Referring to FIG. 19B, the memory device 190b may have a structure corresponding to the second semiconductor layer 182a of FIG. 18A. Also, the memory device 190b may correspond to a modification of the memory device 190a of FIG. 19A, and the descriptions thereof provided above will be omitted. A first page buffer circuit (e.g., 1821a of FIG. 18A), a portion of a second page buffer circuit (e.g., 1822a of FIG. 18A), for example, the page buffers PB and the high-voltage unit HV, and the row decoders XDEC may be buried by the cell overlap region C_OVR, that is, may overlap the cell overlap region C_OVR in the vertical direction. The remaining portion of the second page buffer circuit (e.g., 1822a of FIG. 18A), for example, the C-LATCH CL and the page buffer decoder PBDEC, may be arranged in a center region and thus may not be buried by the cell overlap region C_OVR, that is, may not overlap the cell overlap region C_OVR in the vertical direction.

The memory device 190b may further include the external peripheral circuit OUTER_PERI arranged in a center region, for example, an input/output circuit (e.g., a data input/output buffer, etc.), and the external peripheral circuit OUTER_PERI may not be buried by the cell overlap region C_OVR, that is, may not overlap the cell overlap region C_OVR in the vertical direction. Also, the memory device 190b may further include the pad region PA arranged in a center region, and the pad region PA may include the plurality of bonding pads PD arranged in the second horizontal direction HD2. In this case, the pad region PA may not be buried by cell overlap regions C_OVR, that is, may not overlap the cell overlap regions C_OVR in the vertical direction.

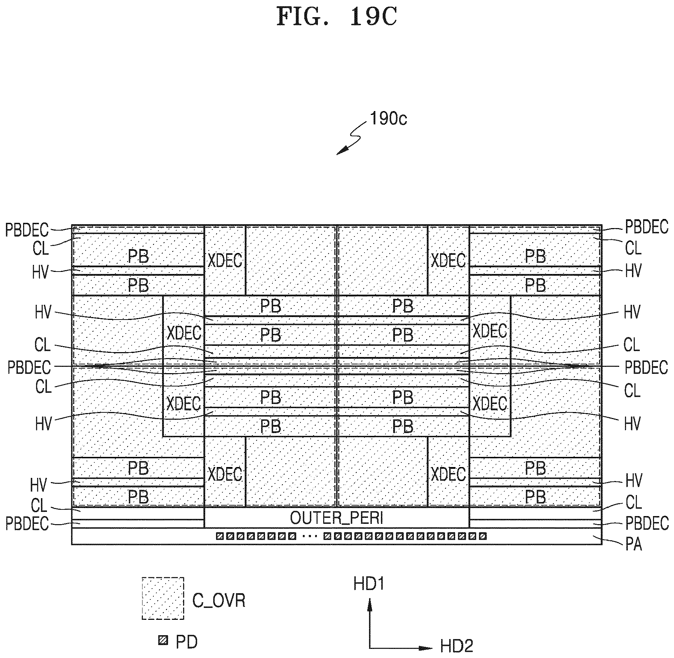

FIG. 19C is a diagram illustrating a memory device 190c according to the disclosure.

Referring to FIG. 19C, the memory device 190c corresponds to a modification of the memory device 190a of FIG. 19A, and may include both a structure corresponding to the second semiconductor layer 182a of FIG. 18A and a structure corresponding to the second semiconductor layer 182b of FIG. 18B. According to the disclosure, the peripheral circuits corresponding to each of first and second memory cell arrays (e.g., MCA1 and MCA2 of FIG. 12A), for example, the page buffers PB, the high-voltage unit HV, the C-LATCH CL, the page buffer decoder PBDEC, and the row decoders XDEC may be completely buried by the cell overlap region C_OVR, and the peripheral circuits corresponding to each of third and fourth memory cell arrays (e.g., MCA3 and MCA4 of FIG. 12A) may be partially buried by the cell overlap region C_OVR.

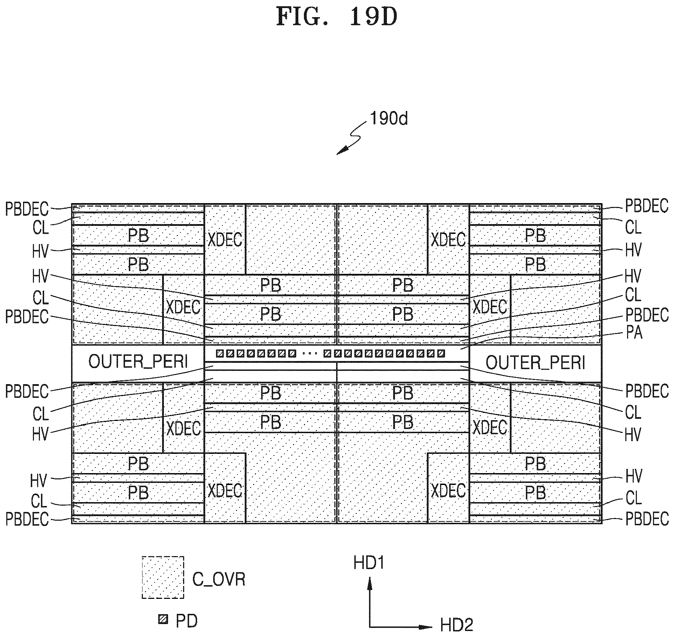

FIG. 19D is a diagram illustrating a memory device 190d according to the disclosure.

Referring to FIG. 19D, the memory device 190d corresponds to a modification of the memory device 190b of FIG. 19B, and may include both a structure corresponding to the second semiconductor layer 182a of FIG. 18A and a structure corresponding to the second semiconductor layer 182b of FIG. 18B. According to the disclosure, the peripheral circuits corresponding to each of the first and second memory cell arrays MCA1 and MCA2, for example, the page buffers PB, the high-voltage unit HV, the C-LATCH CL, the page buffer decoder PBDEC, and the row decoders XDEC may be completely buried by the cell overlap region C_OVR, and the peripheral circuits corresponding to each of the third and fourth memory cell arrays MCA3 and MCA4 may be partially buried by the cell overlap region C_OVR.

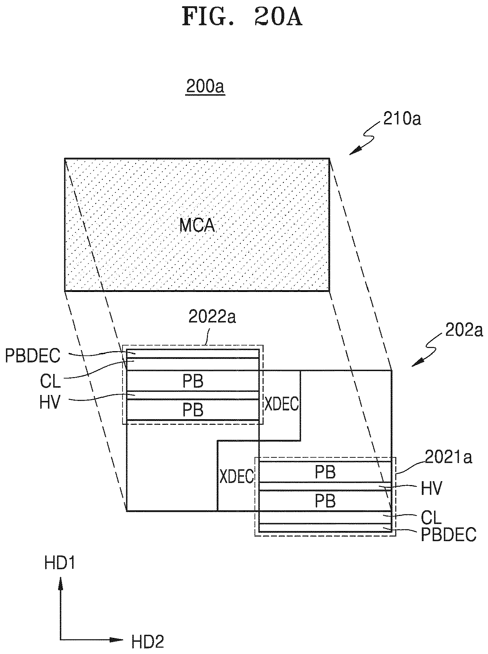

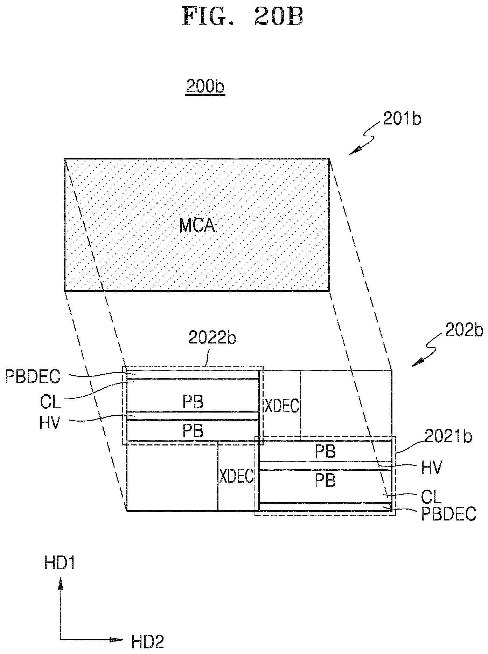

FIGS. 20A and 20B are diagrams illustrating memory devices 200a and 200b, respectively, according to the disclosure.

Referring to FIG. 20A, the memory device 200a may include a first semiconductor layer 201a and a second semiconductor layer 202a, the first semiconductor layer 201a may include the memory cell array MCA, and the second semiconductor layer 202a may include first and second page buffer circuits 2021a and 2022a and the row decoders XDEC. Each of the first and second page buffer circuits 2021a and 2022a may include the page buffers PB, the high-voltage unit HV, the C-LATCH CL, and the page buffer decoder PBDEC. Some of elements included in the first page buffer circuit 2021a may be buried by the memory cell array MCA, and the other elements may not be buried by the memory cell array MCA. For example, the page buffers PB and the high-voltage unit HV included in the first page buffer circuit 2021a may be buried by the memory cell array MCA, and the C-LATCH CL and the page buffer decoder PBDEC included in the first page buffer circuit 2021a may not be buried by the memory cell array MCA.

According to the disclosure, some of elements included in the second page buffer circuit 2022a may be buried by the memory cell array MCA, and the other elements may not be buried by the memory cell array MCA. For example, the page buffers PB and the high-voltage unit HV included in the second page buffer circuit 2022a may be buried by the memory cell array MCA, and the C-LATCH CL and the page buffer decoder PBDEC included in the second page buffer circuit 2022a may not be buried by the memory cell array MCA. In this case, the row decoders XDEC may be buried by the memory cell array MCA.

Referring to FIG. 20B, the memory device 200b may include a first semiconductor layer 201b and a second semiconductor layer 202b, and the second semiconductor layer 202b may include first and second page buffer circuits 2021b and 2022b and the row decoders XDEC, and may correspond to a modification of the memory device 200a of FIG. 20A. The memory device 200a of FIG. 20A may be implemented to be partially buried, whereas the memory device 200b according to the disclosure may be implemented to be completely buried. The memory cell array MCA may be on and overlap the page buffers PB, the high-voltage unit HV, the C-LATCH CL, the page buffer decoder PBDEC, and the row decoders XDEC. As such, both the page buffer circuit and the row decoders XDEC may be buried by the memory cell array MCA.

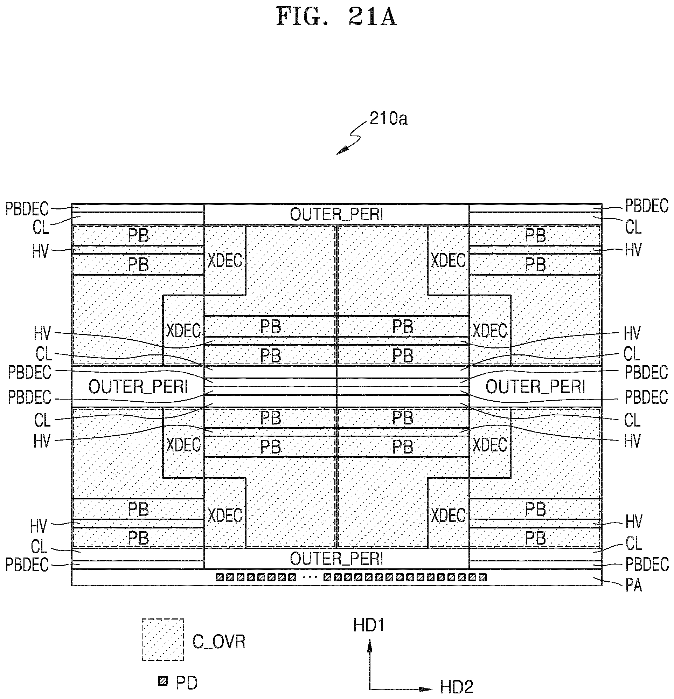

According to the disclosure, when a memory device includes a plurality of memory cell arrays, some memory cell arrays and corresponding peripheral circuits may be arranged as illustrated in FIG. 20A, and the remaining memory cell arrays and corresponding peripheral circuits may be arranged as illustrated in FIG. 20B. However, the present disclosure is not limited thereto, and according to the disclosure, when the memory device includes a plurality of memory cell arrays, the plurality of memory cell arrays and corresponding peripheral circuits may be arranged as illustrated in FIG. 20A or 20B. These various embodiments are described with reference to FIGS. 21A to 21D.

FIG. 21A is a diagram illustrating a memory device 210a according to the disclosure.

Referring to FIG. 21A, the memory device 210a may have a structure corresponding to the second semiconductor layer 202a of FIG. 20A. For example, the memory device 210a may include the page buffers PB, the high-voltage unit HV, the C-LATCH CL, the page buffer decoder PBDEC, and the row decoders XDEC, which correspond to each of a plurality of memory cell arrays, and a portion of each of first and second page buffer circuits (e.g., 2021a and 2022a of FIG. 20A), for example, the page buffers PB and the high-voltage unit HV, and the row decoders XDEC may be buried by the cell overlap region C_OVR, that is, may overlap the cell overlap region C_OVR in the vertical direction. According to the disclosure, the remaining portion of each of the first and second page buffer circuits (e.g., 2021a and 2022a of FIG. 20A), for example, the C-LATCH CL and the page buffer decoder PBDEC, may be arranged in an edge region or a center region, and may not be buried by the cell overlap region C_OVR, that is, may not overlap the cell overlap region C_OVR in the vertical direction.

Alternatively or additionally, the memory device 210a may further include the external peripheral circuit OUTER_PERI arranged in an edge region or a center region, for example, an input/output circuit (e.g., a data input/output buffer, etc.), and the external peripheral circuit OUTER_PERI may not be buried by the cell overlap region C_OVR, that is, may not overlap the cell overlap region C_OVR in the vertical direction. Furthermore, the memory device 210a may further include the pad region PA arranged in an edge region, and the pad region PA may include the plurality of bonding pads PD arranged in the second horizontal direction HD2. In this case, the pad region PA may not be buried by cell overlap regions C_OVR, that is, may not overlap the cell overlap regions C_OVR in the vertical direction.

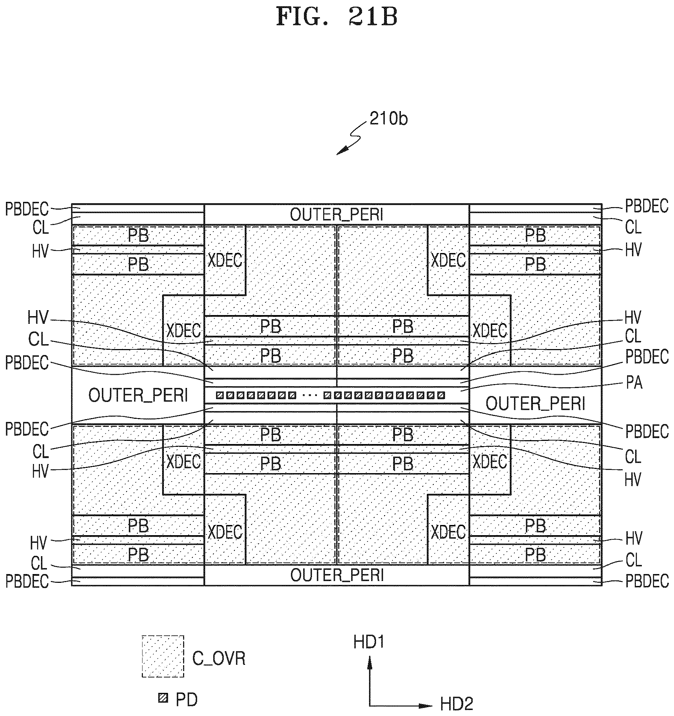

FIG. 21B is a diagram illustrating a memory device 210b according to the disclosure.

Referring to FIG. 21B, the memory device 210b may have a structure corresponding to the second semiconductor layer 202a of FIG. 20A. Also, the memory device 210b may correspond to a modification of the memory device 210a of FIG. 21A, and the descriptions thereof provided above will be omitted. The memory device 210b may further include the pad region PA arranged in a center region, and the pad region PA may include the plurality of bonding pads PD arranged in the second horizontal direction HD2. In this case, the pad region PA may not be buried by cell overlap regions C_OVR, that is, may not overlap the cell overlap regions C_OVR in the vertical direction.

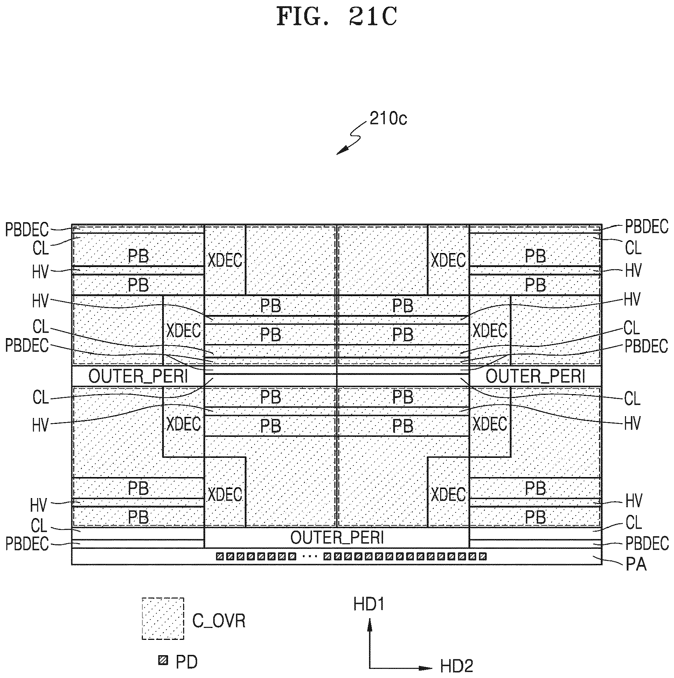

FIG. 21C is a diagram illustrating a memory device 210c according to the disclosure.

Referring to FIG. 21C, the memory device 210c corresponds to a modification of the memory device 210a of FIG. 21A, and may include both a structure corresponding to the second semiconductor layer 202a of FIG. 20A and a structure corresponding to the second semiconductor layer 202b of FIG. 20B. According to the disclosure, the peripheral circuits corresponding to each of first and second memory cell arrays (e.g., MCA1 and MCA2 of FIG. 12A), for example, the page buffers PB, the high-voltage unit HV, the C-LATCH CL, the page buffer decoder PBDEC, and the row decoders XDEC may be completely buried by the cell overlap region C_OVR, and the peripheral circuits corresponding to each of third and fourth memory cell arrays (e.g., MCA3 and MCA4 of FIG. 12A) may be partially buried by the cell overlap region C_OVR.

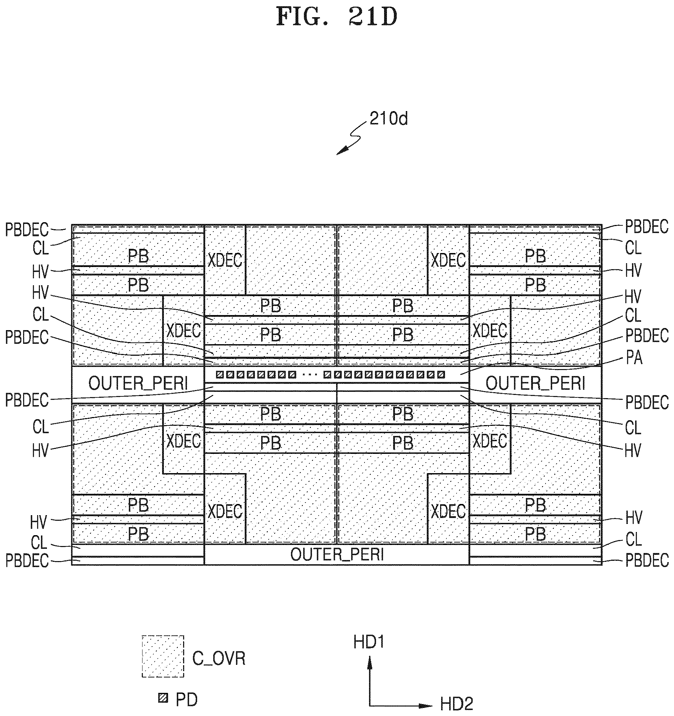

FIG. 21D is a diagram illustrating a memory device 210d according to the disclosure.

Referring to FIG. 21D, the memory device 210d corresponds to a modification of the memory device 210b of FIG. 21B, and may include both a structure corresponding to the second semiconductor layer 202a of FIG. 20A and a structure corresponding to the second semiconductor layer 202b of FIG. 20B. According to the disclosure, the peripheral circuits corresponding to each of the first and second memory cell arrays MCA1 and MCA2, for example, the page buffers PB, the high-voltage unit HV, the C-LATCH CL, the page buffer decoder PBDEC, and the row decoders XDEC may be completely buried by the cell overlap region C_OVR, and the peripheral circuits corresponding to each of the third and fourth memory cell arrays MCA3 and MCA4 may be partially buried by the cell overlap region C_OVR.

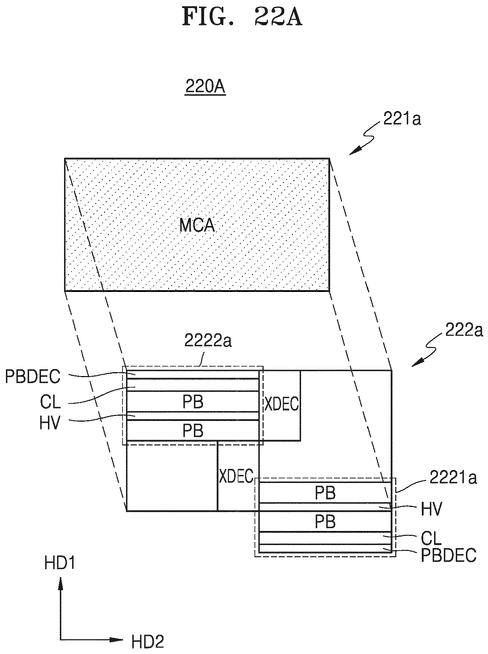

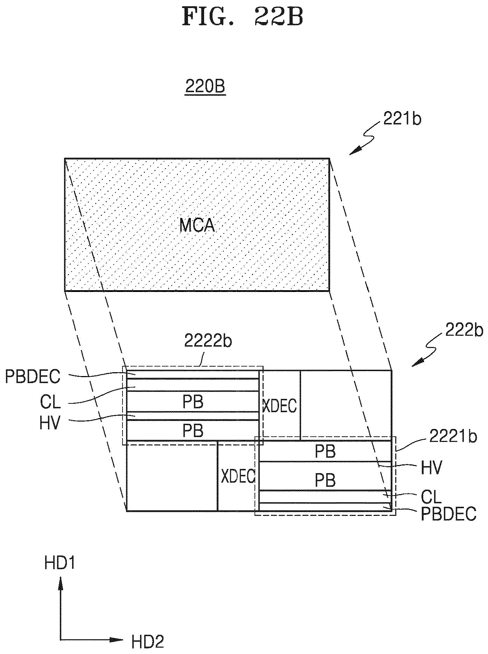

FIGS. 22A and 22B are diagrams illustrating memory devices 220A and 220B, respectively, according to the disclosure.

Referring to FIG. 22A, the memory device 220A may include a first semiconductor layer 221a and a second semiconductor layer 222a, the first semiconductor layer 221a may include the memory cell array MCA, and the second semiconductor layer 222a may include first and second page buffer circuits 2221a and 2222a and the row decoders XDEC. Each of the first and second page buffer circuits 2221a and 2222a may include the page buffers PB, the high-voltage unit HV, the C-LATCH CL, and the page buffer decoder PBDEC. Some of elements included in the first page buffer circuit 2221a may be buried by the memory cell array MCA, and the other elements may not be buried by the memory cell array MCA. For example, one page buffer PB and the high-voltage unit HV included in the first page buffer circuit 2221a may be buried by the memory cell array MCA, and the other page buffer PB, the C-LATCH CL, and the page buffer decoder PBDEC included in the first page buffer circuit 2221a may not be buried by the memory cell array MCA. According to the disclosure, the second page buffer circuit 2222a may be buried by the memory cell array MCA. In this case, the row decoders XDEC may be buried by the memory cell array MCA.

Referring to FIG. 22B, the memory device 220B may include a first semiconductor layer 221b and a second semiconductor layer 222b, and the second semiconductor layer 222b may include first and second page buffer circuits 2221b and 2222b and the row decoders XDEC, and may correspond to a modification of the memory device 220A of FIG. 22A. The memory device 220A of FIG. 22A may be implemented to be partially buried, whereas the memory device 220B according to the disclosure may be implemented to be completely buried. The memory cell array MCA may be on and overlap the page buffers PB, the high-voltage unit HV, the C-LATCH CL, the page buffer decoder PBDEC, and the row decoders XDEC. As such, both the page buffer circuit and the row decoders XDEC may be buried by the memory cell array MCA.

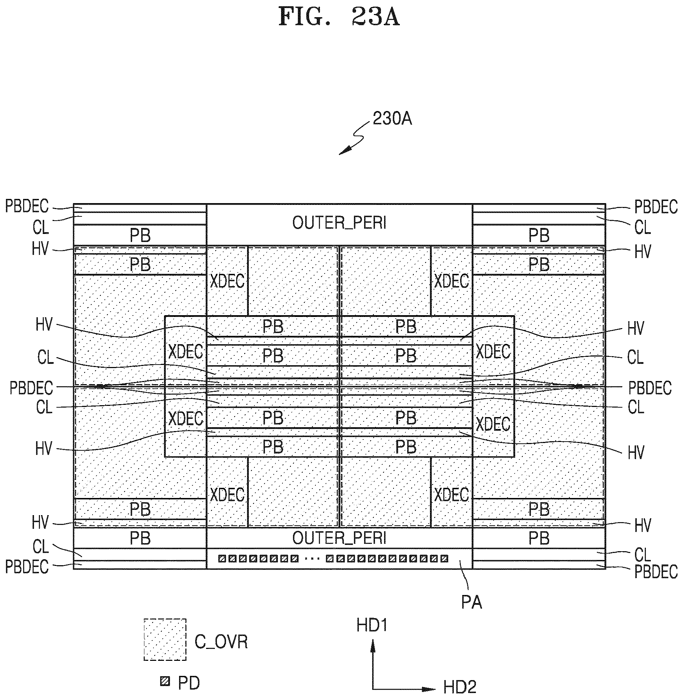

According to the disclosure, when a memory device includes a plurality of memory cell arrays, some memory cell arrays and corresponding peripheral circuits may be arranged as illustrated in FIG. 22A, and the remaining memory cell arrays and corresponding peripheral circuits may be arranged as illustrated in FIG. 22B. However, the present disclosure is not limited thereto, and according to the disclosure, when the memory device includes a plurality of memory cell arrays, the plurality of memory cell arrays and corresponding peripheral circuits may be arranged as illustrated in FIG. 22A or 22B. These various embodiments are described with reference to FIGS. 23A to 23D.

FIG. 23A is a diagram illustrating a memory device 230A according to the disclosure.

Referring to FIG. 23A, the memory device 230A may have a structure corresponding to the second semiconductor layer 222a of FIG. 22A. For example, the memory device 230A may include the page buffers PB, the high-voltage unit HV, the C-LATCH CL, the page buffer decoder PBDEC, and the row decoder XDEC, which correspond to each of a plurality of memory cell arrays. A portion of a first page buffer circuit (e.g., 2221a of FIG. 22A), for example, one page buffer PB and the high-voltage unit HV, and the row decoders XDEC may be buried by the cell overlap region C_OVR, that is, may overlap the cell overlap region C_OVR in the vertical direction. The remaining portion of the first page buffer circuit, for example, one page buffer PB, the C-LATCH CL, and the page buffer decoder PBDEC may be arranged in an edge region and thus may not be buried by the cell overlap region C_OVR, that is, may not overlap the cell overlap region C_OVR in the vertical direction. On the other hand, a second page buffer circuit (e.g., 2222a of FIG. 22A) may be arranged in a center region and thus buried by the cell overlap region C_OVR, that is, may overlap the cell overlap region C_OVR in the vertical direction.

Alternatively or additionally, the memory device 230A may further include the external peripheral circuit OUTER_PERI arranged in an edge region, for example, an input/output circuit (e.g., a data input/output buffer, etc.), and the external peripheral circuit OUTER_PERI may not be buried by the cell overlap region C_OVR, that is, may not overlap the cell overlap region C_OVR in the vertical direction. Furthermore, the memory device 230A may further include the pad region PA arranged in an edge region, and the pad region PA may include the plurality of bonding pads PD arranged in the second horizontal direction HD2. In this case, the pad region PA may not be buried by cell overlap regions C_OVR, that is, may not overlap the cell overlap regions C_OVR in the vertical direction.

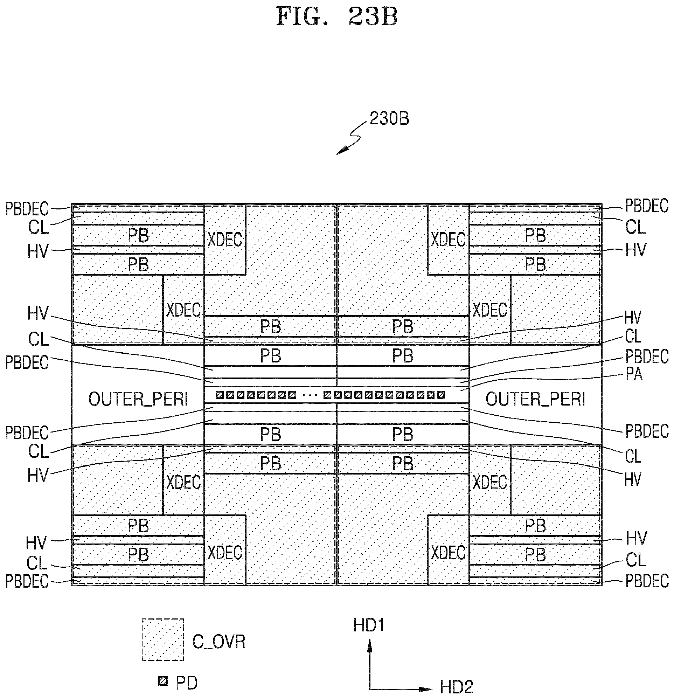

FIG. 23B is a diagram illustrating a memory device 230B according to the disclosure.

Referring to FIG. 23B, the memory device 230B may have a structure corresponding to the second semiconductor layer 222a of FIG. 22A. Also, the memory device 230B may correspond to a modification of the memory device 230A of FIG. 23A, and the descriptions thereof provided above will be omitted. A portion of a first page buffer circuit (e.g., 2221a of FIG. 22A), for example, one page buffer PB and the high-voltage unit HV, and the row decoders XDEC may be buried by the cell overlap region C_OVR, that is, may overlap the cell overlap region C_OVR in the vertical direction. The remaining portion of the first page buffer circuit, for example, one page buffer PB, the C-LATCH CL, and the page buffer decoder PBDEC may be arranged in a center region and thus may not be buried by the cell overlap region C_OVR, that is, may not overlap the cell overlap region C_OVR in the vertical direction. On the other hand, a second page buffer circuit (e.g., 2222a of FIG. 22A) may be arranged in a corner region and thus buried by the cell overlap region C_OVR, that is, may overlap the cell overlap region C_OVR in the vertical direction.

The memory device 230B may further include the external peripheral circuit OUTER_PERI and the pad region PA, which are arranged in a center region. In this case, the external peripheral circuit OUTER_PERI and the pad region PA may not be buried by the cell overlap region C_OVR, that is, may not overlap the cell overlap region C_OVR in the vertical direction.

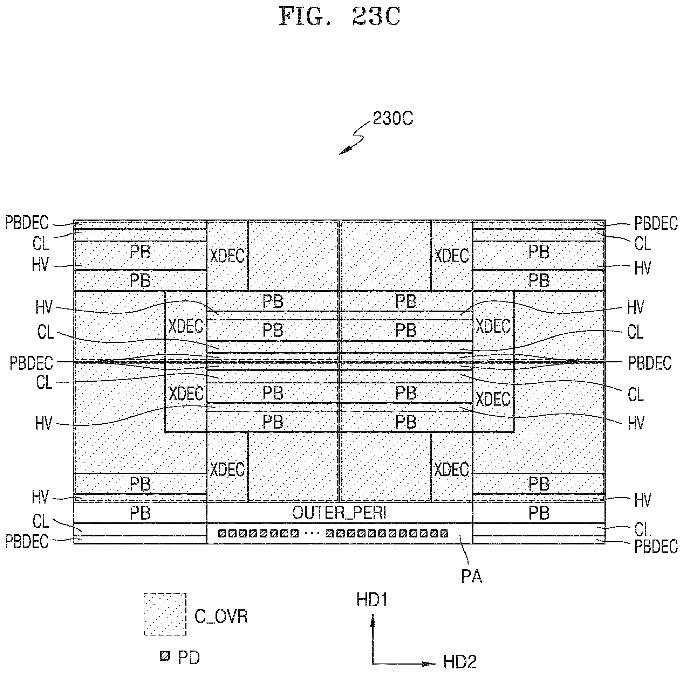

FIG. 23C is a diagram illustrating a memory device 230C according to the disclosure.

Referring to FIG. 23C, the memory device 230C corresponds to a modification of the memory device 230A of FIG. 23A, and may include both a structure corresponding to the second semiconductor layer 222a of FIG. 22A and a structure corresponding to the second semiconductor layer 222b of FIG. 22B. According to the disclosure, the peripheral circuits corresponding to each of first and second memory cell arrays (e.g., MCA1 and MCA2 of FIG. 12A), for example, the page buffers PB, the high-voltage unit HV, the C-LATCH CL, the page buffer decoder PBDEC, and the row decoders XDEC may be completely buried by the cell overlap region C_OVR, and the peripheral circuits corresponding to each of third and fourth memory cell arrays (e.g., MCA3 and MCA4 of FIG. 12A) may be partially buried by the cell overlap region C_OVR.

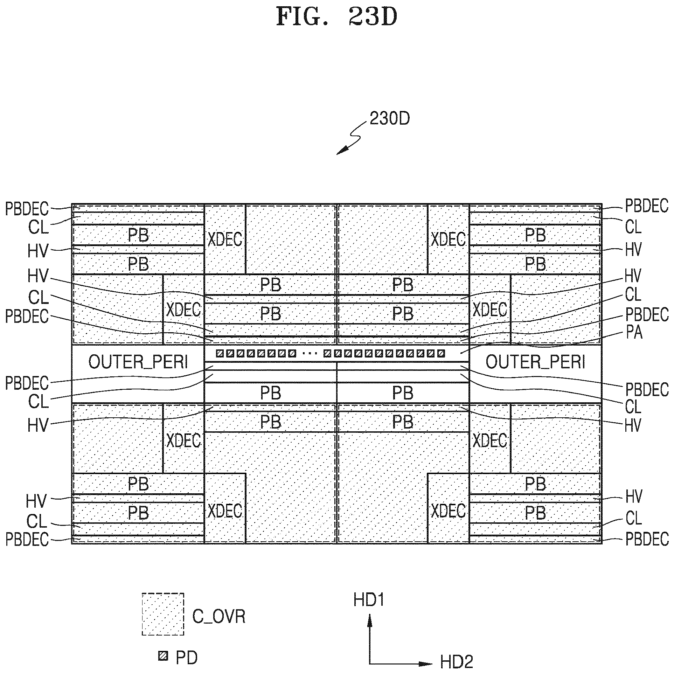

FIG. 23D is a diagram illustrating a memory device 230D according to the disclosure.

Referring to FIG. 23D, the memory device 230D corresponds to a modification of the memory device 230B of FIG. 23B, and may include both a structure corresponding to the second semiconductor layer 222a of FIG. 22A and a structure corresponding to the second semiconductor layer 222b of FIG. 22B. According to the disclosure, the peripheral circuits corresponding to each of the first and second memory cell arrays MCA1 and MCA2, for example, the page buffers PB, the high-voltage unit HV, the C-LATCH CL, the page buffer decoder PBDEC, and the row decoders XDEC may be completely buried by the cell overlap region C_OVR, and the peripheral circuits corresponding to each of the third and fourth memory cell arrays MCA3 and MCA4 may be partially buried by the cell overlap region C_OVR.

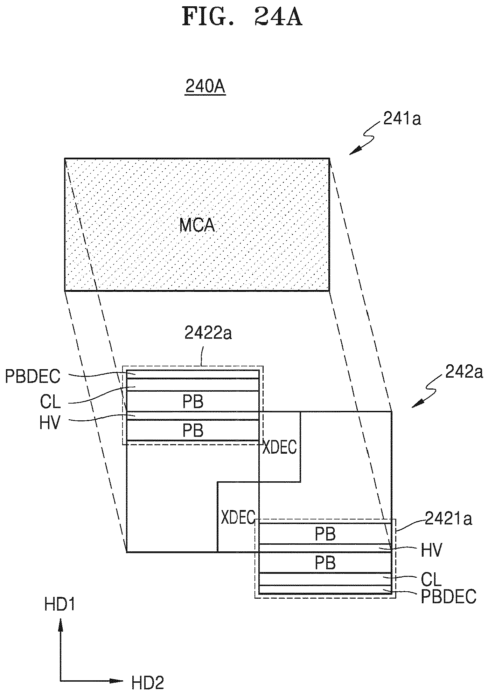

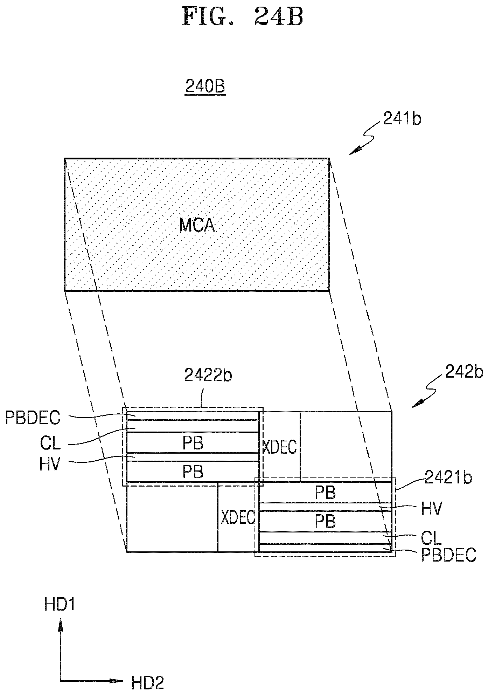

FIGS. 24A and 24B are diagrams illustrating memory devices 240A and 240B, respectively, according to the disclosure.

Referring to FIG. 24A, the memory device 240A may include a first semiconductor layer 241a and a second semiconductor layer 242a, the first semiconductor layer 241a may include the memory cell array MCA, and the second semiconductor layer 242a may include first and second page buffer circuits 2421a and 2422a and the row decoders XDEC. Each of the first and second page buffer circuits 2421a and 2422a may include the page buffers PB, the high-voltage unit HV, the C-LATCH CL, and the page buffer decoder PBDEC. Some of elements included in the first and second page buffer circuits 2421a and 2422a may be buried by the memory cell array MCA, and the other elements may not be buried by the memory cell array MCA. For example, one page buffer PB and the high-voltage unit HV included in each of the first and second page buffer circuits 2421a and 2422a may be buried by the memory cell array MCA, and the other page buffer PB, the C-LATCH CL, and the page buffer decoder PBDEC included in each of the first and second page buffer circuits 2421a and 2422a may not be buried by the memory cell array MCA. In this case, the row decoders XDEC may be buried by the memory cell array MCA.

Referring to FIG. 24B, the memory device 240B may include a first semiconductor layer 241b and a second semiconductor layer 242b, and the second semiconductor layer 242b may include first and second page buffer circuits 2421b and 2422b and the row decoders XDEC, and may correspond to a modification of the memory device 240A of FIG. 24A. The memory device 240A of FIG. 24A may be implemented to be partially buried, whereas the memory device 240B according to the disclosure may be implemented to be completely buried. The memory cell array MCA may be on and overlap the page buffers PB, the high-voltage unit HV, the C-LATCH CL, the page buffer decoder PBDEC, and the row decoders XDEC. As such, the entire page buffer circuit may be buried by the memory cell array MCA.

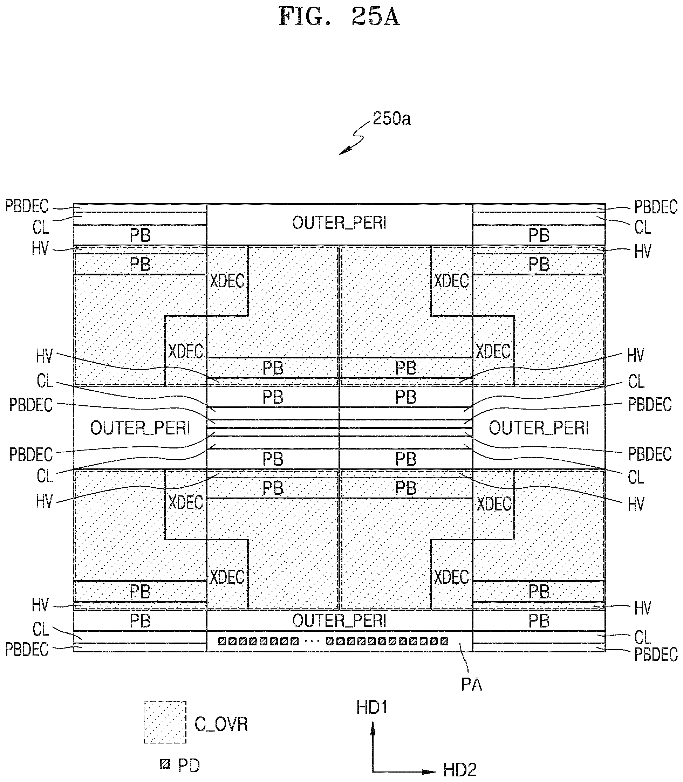

According to the disclosure, when a memory device includes a plurality of memory cell arrays, some memory cell arrays and corresponding peripheral circuits may be arranged as illustrated in FIG. 24A, and the remaining memory cell arrays and corresponding peripheral circuits may be arranged as illustrated in FIG. 24B. However, the present disclosure is not limited thereto, and according to the disclosure, when the memory device includes a plurality of memory cell arrays, the plurality of memory cell arrays and corresponding peripheral circuits may be arranged as illustrated in FIG. 24A or 24B. These various embodiments are described with reference to FIGS. 25A to 25D.

FIG. 25A is a diagram illustrating a memory device 250a according to the disclosure.

Referring to FIG. 25A, the memory device 250a may have a structure corresponding to the second semiconductor layer 242a of FIG. 24A. For example, the memory device 250a may include the page buffers PB, the high-voltage unit HV, the C-LATCH CL, the page buffer decoder PBDEC, and the row decoder XDEC, which correspond to each of a plurality of memory cell arrays. A portion of each of first and second page buffer circuits (e.g., 2421a and 2422a of FIG. 24A), for example, one page buffer PB and the high-voltage unit HV, and the row decoders XDEC may be buried by the cell overlap region C_OVR, that is, may overlap the cell overlap region C_OVR in the vertical direction. The remaining portion of each of the first and second page buffer circuits, for example, one page buffer PB, the C-LATCH CL, and the page buffer decoder PBDEC may be arranged in a center region or an edge region and thus may not be buried by the cell overlap region C_OVR, that is, may not overlap the cell overlap region C_OVR in the vertical direction.

Alternatively or additionally, the memory device 250a may further include the external peripheral circuit OUTER_PERI arranged in a center region or an edge region, for example, an input/output circuit (e.g., a data input/output buffer, etc.), and the external peripheral circuit OUTER_PERI may not be buried by the cell overlap region C_OVR, that is, may not overlap the cell overlap region C_OVR in the vertical direction. Furthermore, the memory device 250a may further include the pad region PA arranged in an edge region, and the pad region PA may include the plurality of bonding pads PD arranged in the second horizontal direction HD2. In this case, the pad region PA may not be buried by cell overlap regions C_OVR, that is, may not overlap the cell overlap regions C_OVR in the vertical direction.

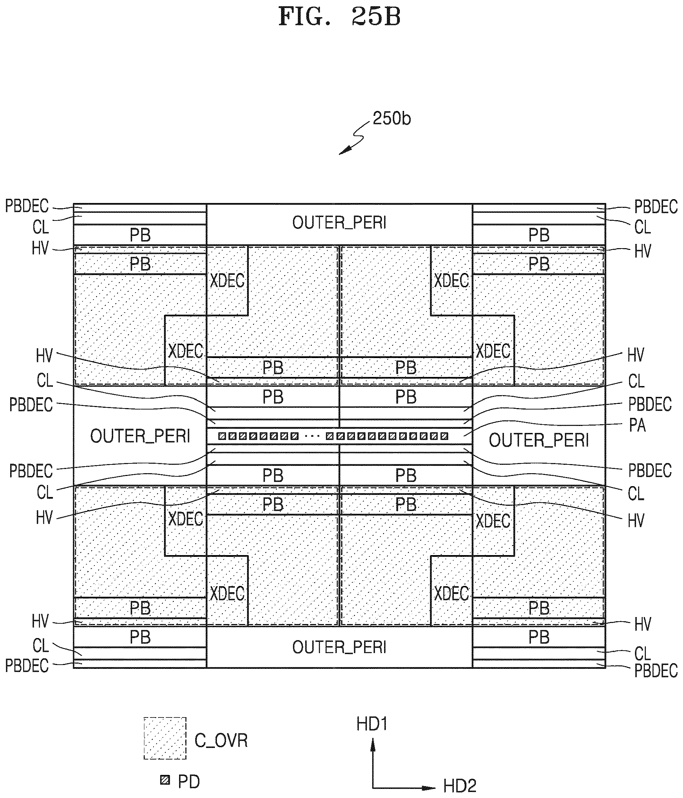

FIG. 25B is a diagram illustrating a memory device 250b according to the disclosure.

Referring to FIG. 25B, the memory device 250b may have a structure corresponding to the second semiconductor layer 242a of FIG. 24A. Also, the memory device 250b may correspond to a modification of the memory device 250a of FIG. 25A, and the descriptions thereof provided above will be omitted. The memory device 250b may further include the external peripheral circuit OUTER_PERI arranged in a center region or an edge region, and the pad region PA arranged in a center region. In this case, the external peripheral circuit OUTER_PERI and the pad region PA may not be buried by the cell overlap region C_OVR, that is, may not overlap the cell overlap region C_OVR in the vertical direction.

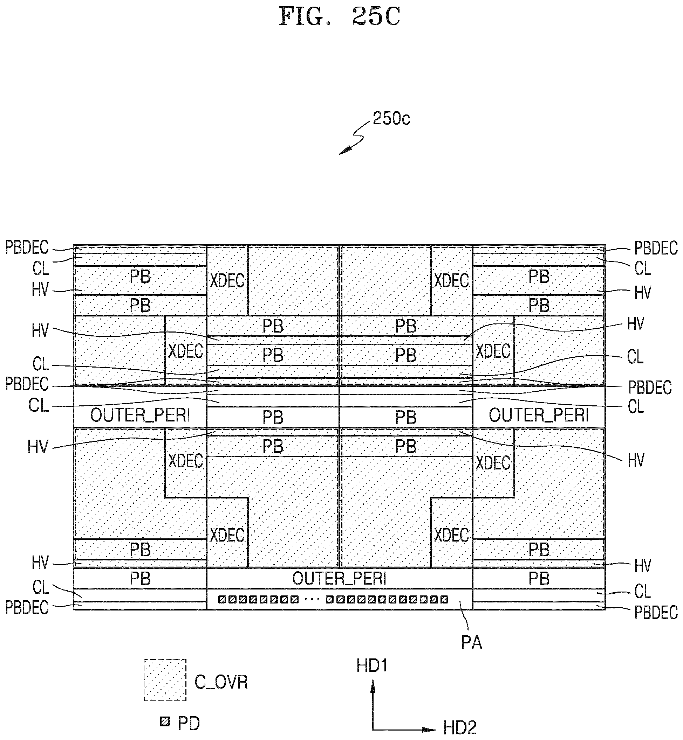

FIG. 25C is a diagram illustrating a memory device 250c according to the disclosure.

Referring to FIG. 25C, the memory device 250c corresponds to a modification of the memory device 250a of FIG. 25A, and may include both a structure corresponding to the second semiconductor layer 242a of FIG. 24A and a structure corresponding to the second semiconductor layer 242b of FIG. 24B. According to the disclosure, the peripheral circuits corresponding to each of first and second memory cell arrays (e.g., MCA1 and MCA2 of FIG. 12A), for example, the page buffers PB, the high-voltage unit HV, the C-LATCH CL, the page buffer decoder PBDEC, and the row decoders XDEC may be completely buried by the cell overlap region C_OVR, and the peripheral circuits corresponding to each of third and fourth memory cell arrays (e.g., MCA3 and MCA4 of FIG. 12A) may be partially buried by the cell overlap region C_OVR.

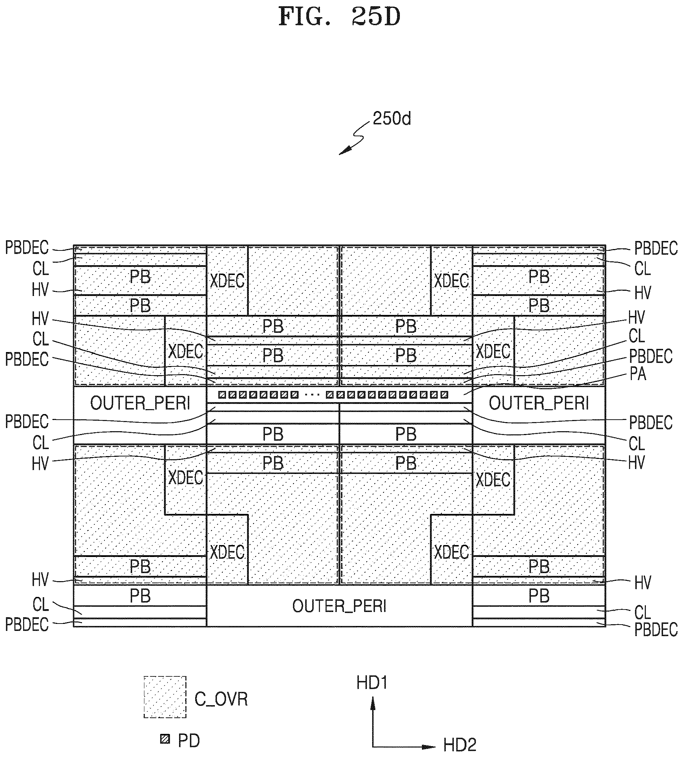

FIG. 25D is a diagram illustrating a memory device 250d according to the disclosure.

Referring to FIG. 25D, the memory device 250d corresponds to a modification of the memory device 250b of FIG. 25B, and may include both a structure corresponding to the second semiconductor layer 242a of FIG. 24A and a structure corresponding to the second semiconductor layer 242b of FIG. 24B. According to the disclosure, the peripheral circuits corresponding to each of the first and second memory cell arrays MCA1 and MCA2, for example, the page buffers PB, the high-voltage unit HV, the C-LATCH CL, the page buffer decoder PBDEC, and the row decoders XDEC may be completely buried by the cell overlap region C_OVR, and the peripheral circuits corresponding to each of the third and fourth memory cell arrays MCA3 and MCA4 may be partially buried by the cell overlap region C_OVR.

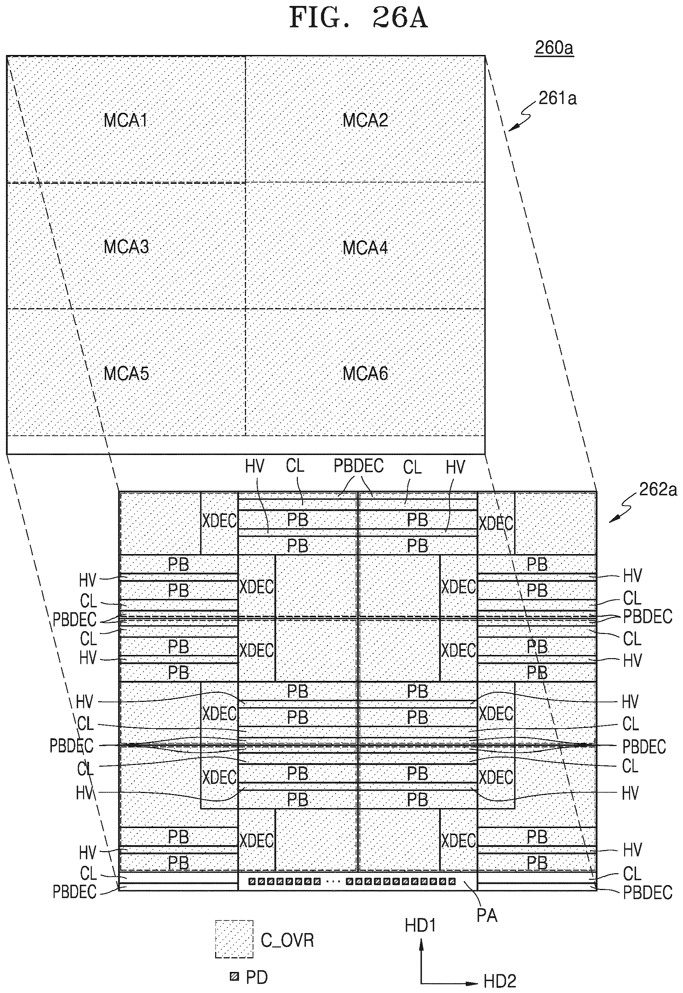

FIG. 26A is a diagram illustrating a memory device 260a according to the disclosure.

Referring to FIG. 26A, the memory device 260a may include a first semiconductor layer 261a and a second semiconductor layer 262a, and first to sixth memory cell arrays MCA1 to MCA6 may be arranged in the first semiconductor layer 261a. The second semiconductor layer 262a may include the page buffers PB, the high-voltage unit HV, the C-LATCH CL, the page buffer decoder PBDEC, and the row decoder XDEC, which correspond to each of the first to sixth memory cell arrays MCA1 to MCA6. As such, the memory device 260a may be implemented in a 6-MAT structure, but the present disclosure is not limited thereto, and the number of memory cell arrays or the number of mats included in the memory device 260a may vary depending on embodiments.

The second semiconductor layer 262a may further include the pad region PA. According to the disclosure, the pad region PA may be arranged in an edge region, a bottom region, or a top region of the second semiconductor layer 262a, and may include the plurality of bonding pads PD arranged in the second horizontal direction HD2. In this case, the pad region PA may not be buried by cell overlap regions C_OVR, that is, may not overlap the cell overlap regions C_OVR in the vertical direction.

According to the disclosure, the first to fourth memory cell arrays MCA1 to MCA4 and the corresponding peripheral circuits may be implemented as illustrated in FIG. 18B, and the fifth and sixth memory cell arrays MCA5 and MCA6 and the corresponding peripheral circuits may be implemented as illustrated in FIG. 18A. For example, the peripheral circuits corresponding to each of the first to fourth memory cell arrays MCA1 to MCA4 may be completely buried, and the peripheral circuits corresponding to each of the fifth and sixth memory cell arrays MCA5 and MCA6 may be partially buried. For example, in the second semiconductor layer 262a, a partial region of the page buffer circuit corresponding to each of the fifth and sixth memory cell arrays MCA5 and MCA6, for example, the C-LATCH CL and the page buffer decoder PBDEC, may not be buried by the cell overlap region C_OVR. For example, the cell overlap regions C_OVR respectively corresponding to the first to sixth memory cell arrays MCA1 to MCA6 may have different sizes.

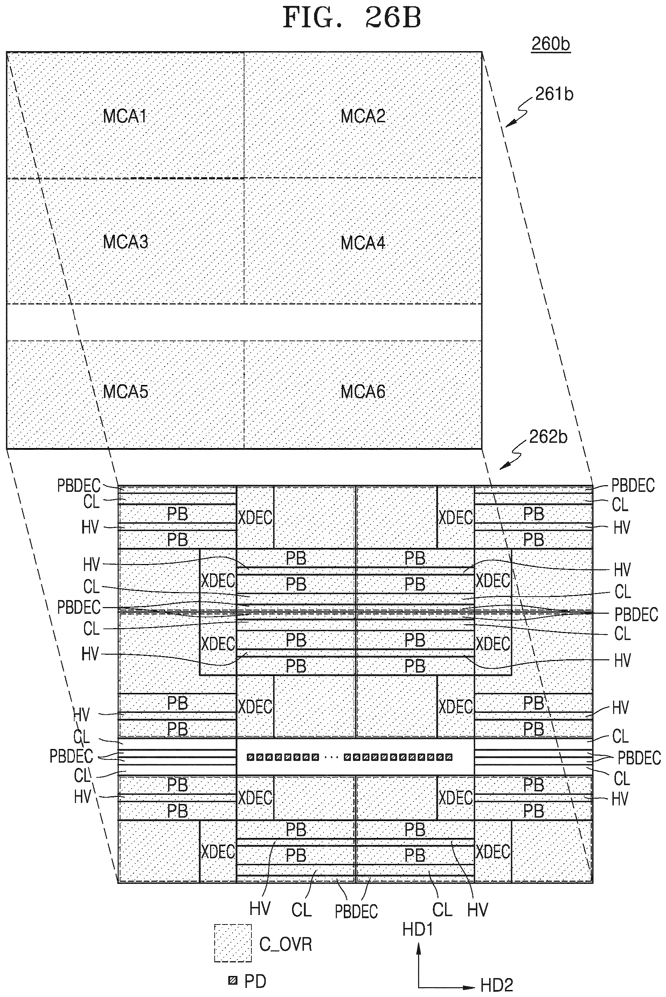

FIG. 26B is a diagram illustrating a memory device 260b according to the disclosure.

Referring to FIG. 26B, the memory device 260b may include a first semiconductor layer 261b and a second semiconductor layer 262b, and may correspond to a modification of the memory device 260a of FIG. 26A. The memory device 260b may further include the pad region PA arranged in a center region, and the pad region PA may include the plurality of bonding pads PD arranged in the second horizontal direction HD2. In this case, the pad region PA may not be buried by cell overlap regions C_OVR, that is, may not overlap the cell overlap regions C_OVR in the vertical direction. According to the disclosure, the first and second memory cell arrays MCA1 and MCA2 and the corresponding peripheral circuits may be implemented as illustrated in FIG. 18B, and the third to sixth memory cell arrays MCA3 to MCA6 and the corresponding peripheral circuits may be implemented as illustrated in FIG. 18A.

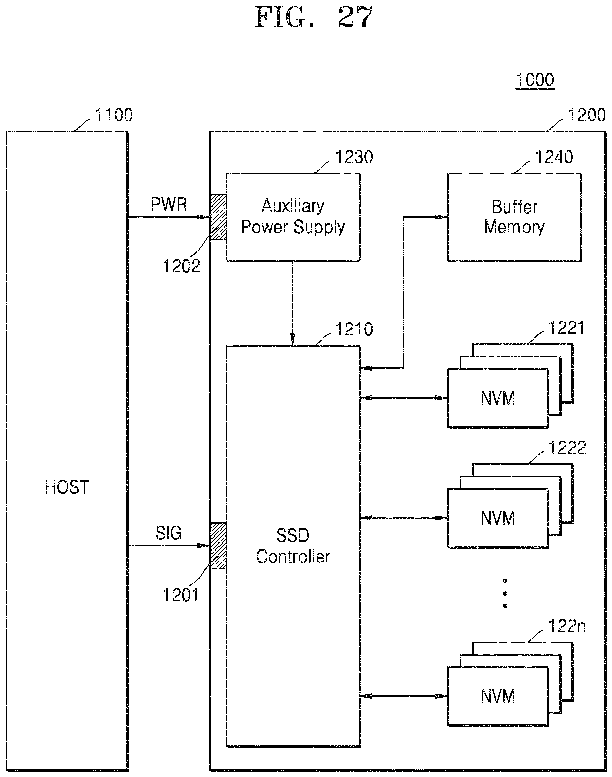

FIG. 27 is a block diagram illustrating a solid-state drive (SSD) system 1000 to which a memory device according to an embodiment.

Referring to FIG. 27, the SSD system 1000 may include a host 1100 and an SSD 1200. The SSD 1200 transmits and receives signals to and from the host 1100 through a signal connector 1201, and receives power through a power connector 1202. The SSD 1200 may include an SSD controller 1210, an auxiliary power supply 1230, and memory devices 1221, 1222, and 122n. The memory devices 1221, 1222, and 122n may be vertically stacked NAND flash memory devices. In this case, the SSD 1200 may be implemented by using the embodiments described above with reference to FIGS. 1 to 26B.

## Claims

1. A non-volatile memory device (120b) comprising:
a first semiconductor layer (121b) that includes:
a first memory cell array (MCA1) including a first plurality of word lines stacked in a vertical direction and a first plurality of memory cells respectively coupled to the first plurality of word lines; and
a second memory cell array (MCA2) including a second plurality of word lines stacked in the vertical direction and a second plurality of memory cells respectively coupled to the second plurality of word lines, wherein the second memory cell array (MCA2) is next to the first memory cell array (MCA1) in a first horizontal direction (HD2);
a third memory cell array (MCA3) including a third plurality of word lines stacked in the vertical direction and a third plurality of memory cells respectively coupled to the third plurality of word lines, wherein the third memory cell array (MCA3) is next to the first memory cell array (MCA1) in a second horizontal direction (HD1), the second horizontal direction (HD1) being orthogonal to the first horizontal direction (HD2);
a fourth memory cell array (MCA4) including a fourth plurality of word lines stacked in the vertical direction and a fourth plurality of memory cells respectively coupled to the fourth plurality of word lines, wherein the fourth memory cell array (MCA2) is next to the second memory cell array (MCA2) in the second horizontal direction (HD1);
a second semiconductor layer (122b) that includes:
a pad region (PA) arranged in a center region of the second semiconductor layer (122b), wherein the pad region (PA) includes a plurality bonding pads (PD) arranged in the second horizontal direction (HD1), and wherein the pad region (PA) extends between the first memory cell array (MCA1) and the third memory cell array (MCA3), and between the second memory cell array (MCA2) and the fourth memory cell array (MCA4), in the second horizontal direction (HD1);
a first peripheral circuit coupled to the first memory cell array (MCA1); and
a second peripheral circuit coupled to the second memory cell array (MCA2),
a third peripheral circuit coupled to the third memory cell array (MCA3);
a fourth peripheral circuit coupled to the fourth memory cell array (MCA4);
wherein the first peripheral circuit includes first page buffers (PB), a first high-voltage unit (HV), a first cache latch (CL), a first page buffer decoder (PBDEC), and a first row decoder (XDEC);
wherein the second first peripheral circuit includes second page buffers (PB), a second high-voltage unit (HV), a second cache latch (CL), a second page buffer decoder (PBDEC), and a second row decoder (XDEC);
wherein the third peripheral circuit includes third page buffers (PB), a third high-voltage unit (HV), a third cache latch (CL), a third page buffer decoder (PBDEC), and a third row decoder (XDEC);
wherein the fourth first peripheral circuit includes fourth page buffers (PB), a fourth high-voltage unit (HV), a fourth cache latch (CL), a fourth page buffer decoder (PBDEC), and a fourth row decoder (XDEC);
wherein the first row decoder (XDEC) and the second row decoder (XDEC) are disposed under a region between the first memory cell array (MCA1) and the second memory cell array (MCA2), wherein the first row decoder (XDEC) is adjacent to the first memory cell array (MCA1) as viewed in the vertical direction, and wherein the second row decoder (XDEC) is adjacent to the second memory cell array (MCA2) as viewed in the vertical direction;
wherein the third row decoder (XDEC) and the fourth row decoder (XDEC) are disposed under a region between the third memory cell array (MCA3) and the fourth memory cell array (MCA4); wherein the third row decoder (XDEC) is adjacent to the third memory cell array (MCA3) as viewed in the vertical direction, and wherein the fourth row decoder (XDEC) is adjacent to the fourth memory cell array (MCA4) as viewed in the vertical direction;
wherein the first peripheral circuit is partially overlapped by the first memory cell array (MCA1) in the vertical direction such that the first page buffers (PB) and the first high-voltage unit (HV) are overlapped by the first memory cell array (MCA1) in the vertical direction, and the first cache latch (CL), the first page buffer decoder (PBDEC) and the first row decoder (XDEC) are not overlapped by the first memory cell array (MCA1) in the vertical direction; and
wherein the second peripheral circuit is partially overlapped by the second memory cell array (MCA2) in the vertical direction such that the second page buffers (PB) and the second high-voltage unit (HV) are overlapped by the second memory cell array (MCA2) in the vertical direction and the second cache latch (CL), the second page buffer decoder (PBDEC) and the second row decoder (XDEC) are not overlapped by the second memory cell array (MCA2) in the vertical direction;
wherein the third peripheral circuit is partially overlapped by the third memory cell array (MCA3) in the vertical direction such that the third page buffers (PB) and the third high-voltage unit (HV) are overlapped by the third memory cell array (MCA3) in the vertical direction and the third cache latch (CL), the third page buffer decoder (PBDEC) and the third row decoder (XDEC) are not overlapped by the third memory cell array (MCA3) in the vertical direction; and
wherein the fourth peripheral circuit is partially overlapped by the fourth memory cell array (MCA4) in the vertical direction such that the fourth page buffers (PB) and the fourth high-voltage unit (HV) are overlapped by the fourth memory cell array (MCA4) in the vertical direction and the fourth cache latch (CL), the fourth page buffer decoder (PBDEC) and the fourth row decoder (XDEC) are not overlapped by the fourth memory cell array (MCA4) in the vertical direction;
wherein the first cache latch (CL) and the third cache latch (CL) are disposed under a region between the first memory cell array (MCA1) and the third memory cell array (MCA3), such that the first cache latch (CL) is adjacent to the first memory cell array (MCA1) and that the third cache latch (CL) adjacent to the third memory cell array (MCA3) as viewed in the vertical direction;
wherein the second cache latch (CL) and the fourth cache latch (CL) are disposed under a region between the second memory cell array (MCA2) and the fourth memory cell array (MCA4), such that the second cache latch (CL) is adjacent to the second memory cell array (MCA2) and that the fourth cache latch (CL) adjacent to the fourth memory cell array (MCA4) as viewed in the vertical direction;
wherein:
the first page buffer decoder (PBDEC) is between the first cache latch (CL) and the pad region (PA);
the second page buffer decoder (PBDEC) is between the second cache latch (CL) and the pad region (PA);
the third page buffer decoder (PBDEC) is between the third cache latch (CL) and the pad region (PA);
the fourth page buffer decoder (PBDEC) is between the fourth cache latch (CL) and the pad region (PA).

2. The non-volatile memory device (120b) of claim 1,
wherein each first, second, third and fourth page buffer (PB) includes a sensing latch (SL),
wherein the sensing latch (SL) is overlapped by the respective memory cell array.

3. The non-volatile memory device (120b) of claim 2,
wherein each first, second, third and fourth page buffer (PB) further includes a force latch (FL), an upper-bit latch (ML), and a lower-bit latch (LL), and
wherein the force latch (FL), the upper-bit latch (ML), and the lower-bit latch (LL) are overlapped by the respective memory cell array.

4. The non-volatile memory device (120b) of claim 2,
wherein the first, second, third and fourth high-voltage unit (HV) includes a respective high-voltage transistor (TR_hv) coupled to one of a plurality of bit lines (BL, BL1-BL3), and
wherein the respective high-voltage transistor (TR_hv) is overlapped by the respective memory cell array.

5. The non-volatile memory device (120b) of claim 1,
wherein each first, second, third and fourth page buffer (PB) is part of the respective first, second, third and fourth peripheral circuit that includes the respective first, second, third and fourth page buffer circuit (PGBUF1, 1821a, 2021a, 2221a, 2421a) that includes the respective first, second, third and fourth page buffer decoder configured to address and drive the respective first, second, third and fourth memory cell array.

## Patentansprüche

1. Nichtflüchtige Speichervorrichtung (120b), welche folgende Merkmale aufweist:
eine erste Halbleiterschicht (121b), welche Folgendes beinhaltet:
eine erste Speicherzellenanordnung (MCA1), welche eine erste Mehrzahl von Wortleitungen, welche in einer vertikalen Richtung gestapelt sind, und eine erste Mehrzahl von Speicherzellen beinhaltet, welche jeweils mit der ersten Mehrzahl von Wortleitungen gekoppelt sind; und
eine zweite Speicherzellenanordnung (MCA2), welche eine zweite Mehrzahl von Wortleitungen, welche in der vertikalen Richtung gestapelt sind, und eine zweite Mehrzahl von Speicherzellen beinhaltet, welche jeweils mit der zweiten Mehrzahl von Wortleitungen gekoppelt sind, wobei sich die zweite Speicherzellenanordnung (MCA2) in einer ersten horizontalen Richtung (HD2) neben der ersten Speicherzellenanordnung (MCA1) befindet;
eine dritte Speicherzellenanordnung (MCA3), welche eine dritte Mehrzahl von Wortleitungen, welche in der vertikalen Richtung gestapelt sind, und eine dritte Mehrzahl von Speicherzellen beinhaltet, welche jeweils mit der dritten Mehrzahl von Wortleitungen gekoppelt sind, wobei sich die dritte Speicherzellenanordnung (MCA3) in einer zweiten horizontalen Richtung (HD1) neben der ersten Speicherzellenanordnung (MCA1) befindet, wobei die zweite horizontale Richtung (HD1) orthogonal zu der ersten horizontalen Richtung (HD2) ist;
eine vierte Speicherzellenanordnung (MCA4), welche eine vierte Mehrzahl von Wortleitungen, welche in der vertikalen Richtung gestapelt sind, und eine vierte Mehrzahl von Speicherzellen beinhaltet, welche jeweils mit der vierten Mehrzahl von Wortleitungen gekoppelt sind, wobei sich die vierte Speicherzellenanordnung (MCA2) in der zweiten horizontalen Richtung (HD1) neben der zweiten Speicherzellenanordnung (MCA2) befindet;
eine zweite Halbleiterschicht (122b), welche Folgendes beinhaltet:
einen Pad-Bereich (PA), welcher in einem mittleren Bereich der zweiten Halbleiterschicht (122b) angeordnet ist, wobei der Pad-Bereich (PA) eine Mehrzahl von Bondingpads (PD) beinhaltet, welche in der zweiten horizontalen Richtung (HD1) angeordnet sind, und wobei sich der Pad-Bereich (PA) zwischen der ersten Speicherzellenanordnung (MCA1) und der dritten Speicherzellenanordnung (MCA3), und zwischen der zweiten Speicherzellenanordnung (MCA2) und der vierten Speicherzellenanordnung (MCA4), in der zweiten horizontalen Richtung (HD1), erstreckt;
eine erste Peripherieschaltung, welche mit der ersten Speicherzellenanordnung (MCA1) gekoppelt ist; und
eine zweite Peripherieschaltung, welche mit der zweiten Speicherzellenanordnung (MCA2) gekoppelt ist,
eine dritte Peripherieschaltung, welche mit der dritten Speicherzellenanordnung (MCA3) gekoppelt ist; und
eine vierte Peripherieschaltung, welche mit der vierten Speicherzellenanordnung (MCA4) gekoppelt ist;
wobei die erste Peripherieschaltung erste Seitenpuffer (PB), eine erste Hochspannungseinheit (HV), einen ersten Cache-Latch (CL), einen ersten Seitenpuffer-Dekodierer (PBDEC) und einen ersten Zeilendekodierer (XDED) beinhaltet;
wobei die zweite Peripherieschaltung zweite Seitenpuffer (PB), eine zweite Hochspannungseinheit (HV), einen zweiten Cache-Latch (CL), einen zweiten Seitenpuffer-Dekodierer (PBDEC) und einen zweiten Zeilendekodierer (XDED) beinhaltet;
wobei die dritte Peripherieschaltung dritte Seitenpuffer (PB), eine dritte Hochspannungseinheit (HV), einen dritten Cache-Latch (CL), einen dritten Seitenpuffer-Dekodierer (PBDEC) und einen dritten Zeilendekodierer (XDED) beinhaltet;
wobei die vierte Peripherieschaltung vierte Seitenpuffer (PB), eine vierte Hochspannungseinheit (HV), einen vierten Cache-Latch (CL), einen vierten Seitenpuffer-Dekodierer (PBDEC) und einen vierten Zeilendekodierer (XDED) beinhaltet;
wobei der erste Zeilendekodierer (XDEC) und der zweiten Zeilendekodierer (XDEC) unter einem Bereich zwischen der ersten Speicherzellenanordnung (MCA1) und der zweiten Speicherzellenanordnung (MCA2) angeordnet sind, wobei der erste Zeilendekodierer XDEC) aus der vertikalen Richtung betrachtet benachbart zu der ersten Speicherzellenanordnung (MCA1) ist, und wobei der zweite Zeilendekodierer (XDEC) aus der vertikalen Richtung betrachtet benachbart zu der zweiten Speicherzellenanordnung (MCA2) ist;
wobei der dritte Zeilendekodierer (XDEC) und der vierte Zeilendekodierer (XDEC) unter einem Bereich zwischen der dritten Speicherzellenanordnung (MCA3) und der vierten Speicherzellenanordnung (MCA4) angeordnet sind, wobei der dritte Zeilendekodierer (XDEC) aus der vertikalen Richtung betrachtet benachbart zu der dritten Speicherzellenanordnung (MCA3) ist, und wobei der vierte Zeilendekodierer (XDEC) aus der vertikalen Richtung betrachtet benachbart zu der vierten Speicherzellenanordnung (MCA4) ist;
wobei die erste Peripherieschaltung durch die erste Speicherzellenanordnung (MCA1) in der vertikalen Richtung teilweise überlappt ist, so dass die ersten Seitenpuffer (PB) und die erste Hochspannungseinheit (HV) durch die erste Speicherzellenanordnung (MCA1) in der vertikalen Richtung überlappt sind, und der erste Cache-Latch (CL), der erste Seitenpuffer-Dekodierer (PBDEC) und der erste Zeilendekodierer (XDEC) durch die erste Speicherzellenanordnung (MCA1) in der vertikalen Richtung nicht überlappt sind; und
wobei die zweite Peripherieschaltung durch die zweite Speicherzellenanordnung (MCA2) in der vertikalen Richtung teilweise überlappt ist, so dass die zweiten Seitenpuffer (PB) und die zweite Hochspannungseinheit (HV) durch die zweite Speicherzellenanordnung (MCA2) in der vertikalen Richtung überlappt sind, und der zweite Cache-Latch (CL), der zweite Seitenpuffer-Dekodierer (PBDEC) und der zweite Zeilendekodierer (XDEC) durch die zweite Speicherzellenanordnung (MCA2) in der vertikalen Richtung nicht überlappt sind;
wobei die dritte Peripherieschaltung durch die dritte Speicherzellenanordnung (MCA3) in der vertikalen Richtung teilweise überlappt ist, so dass die dritten Seitenpuffer (PB) und die dritte Hochspannungseinheit (HV) durch die dritte Speicherzellenanordnung (MCA3) in der vertikalen Richtung überlappt sind, und der dritte Cache-Latch (CL), der dritte Seitenpuffer-Dekodierer (PBDEC) und der dritte Zeilendekodierer (XDEC) durch die dritte Speicherzellenanordnung (MCA3) in der vertikalen Richtung nicht überlappt sind; und
wobei die vierte Peripherieschaltung durch die vierte Speicherzellenanordnung (MCA4) in der vertikalen Richtung teilweise überlappt ist, so dass die vierten Seitenpuffer (PB) und die vierte Hochspannungseinheit (HV) durch die vierte Speicherzellenanordnung (MCA4) in der vertikalen Richtung überlappt sind, und der vierte Cache-Latch (CL), der vierte Seitenpuffer-Dekodierer (PBDEC) und der vierte Zeilendekodierer (XDEC) durch die vierte Speicherzellenanordnung (MCA4) in der vertikalen Richtung nicht überlappt sind;
wobei der erste Cache-Latch (CL) und der dritte Cache-Latch (CL) unter einem Bereich zwischen der ersten Speicherzellenanordnung (MCA1) und der dritten Speicherzellenanordnung (MCA3) angeordnet sind, so dass der erste Cache-Latch (CL) benachbart ist zu der ersten Speicherzellenanordnung (MCA1) und dass der dritte Cache-Latch (CL) aus der vertikalen Richtung betrachtet benachbart ist zu der dritten Speicherzellenanordnung (MCA3);
wobei der zweite Cache-Latch (CL) und der vierte Cache-Latch (CL) unter einem Bereich zwischen der zweiten Speicherzellenanordnung (MCA2) und der vierten Speicherzellenanordnung (MCA4) angeordnet sind, so dass der zweite Cache-Latch (CL) benachbart ist zu der zweiten Speicherzellenanordnung (MCA2) und dass der vierte Cache-Latch (CL) aus der vertikalen Richtung betrachtet benachbart ist zu der vierten Speicherzellenanordnung (MCA4);
wobei:
der erste Seitenpuffer-Dekodierer (PBDEC) zwischen dem ersten Cache-Latch (CL) und dem Pad-Bereich (PA) ist;
der zweite Seitenpuffer-Dekodierer (PBDEC) zwischen dem zweiten Cache-Latch (CL) und dem Pad-Bereich (PA) ist;
der dritte Seitenpuffer-Dekodierer (PBDEC) zwischen dem dritten Cache-Latch (CL) und dem Pad-Bereich (PA) ist;
der vierte Seitenpuffer-Dekodierer (PBDEC) zwischen dem vierten Cache-Latch (CL) und dem Pad-Bereich (PA) ist.

2. Nichtflüchtige Speichervorrichtung (120b) nach Anspruch 1,
wobei jeder erste, zweite, dritte und vierte Seitenpuffer (PB) einen Erfassungs-Latch (SL) beinhaltet, wobei der Erfassungs-Latch (SL) durch die jeweilige Speicherzellenanordnung überlappt ist.

3. Nichtflüchtige Speichervorrichtung (120b) nach Anspruch 2,
wobei der erste, zweite, dritte und vierte Seitenpuffer (PB) ferner einen Force-Latch (FL), einen Upper-Bit-Latch (ML) und einen Lower-Bit-Latch (LL) beinhaltet, und
wobei der Force-Latch (FL), der Upper-Bit-Latch (ML) und der Lower-Bit-Latch (LL) durch die jeweilige Speicherzellenanordnung überlappt sind.

4. Nichtflüchtige Speichervorrichtung (120b) nach Anspruch 2,
wobei die erste, zweite, dritte und vierte Hochspannungseinheit (HV) ferner einen jeweiligen Hochspannungs-Transistor (TR_hv) beinhaltet, welcher mit einer von einer Mehrzahl von Bitleitungen (BL, BL1-BL3) gekoppelt ist, und
wobei der jeweilige Hochspannungs-Transistor (TR_hv) durch die jeweilige Speicherzellenanordnung überlappt ist.

5. Nichtflüchtige Speichervorrichtung (120b) nach Anspruch 1,
wobei jeweils der erste, zweite, dritte und vierte Seitenpuffer (PB) Teil der jeweiligen ersten, zweiten, dritten und vierten Peripherieschaltung ist, welche die jeweilige erste, zweite, dritte und vierte Seitenpuffer-Schaltung (PGBUF1, 1821a, 2021a, 2221a, 2421a) beinhaltet, welche den jeweiligen ersten, zweiten, dritten und vierten Seitenpuffer-Dekodierer beinhaltet, welcher eingerichtet ist zum Adressieren und Ansteuern der jeweiligen ersten, zweiten, dritten und vierten Speicherzellenanordnung.

## Revendications

1. Dispositif de mémoire non volatile (120b) comprenant :
une première couche semi-conductrice (121b) comprenant :
un premier réseau de cellules de mémoire (MCA1) comprenant une première pluralité de lignes de mot empilées selon une direction verticale et une première pluralité de cellules de mémoire respectivement couplées à la première pluralité de lignes de mot ; et
un deuxième réseau de cellules de mémoire (MCA2) comprenant une deuxième pluralité de lignes de mot empilées selon la direction verticale et une deuxième pluralité de cellules de mémoire respectivement couplées à la deuxième pluralité de lignes de mot, le deuxième réseau de cellules de mémoire (MCA2) étant disposé, selon une première direction horizontale (HD2), à côté du premier réseau de cellules de mémoire (MCA1) ;
un troisième réseau de cellules de mémoire (MCA3) comprenant une troisième pluralité de lignes de mot empilées selon la direction verticale et une troisième pluralité de cellules de mémoire respectivement couplées à la troisième pluralité de lignes de mot,le troisième réseau de cellules de mémoire (MCA3) étant disposé, selon une deuxième direction horizontale (HD1) orthogonale à la première direction horizontale (HD2), à côté du premier réseau de cellules de mémoire (MCA1) ;
un quatrième réseau de cellules de mémoire (MCA4) comprenant une quatrième pluralité de lignes de mot empilées selon la direction verticale et une quatrième pluralité de cellules de mémoire respectivement couplées à la quatrième pluralité de lignes de mot, le quatrième réseau de cellules de mémoire (MCA4) étant disposé, selon la deuxième direction horizontale (HD1), à côté du deuxième réseau de cellules de mémoire (MCA2) ;
une deuxième couche semi-conductrice (122b) comprenant :
une région de plots (PA) disposée dans une région centrale de la deuxième couche semi-conductrice (122b), ladite région de plots (PA) comprenant une pluralité de plots de connexion (PD) disposés selon la deuxième direction horizontale (HD1), la région de plots (PA) s'étendant, selon la deuxième direction horizontale (HD1), entre le premier réseau de cellules de mémoire (MCA1) et le troisième réseau de cellules de mémoire (MCA3), et entre le deuxième réseau de cellules de mémoire (MCA2) et le quatrième réseau de cellules de mémoire (MCA4) ;
un premier circuit périphérique couplé au premier réseau de cellules de mémoire (MCA1) ;
un deuxième circuit périphérique couplé au deuxième réseau de cellules de mémoire (MCA2) ;
un troisième circuit périphérique couplé au troisième réseau de cellules de mémoire (MCA3) ; et
un quatrième circuit périphérique couplé au quatrième réseau de cellules de mémoire (MCA4) ;
le premier circuit périphérique comprenant des premiers tampons de page (PB), une première unité de haute tension (HV), un premier verrou de cache (CL), un premier décodeur de tampon de page (PBDEC) et un premier décodeur de ligne (XDEC) ;
le deuxième circuit périphérique comprenant des deuxièmes tampons de page (PB), une deuxième unité haute tension (HV), un deuxième verrou de cache (CL), un deuxième décodeur de tampon de page (PBDEC) et un deuxième décodeur de ligne (XDEC) ;
le troisième circuit périphérique comprenant des troisièmes tampons de page (PB), une troisième unité haute tension (HV), un troisième verrou de cache (CL), un troisième décodeur de tampon de page (PBDEC) et un troisième décodeur de ligne (XDEC) ;
le quatrième circuit périphérique comprenant des quatrièmes tampons de page (PB), une quatrième unité haute tension (HV), un quatrième verrou de cache (CL), un quatrième décodeur de tampon de page (PBDEC) et un quatrième décodeur de ligne (XDEC) ;
le premier décodeur de ligne (XDEC) et le deuxième décodeur de ligne (XDEC) étant disposés sous une région comprise entre le premier réseau de cellules de mémoire (MCA1) et le deuxième réseau de cellules de mémoire (MCA2), le premier décodeur de ligne (XDEC) étant adjacent au premier réseau de cellules de mémoire (MCA1) lorsqu'on le considère selon la direction verticale, et le deuxième décodeur de ligne (XDEC) étant adjacent au deuxième réseau de cellules de mémoire (MCA2) lorsqu'on le considère selon la direction verticale ;
le troisième décodeur de ligne (XDEC) et le quatrième décodeur de ligne (XDEC) étant disposés sous une région comprise entre le troisième réseau de cellules de mémoire (MCA3) et le quatrième réseau de cellules de mémoire (MCA4), le troisième décodeur de ligne (XDEC) étant adjacent au troisième réseau de cellules de mémoire (MCA3) lorsqu'on le considère selon la direction verticale, et le quatrième décodeur de ligne (XDEC) étant adjacent au quatrième réseau de cellules de mémoire (MCA4) lorsqu'on le considère selon la direction verticale ;
le premier circuit périphérique étant partiellement recouvert, selon la direction verticale, par le premier réseau de cellules de mémoire (MCA1) de sorte que les premiers tampons de page (PB) et la première unité haute tension (HV) sont recouverts par le premier réseau de cellules de mémoire (MCA1) selon la direction verticale, et que le premier verrou de cache (CL), le premier décodeur de tampon de page (PBDEC) et le premier décodeur de ligne (XDEC) ne sont pas recouverts par le premier réseau de cellules de mémoire (MCA1) selon la direction verticale ;
le deuxième circuit périphérique étant partiellement recouvert, selon la direction verticale, par le deuxième réseau de cellules de mémoire (MCA2) de sorte que les deuxièmes tampons de page (PB) et la deuxième unité haute tension (HV) sont recouverts par le deuxième réseau de cellules de mémoire (MCA2) selon la direction verticale, et que le deuxième verrou de cache (CL), le deuxième décodeur de tampon de page (PBDEC) et le deuxième décodeur de ligne (XDEC) ne sont pas recouverts par le deuxième réseau de cellules de mémoire (MCA2) selon la direction verticale;
le troisième circuit périphérique étant partiellement recouvert, selon la direction verticale, par le troisième réseau de cellules de mémoire (MCA3) de sorte que les troisièmes tampons de page (PB) et la troisième unité haute tension (HV) sont recouverts par le troisième réseau de cellules de mémoire (MCA3) selon la direction verticale, et que le troisième verrou de cache (CL), le troisième décodeur de tampon de page (PBDEC) et le troisième décodeur de ligne (XDEC) ne sont pas recouverts par le troisième réseau de cellules de mémoire (MCA3) selon la direction verticale; et
le quatrième circuit périphérique étant partiellement recouvert, selon la direction verticale, par le quatrième réseau de cellules de mémoire (MCA4) de sorte que les quatrièmes tampons de page (PB) et la quatrième unité haute tension (HV) sont recouverts par le quatrième réseau de cellules de mémoire (MCA4) selon la direction verticale, et que le quatrième verrou de cache (CL), le quatrième décodeur de tampon de page (PBDEC) et le quatrième décodeur de ligne (XDEC) ne sont pas recouverts par le quatrième réseau de cellules de mémoire (MCA4) selon la direction verticale;
le premier verrou de cache (CL) et le troisième verrou de cache (CL) étant disposés sous une région comprise entre le premier réseau de cellules de mémoire (MCA1) et le troisième réseau de cellules de mémoire (MCA3), de sorte que le premier verrou de cache (CL) est adjacent au premier réseau de cellules de mémoire (MCA1) et que le troisième verrou de cache (CL) est adjacent au troisième réseau de cellules de mémoire (MCA3) lorsqu'on les considère selon la direction verticale ;
le deuxième verrou de cache (CL) et le quatrième verrou de cache (CL) étant disposés sous une région comprise entre le deuxième réseau de cellules de mémoire (MCA2) et le quatrième réseau de cellules de mémoire (MCA4), de sorte que le deuxième verrou de cache (CL) est adjacent au deuxième réseau de cellules de mémoire (MCA2) et que le quatrième verrou de cache (CL) est adjacent au quatrième réseau de cellules de mémoire (MCA4) lorsqu'on les considère selon la direction verticale;
le premier décodeur de tampon de page (PBDEC) étant disposé entre le premier verrou de cache (CL) et la région de plots (PA) ;
le deuxième décodeur de tampon de page (PBDEC) étant disposé entre le deuxième verrou de cache (CL) et la région de plots (PA) ;
le troisième décodeur de tampon de page (PBDEC) étant disposé entre le troisième verrou de cache (CL) et la région de plots (PA) ; et
le quatrième décodeur de tampon de page (PBDEC) étant disposé entre le quatrième verrou de cache (CL) et la région de plots (PA).

2. Dispositif de mémoire non volatile (120b) selon la revendication 1,
dans lequel chacun des premier, deuxième, troisième et quatrième tampons de page (PB) comprend un verrou de détection (SL),
le verrou de détection (SL) étant recouvert par le réseau de cellules de mémoire correspondant.

3. Dispositif de mémoire non volatile (120b) selon la revendication 2,
dans lequel chacun des premier, deuxième, troisième et quatrième tampons de page (PB) comprend en outre un verrou de forçage (FL), un verrou de bit supérieur (ML) et un verrou de bit inférieur (LL), et
dans lequel le verrou de forçage (FL), le verrou de bit supérieur (ML) et le verrou de bit inférieur (LL) sont recouverts par le réseau de cellules de mémoire correspondant.

4. Dispositif de mémoire non volatile (120b) selon la revendication 2,
dans lequel chacune des première, deuxième, troisième et quatrième unités haute tension (HV) comprend un transistor haute tension (TR_hv) respectif couplé à l'une d'une pluralité de lignes de bit (BL, BL1-BL3),
et dans lequel ledit transistor haute tension (TR_hv) est recouvert par le réseau de cellules de mémoire correspondant.

5. Dispositif de mémoire non volatile (120b) selon la revendication 1,
dans lequel chacun des premier, deuxième, troisième et quatrième tampons de page (PB) fait partie du circuit périphérique correspondant qui comprend le circuit de tampon de page correspondant (PGBUF1, 1821a, 2021a, 2221a, 2421a), lequel comprend le décodeur de tampon de page correspondant configuré pour adresser et piloter le réseau de cellules de mémoire correspondant.
